# EUROPEAN PATENT SPECIFICATION

(11) **EP 1 012 611 B1**
(45) Date of publication and mention of the grant of the patent: **23.04.2003**
(21) Application number: 98903658.7
(22) Date of filing: 23.01.1998
(51) Int. Cl.: G01R 31/02, G01R 31/12, G01R 35/00

(54) **ARCING FAULT DETECTION SYSTEM**
LICHTBOGENFEHLERERFASSUNGSSYSTEM
SYSTEME DE DETECTION D'ARCS ELECTRIQUES

(30) Priority: 24.01.1997 US 788969; 27.01.1997 US 789659; 04.02.1997 US 794848; 06.02.1997 US 796745; 11.02.1997 US 799095; 21.02.1997 US 804420; 25.03.1997 US 827031; 26.03.1997 US 825005
(43) Date of publication of application: 28.06.2000
(73) Proprietor: SQUARE D COMPANY, Palatine, Illinois 60067 (US)
(72) Inventor: BROOKS, Stanley, J., Rockvale, TN 37153 (US); DICKENS, James, W., Lexington, KY 40503 (US); FLEEGE, Dennis, W., Cedar Rapids, IA 52404 (US); LARSON, Brett, E., Cedar Rapids, IA 52403 (US); FIXEMER, James, V., Denton, NE 68339 (US); TURNER, Duane, L., Cedar Rapids, IA 52405 (US); WIESE, Gregory, S., Coralville, Iowa 52441 (US); DVORAK, Robert, F., Mt. Vernon, IA 52314 (US); HAUN, Andy, A., Cedar Rapids, IA 52404 (US); ERGER, Robert, J., Cedar Rapids, IA 52402 (US); WONG, Kon, B., Cedar Rapids, IA 52404 (US); BETTIS, Charles, D., Cedar Rapids, Iowa 52402 (US)
(74) Representative: Grünecker, August, Dipl.-Ing.
(86) International application number: US9801266
(87) International publication number: WO98035237

(56) References cited:
- EP-A- 0 570 206
- EP-A- 0 649 207
- GB-A- 2 260 043
- US-A- 4 616 200
- US-A- 4 639 817
- US-A- 4 702 002
- US-A- 4 833 564
- US-A- 5 388 021
- US-A- 5 452 222
- US-A- 5 459 630
- US-A- 5 537 327
- US-A- 5 561 605
- PATENT ABSTRACTS OF JAPAN vol. 1995, no. 2, 30 March 1995 (1995-03-30) & JP 06 308191 A (FUJIKURA), 4 November 1994 (1994-11-04)

## Description

The present invention relates to a method and a system for testing an arcing fault detection system for protecting an electrical distribution system from arcing faults.

Electrical systems in residential, commercial and industrial applications usually include a panelboard for receiving electrical power from a utility source. The power is connected to the panelboard via line bus bars and neutral bus bars. The electrical power is delivered from the panelboard to designated branch circuits through line and neutral conductors supplying one or more loads. Typically, various types of protective devices are mounted to the bus bars of the panelboard to protect the branch circuits from hazardous electrical conditions and reduce the risk of injury, damage or fires.

Circuit breakers are a well known type of protective device which are designed to trip open and interrupt an electric circuit in response to detecting overloads and short circuits. Overload protection is provided by a thermal element which, when heated by the increased current, will cause the circuit breaker to trip and interrupt the power. This can occur when too many loads draw power from the same branch circuit at the same time, or when a single load draws more power than the branch circuit is designed to carry. Short circuit protection is provided by an electromagnetic element that trips when sensing high current flow. Circuit breakers may also provide protection against ground faults which occur when current flows from a hot conductor to ground through a person or object.

Arcing faults, which occur when electric current "arcs" or flows through ionized gas between two ends of a broken conductor, between two conductors supplying a load, or between a conductor and ground, comprise one type of electrical hazard that cannot generally be detected by standard circuit breakers. This is because current levels associated with arcing faults are generally not high enough to trip the thermal or electromagnetic elements associated with standard circuit breakers. Arching faults typically results from corroded, worn or aged wiring or insulation, loose connections, wiring damaged by nails or staples through the insulation, and electrical stress caused by repeated overloading, lightning strikes, etc. The presence of an arcing fault creates a significant fire hazard because it generates heat which may ignite the conductor insulation and adjacent combustible materials.

Arcing fault detection systems known in the art generally sense the current passing through the line conductor of a branch circuit, process the sensed information to determine whether the characteristics of the line current represent the occurrence of an arcing fault, and trip open the branch circuit if an arcing fault has occurred. A preferred arcing fault detection system of this type is described in pending U.S. patent application Serial No. 08/600,512, entitled "Arcing Fault Detection System".

The English abstract of JP-06-308191-A discloses a testing method for a resonance type partial discharge detector. A signal injecting contact is provided on a periphery of a power cable near a high frequency partial discharge sensor. A capacitor is connected to said contact A frequency pulse generated from a pulse calibration unit is injected to a power cable through the capacitor. The confirmation of an operation and the calibration of their resonance type partial discharge detector are executed based on the output of the sensor.

EP-649 207 A1 discloses a self testing circuit breaker ground fault and sputtering arc trip unit The circuit breaker combines a sputtering arc detector with a ground fault detector. The circuit breaker protects an electronic system which includes a line and a neutral conductor providing electric power to a load. Faults in the electrical system are detected by current sensors in the form of toroidal transformers. One transformer is used for detecting sputtering arc faults by measuring the rate of change of the current signal di/dt. The di/dt signal is bandwidth limited and applied through a follower operational amplifier to a window comparator comprised of two comparators. The entire electronic circuit for the sputtering arc detector can be tested by using a second test circuit including an impedance connected between the line conductor and the secondary winding of the sensing coil or a current transformer on the neutral conductor. A switch selectively Injects an AC signal into the secondary winding. Said impedance may be resistor, a capacitor or a series combination of resistance capacitor. The impedance is choosen so that, in conjunction with the circuit impedance, the line voltage is attenuated to a suitable level for testing. An alternate form of a test circuit utilises DC power derived from the internal power supply to generate the pulses needed to complete the tests of the sputtering arc dectector.

It is the object of this invention to provide a more reliable method and system for testing the detecting of arcing faults in an electrical distribution system.

This object is achieved by the method according to claim 1 and a system according to claim 14.

In accordance with another embodyment of the present invention, there is provided a system for detecting arcing faults in an electrical distribution system including a plurality of phase lines for connecting a power source to a respective plurality of loads, and a current transformer electrically coupled to one of the phase lines. The current transformer has a secondary line extending therefrom carrying an electrical current. The system monitors the secondary line for the occurrence of an arcing fault in the corresponding phase line and disconnects the load from the power source in response to the detection of an arcing fault in the corresponding phase line. The monitoring of the secondary line for the occurrence of an arcing fault comprises monitoring changes in current (or voltage) associated with the secondary line and producing a rate-of-change signal representing the rate of change of current (or voltage) associated with the secondary line. An arc-fault-detection signal is generated in response to variations in the rate-of-change signal representing an arcing fault.

In accordance with another embodyment, there is provided an integrated protection system for an electrical distribution system including a panelboard for receiving and distributing power from a utility source. The panelboard receives power from the utility source through at least one line bus and a neutral bus. The panelboard distributes power to a plurality of branch circuits each having line and neutral conductors for delivering the power to a load. The line conductors are electrically connected to one of the line buses and the neutral conductors are electrically connected to the neutral bus. The panelboard includes a framework having a plurality of positions for attaching circuit protection devices to the plurality of branch circuits. The integrated protection system comprises a plurality of arcing fault detector modules and line interrupters, each attached to one of the positions in the panelboard framework. The arcing fault detector modules are adapted to detect the occurrence of an arcing fault in either of the selected number of branch circuits, while the line interrupters are adapted to disconnect the load from the power source in response to the detection of an arcing fault in one of the selected branch circuits. An isolation module attached to one of the positions in the panelboard may be provided for electrically isolating arcing fault signals to the branch circuit in which they occur.

In accordance with another embodyment, there is provided an integrated protection system for an electrical distribution system substantially as described above, comprising a plurality of combination arcing fault detector and line interrupter modules, each associated with one of the branch circuits and attached to one of the positions in the panelboard framework. An arcing fault detector portion of the module is designed to detecting the occurrence of an arcing fault in its respective branch circuit, while a line interrupter portion of the module is designed to disconnect the load from the power source in response to the occurrence of an arcing fault in the respective branch circuit. An isolation module attached to one of the positions in the panelboard may be provided for electrically isolating an arcing fault signal to the branch circuit on which it occurred.

In accordance with still another embodyment, there is provided an integrated protection system for an electrical distribution system substantially as described above, comprising a plurality of arcing fault detector modules and line interrupter modules. The line interrupter modules are each attached to one of the positions in the panelboard framework, while the arcing fault detector modules are attached externally to the line interrupter modules. The arcing fault detector modules are designed to detect the occurrence of an arcing fault in either of the branch circuits, while the line interrupter modules are designed to disconnect the load from the power source in response to the detection of an arcing fault in one of the branch circuits. An isolation module attached to one of the positions in the panelboard may be provided for electrically isolating arcing fault signals to the branch circuit on which they occurred.

In accordance with a further embodyment, there is provided a trip indicator for use in an electrical distribution system including a plurality of branch circuits each of which has line and neutral conductors for connecting a power source to a load. Each of the plurality of branch circuits includes an arcing fault detector disposed within a housing for detecting the occurrence of an arcing fault condition and activating a trip signal in response thereto and a line interrupter for disconnecting the load from the power source in response to the activation of the trip signal. The trip indicator comprises a light source adapted to illuminate in response to the activation of the trip signal. A conduit is provided within the housing for conveying light between the light source and an opening of the housing in response to illumination of the light source.

In accordance with another embodyment, there is provided a trip indicator for use in an electrical distribution system substantially as described above, in which the trip indicator comprises a plunger having a colored tip. The plunger is movable between a retracted position and an extended position in response to the activation of the trip signal. A conduit is provided within the housing for conveying light external to the housing toward the colored tip to produce a reflection of colored light. The conduit thereafter conveys the reflection of colored light to the opening of the housing.

In accordance with yet another embodyment, there is provided a trip indicator for use in an electrical distribution system substantially as described above, in which the trip indicator comprises a bimetal disk having a colored top. The bimetal disk is thermally movable between a generally flat position and a convex position in response to the activation of the trip signal. A conduit is provided within the housing for conveying light external to the housing toward the colored top to produce a reflection of colored light. The conduit thereafter conveys the reflection of colored light to the opening of the housing.

In accordance with still another embodyment, there is provided a trip indicator for use in an electrical distribution system substantially as described above, in which each of the plurality of branch circuits includes two or more protective devices. Each of the protective devices is adapted to detect the occurrence of respective fault conditions and activate a trip signal in response thereto: The trip indicator is responsive to the activation of the trip signal and indicates which of the respective protective devices activated the trip signal.

In accordance with a further embodyment, there is provided a circuit breaker for interrupting the electrical current flowing through a line conductor to a load terminal in response to the detection of an arcing fault, ground fault and/or overload. The circuit breaker has a sensor for sensing the electrical current in an electrical power distribution circuit and for sending a signal representing the characteristics of the current to an electronic detector. When the detector detects the occurence of an overload, ground fault or arcing fault, a trip signal is sent to an actuator. In response to the trip signal, the actuator actuates a trip mechanism for opening and closing a pair of breaker contacts which open and close the electrical circuit.

In accordance with another embodyment, there is provided an isolation device for use in an electrical distribution network, the network having a plurality of branch circuits defined by line and neutral conductors connected between a power source and load, the line and neutral conductors being electrically connected to respective line and neutral buses in an electrical distribution panelboard, the isolation device comprising filter means for providing a low impedance path for an arcing fault signal occurring in a selected one of the branch circuits, the filter means being coupled between the line and neutral buses in the electrical distribution network.

A further embodyment facilitates automated production (or hand assembly) of circuit breakers which include arcing fault detectors. Such detectors comprise a toroidal sensor having an annular core encompassing a current-carrying load line in which the sensing coil is wound helically on the core such as has been described in the patent applications referenced above. In one embodiment, the assembly includes a circuit board and a two-piece sensor core in a two piece housing. The lower sections of the core and housing are connected to the circuit board and the upper sections of the core and housing are detachably mountable to their respective lower sections. A helical winding is placed on the lower core and is attached to conductive pins which make electrical contact with the circuit board. When the upper core is locked to the lower core, they form a hollow center oriented horizontally. Electrical power is supplied to an electrical load via attachment to a load line terminal located on one side of the sensing coil. The load line terminal extends through the hollow center of the sensing coil. An insulator is disposed around the portion of the load line terminal within the center of the sensing coil. A connection to the electrical supply is provided via a load terminal which is connected to the load line terminal after it has emerged on the opposite side of the sensing coil. In an alternative embodiment, the upper section of the housing is omitted. In another embodiment, the sensing coil is positioned on the circuit board so that the hollow center of the coil is oriented vertically and the load line terminal is connected to the load terminal above the sensing coil. Alternatively, the sensing coil may be one-piece and positioned with the hollow center mounted horizontally. In such an embodiment, the terminal would be inserted within the sensing coil and weld connections made to the load terminal and the circuit board after the sensing coil has been positioned.

In accordance with yet another embodyment, there is provided a method and apparatus for detecting arcing faults in a line conductor carrying an electrical current between a power source and a load, the electrical current defining an AC waveform comprising a series of alternating positive half cycles and negative half cycles. The method comprises the steps of obtaining current samples in a series of half cycles of the waveform, determining the peak current of each of the half cycles, and comparing the peak currents to determine changes in slope between half cycles. The number of changes in slope occurring within a selected time interval are counted and an arc indicative signal is produced when the number of reversals in polarity of the slope occurring within the selected time interval equals or exceeds a predetermined threshold number.

In accordance another embodyment, there is provided an alternative method and apparatus for detecting arcing faults in a line conductor carrying an electrical current between a power source and a load, the electrical current defining an AC waveform comprising a series of alternating positive half cycles and negative half cycles. The method comprises the steps of obtaining current samples in a series of half cycles, determining the peak current in each of the half cycles, and comparing the peak currents to determine slope changes between consecutive half cycles as described above. The method further comprises the steps of normalizing each of the current samples and autocorrelating the normalized current samples to obtain a measure of significant waveform shape changes between consecutive half cycles. Both the number of changes in slope and the number of significant waveform shape changes occurring within a selected time interval are counted and an arc indicative signal is produced when the number of reversals in polarity or the number of waveform changes equal or exceed predetermined threshold values.

In the drawings, which comprise a portion of this disclosure:
FIG. 1 is a block diagram of an arcing fault detection system having a sensor connected to the line conductor of a branch circuit;
FIG. 2 is a schematic diagram of an electrical circuit for implementing the arcing fault detection system illustrated in FIG. 1;
FIGs. 3a through 3g are waveforms at various points in the circuit of FIG. 2;
FIG. 4 is a schematic diagram of an alternative circuit for use in place of the comparator and single-shot pulse generator in the circuit of FIG. 2;
FIG. 5 is a schematic diagram of an alternative circuit for implementing the arcing fault detection system illustrated in FIG. 1;
FIG. 6 is a schematic diagram of a test circuit which may be utilized in an arcing fault detection system according to principles of the present invention;
FIG. 7 is a schematic diagram of an alternative test circuit which may be utilized in an arcing fault detection system according to principles of the present invention;
FIG. 8 is a flow chart of an arcing fault detection system and test method according to one embodiment of the present invention;
FIG. 9 is a block diagram of an arcing fault detection system connected to secondary lines of a current transformer according to principles of the present invention;
FIG. 10 is a block diagram of a panelboard including an integrated protection system according to one embodiment of the present invention;
FIG. 11 is a perspective view of a panelboard including the integrated protection system of FIG. 10 with an isolation module at the distribution panel;
FIG. 12 is a block diagram of a panelboard including an integrated protection system according to another embodiment of the present invention;
FIG. 13 is a perspective view of a panelboard including the integrated protection system of FIG. 12 with an isolation module at the distribution panel;
FIG. 14 is a block diagram of a panelboard including an integrated protection system according to still another embodiment of the present invention;
FIG. 15 is a perspective view of a panelboard including the integrated protection system of FIG. 14 with an isolation module at the distribution panel;
FIG. 16 is a perspective view of an isolation module which may be used in the integrated protection systems of FIGs. 9-15;
FIG. 17 is a schematic diagram of an electrical circuit for implementing the isolation module illustrated in FIG. 16;
FIG. 18 is a perspective view of an arcing fault detector module which may be used in the integrated protection systems of FIG. 10 and 11;
FIG. 19 is a block diagram of the arcing fault detector module of FIG. 18;
FIG. 20 is a perspective view of a miniature circuit breaker housing which may be mounted to a panelboard and which may include the arcing fault detection system of FIG. 1;
FIG. 21 is a top view of a miniature circuit breaker installed within the miniature circuit breaker housing of FIG. 20 in a closed (on) position and including a trip indicator according to one embodiment of the present invention;
FIG. 22 is a top view of a portion of the miniature circuit breaker of FIG. 21 in an open (off/tripped) position;
FIG. 23 is a side elevation of a trip indicator which may be positioned within the miniature circuit breaker housing of FIG. 20;
FIG. 24 is a top view of the miniature circuit breaker of FIG. 21 including a trip indicator according to another embodiment of the present invention;
FIG. 25 is a side elevation of a trip indicator which may be positioned within the miniature circuit breaker housing of FIG. 20 according to still another embodiment of the present invention;
FIG. 26 is a schematic diagram of an electrical circuit for implementing a dual-LED trip indicator according to one embodiment of the present invention;
FIG. 27 is a side elevation of a trip indicator which may be positioned within the miniature circuit breaker housing of FIG. 20 according to yet another embodiment of the present invention;
FIG. 28 is a side elevation of a trip indicator which may be positioned within the miniature circuit breaker housing of FIG. 20 according to still yet another embodiment of the present invention;
FIG. 29 is a side elevation of an alternative embodiment of the trip indicator of FIG. 26 including a push-to-reset and push-to-test feature;
FIG. 30 is a side elevation of an alternative embodiment of the trip indicator of FIG. 28 including a push-to-reset and a push-to-test feature;
FIG. 31 is a top view of the miniature circuit breaker of FIG. 21 including a push-to-test feature;
FIG. 32 is a side elevation of an alternative embodiment of the trip indicator of FIG. 27 including a push-to-reset and twist-to-test feature;
FIG. 33 is a side elevation of a latching mechanism according to one embodiment of the present invention and illustrates the associated sensing and detection circuits in block diagram;
FIG. 34 is a plan view of a latching mechanism according to another embodiment of the present invention;
FIG. 35a is a perspective view of a plunger/latch plate assembly for a latching mechanism according to another embodiment of the present invention;
FIG. 35b is a plan view of the plunger/latch plate assembly of FIG. 35a in which the latch plate has a rounded end;
FIG. 35c is a plan view of the plunger/latch plate assembly of FIG. 35a in which the latch plate has a L-shaped end;
FIG. 36a is a plan view of a latching mechanism comprising a latch plate with an integrated spring, coil and plunger according to another embodiment of the present invention;
FIG. 36b is a plan view of a latching mechanism comprising a latch plate with an integrated spring, coil and plunger according to another embodiment of the present invention;
FIG. 36c is a plan view of the latching mechanism of FIG. 36b with the integrated spring flexed;
FIG. 37 is a plan view of an electronically controlled circuit breaker with integrated latch tripping including a high magnetic tripping conductor loop according to another embodiment of the present invention;
FIG. 38 is a plan view of an electronically controlled circuit breaker with integrated latch tripping comprising a trip coil, armature and yoke according to another embodiment of the present invention;
FIG. 39 is a block diagram of an electrical distribution network using an isolation device according to principles of the present invention;
FIG. 40 is a perspective view of a panelboard which uses an isolation device according to principles of the present invention;

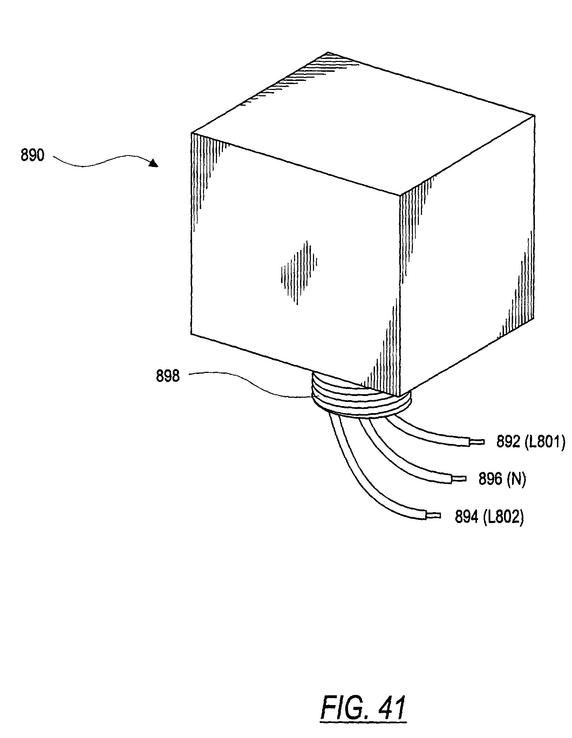

FIG. 41 is a perspective view of an alternate isolation device according to principles of the present invention;
FIG. 42 is a circuit diagram of the isolation device according to principles of the present invention;
FIG. 43 is a plan view of a circuit breaker incorporating an arcing fault sensor packaged within the miniature circuit breaker housing of FIG. 20;
FIG. 44 is a perspective view of a sensing coil connected to an internal load connector and a load line terminal;
FIG. 45 is a partial perspective view of an alternate embodiment of the power connection to the circuit board;
FIG. 46 is a partial perspective view of an alternative embodiment of the lower housing;
FIG. 47 is a perspective view of the housing and sensing coil;
FIG. 48 is a partial perspective view of an alternative connection between the internal load connector and load line terminal;
FIG. 49 is a perspective view of an alternative embodiment of the sensing coil and the connection of the internal load connector and the load line terminal;
FIG. 50 is a partial perspective view of another alternative embodiment of the sensing coil of FIG. 50;
FIG. 51 is a perspective view of a lug connection;
FIG. 52 is a perspective view of a strain relief member;
FIG. 53 is a perspective view of an alternative strain relief member;
FIG. 54 is an elevation view and a perspective view of another alternative strain relief member;
FIG. 55 is an elevation view of a load line terminal of the present invention;
FIG. 56 is perspective view of another alternative embodiment employing a one-piece sensing coil horizontally mounted;
FIG. 57 is a perspective view of an alternative embodiment of the vertically positioned sensing coil of Fig. 49;
FIG. 58 is a perspective view of another alternative embodiment of the vertically positioned sensing coil of Fig. 49;
FIG. 59 is a schematic block diagram of an electrical distribution circuit including an arcing fault detection system according to principles of the present invention;
FIG. 60 is an overview flow chart of one manner of operating the arcing fault detection system of FIG. 59;
FIG. 61 is a flow chart illustrating the peak detection subroutine associated with step 2 in the flowchart of FIG. 60;
FIG. 62 is a flow chart illustrating the counting slope changes subroutine associated with step 3 in the flowchart of FIG. 60;
FIG. 63 is a flow chart illustrating the normalization and autocorrelation subroutines associated with step 4 in the flowchart of FIG. 60;
FIG. 64 is a flow chart illustrating the counting shape changes subroutine associated with step 5 in the flowchart of FIG. 60;
FIG. 65 is a flow chart illustrating the check for trip condition subroutine associated with step 6 in the flowchart of FIG. 60;
FIG. 66 depicts the waveforms associated with the detection of slope changes according to one aspect of the present invention; and
FIG. 67 depicts the waveforms associated with the detection of shape changes according to one aspect of the present invention.

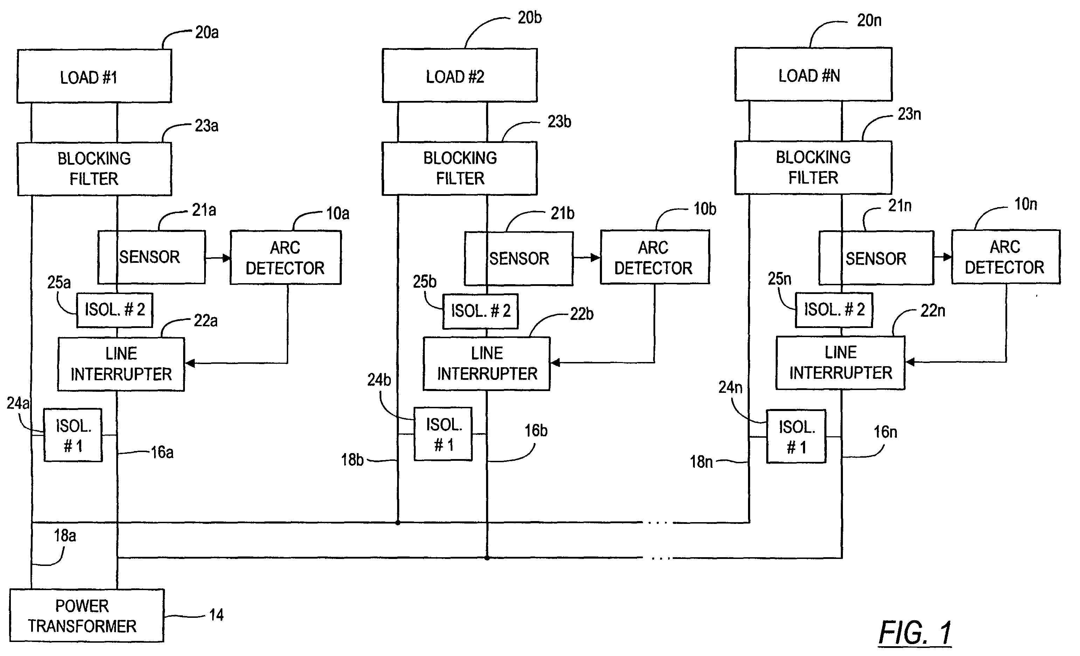

Turning now to the drawings and referring initially to FIG. 1, arcing fault detectors 10a, 10b ... 10*n* are connected to n branches of an electrical distribution system 12 having a utility company power transformer 14 as a source of electric power. The electrical distribution system 12 includes line conductors 16a, 16b ... 16*n* and neutral conductors 18a, 18b ... 18*n* which distribute electrical power to loads 20a, 20b ... 20*n* through corresponding sensors 21a, 21b ... 21*n*, line interrupters 22a, 22b ... 22*n*, and blocking filters 23a, 23b ... 23*n*. The line conductors 16 and a neutral conductors 18 are typically at 240 volts or 120 volts, and a frequency of 60 Hz.

Each of the line interrupters 22 is preferably a circuit breaker which includes an overload trip mechanism having a thermal/magnetic characteristic which trips the breaker contacts to an open circuit condition in response to a given overload condition, to disconnect the corresponding load 20 from the power source, as is known in the art. It is also known to provide the circuit breaker 22 with ground fault interrupter circuitry responding to a line or neutral-to-ground fault to energize a trip solenoid which trips the circuit breaker and opens the contacts.

The sensors 21 monitor the rate of change of electrical current in the respective line conductors 16 and produce signals representing the rate of change. The rate-of-change signal from each sensor 21 is supplied to the corresponding arcing detector 10, which produces a pulse each time the rate-of-change signal increases above a selected threshold. The rate-of-change signal and/or the pulses produced therefrom are filtered to eliminate signals or pulses outside a selected frequency range. The final pulses are then monitored to detect when the number of pulses that occur within a selected time interval exceeds a predetermined threshold. In the event that the threshold is exceeded, the detector 10 generates an arcing-fault-detection signal that can be used to trip the corresponding line interrupter 22.

In one embodiment of the present invention, the sensor 21 comprises a toroidal sensor having an annular core encompassing the current-carrying load line, with the sensing coil wound helically on the core. The core is made of magnetic material such as a ferrite, iron, or molded permeable powder capable of responding to rapid changes in flux. A preferred sensor uses a ferrite core wound with 200 turns of 24-36 gauge copper wire to form the sensing coil. An air gap may be cut into the core to reduce the permeability to about 30. The core material preferably does not saturate during the relatively high currents produced by parallel arcs, so that arc detection is still possible at those high current levels.

Other means for sensing the rate of change of the current in a line conductor are contemplated by the present invention. By Faraday's Law, any coil produces a voltage proportional to the rate of change in magnetic flux passing through the coil. The current associated with an arcing fault generates a magnetic flux around the conductor, and the coil of the sensor 21 intersects this flux to produce a signal. Other suitable sensors include a toroidal transformer with a core of magnetic material or an air core, an inductor or a transformer with a laminated core of magnetic material, and inductors mounted on printed circuit boards. Various configurations for the sensor core are contemplated by the present invention and include toroids which have air gaps in their bodies.

Preferably, the rate-of-change signal produced by the sensor 21 represents only fluctuations in the rate of change within a selected frequency band. The sensor bandpass characteristic is preferably such that the lower frequency cut-off point rejects the power frequency signals, while the upper frequency cut-off point rejects the high frequency signals generated by noisy loads such as a solder gun, electric saw, electric drill, or like appliances, equipment, or tools. The resulting output of the sensor 21 is thus limited to the selected frequency band associated with arcing faults, thereby eliminating or reducing spurious fluctuations in the rate-of-change signal which could result in nuisance tripping. As an example, the sensor bandpass characteristic may have: (1) a lower frequency cut-off point or lower limit of 60 Hz so as to reject power frequency signals, and (2) an upper frequency cut-off point or upper limit of approximately 1 MHz so as to effectively reject high frequency signals associated with noisy loads. These specific frequency cut-off points for the sensor bandpass characteristic are by way of example only, and other appropriate frequency cut-off limits may be adopted depending upon actual frequency ranges for the power signals as well as the noisy load signals.

The desired bandpass characteristic is realized by appropriately selecting and adjusting the self-resonant frequency of the sensor. The current-type sensor is selected to have a predetermined self-resonant frequency which defines associated upper and lower frequency cut-off or roll-off points for the operational characteristics of the sensor. Preferably, the current-type sensor is designed to exhibit the desired bandpass filtering characteristic as it operates to detect the rate of change of current variations within the load line being monitored. The present invention contemplates other means for bandpass filtering the signal output within the selected frequency band. For example, a bandpass filter or a combination of filters in a circuit can be used to attenuate frequencies above or below the cut-off points for the selected frequency band.

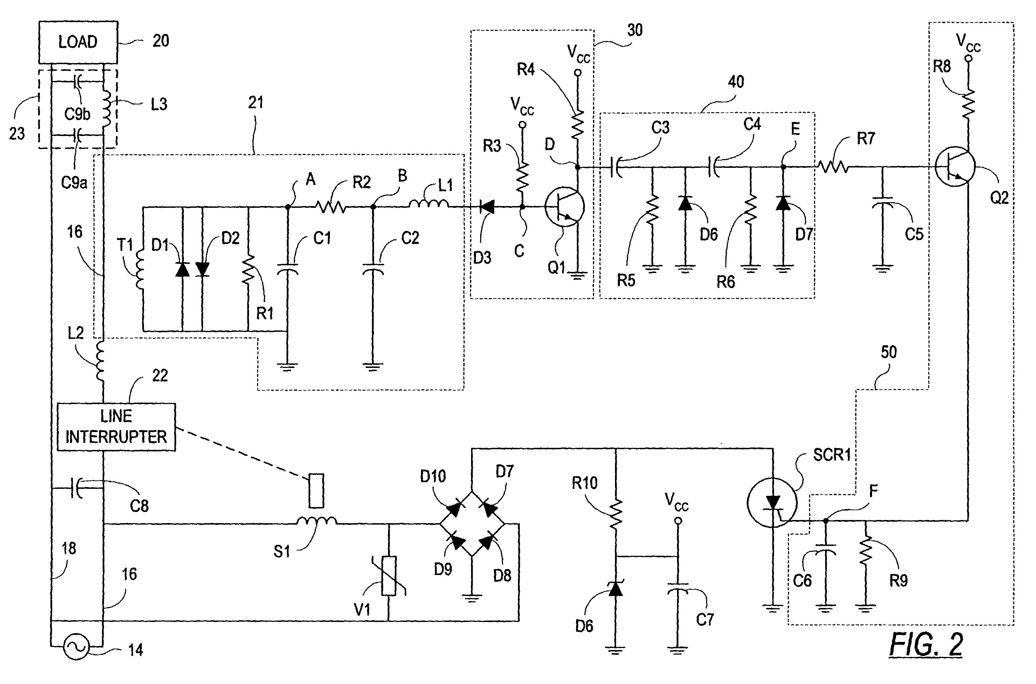

FIG. 2 illustrates a preferred circuit for the arcing fault detection system of FIG. 1. The sensor 21 comprises a sensor coil T1 which is wound on a core surrounding the line conductor 16. Connected in parallel with the sensor coil T1 are a pair of diodes D1 and D2 which serve as clamping devices during high-power transient conditions. A resistor R1 in parallel with the diodes D1 and D2 dampens self-ringing of the sensor, during high-power transients. A pair of capacitors C1 and C2 in parallel with the resistor R1, and a resistor R2 and an inductor L1 connected in series to the input to a comparator 30, are tuned to assist in attaining the desired rolloff characteristics of the filtering network formed thereby. For example, with the illustrative values listed below for the components of the circuit of FIG. 2, the sensor has a passband extending from about 10 KHz to about 100 KHz, with sharp rolloff at both sides of the passband.

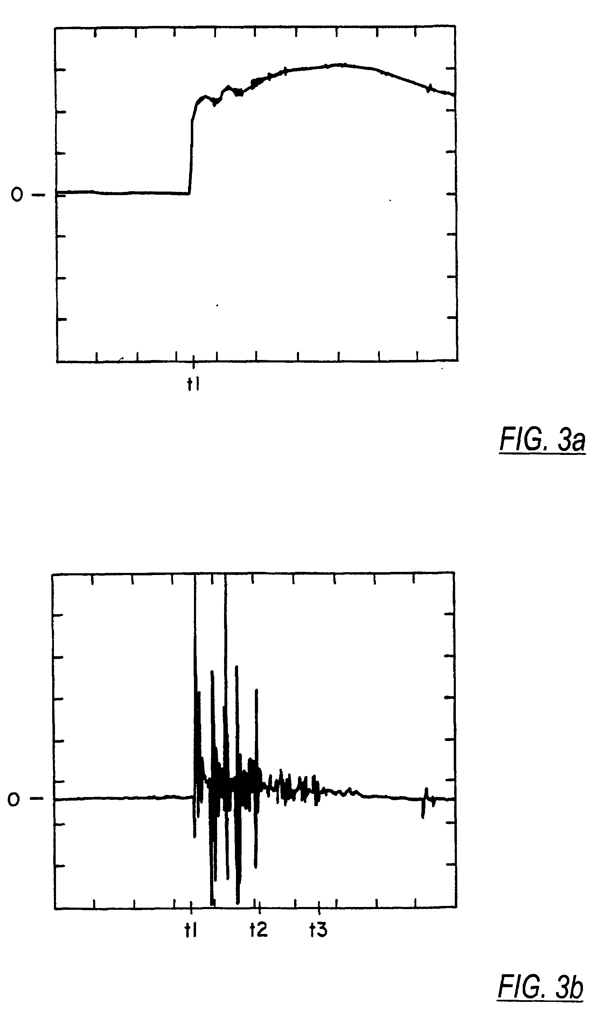

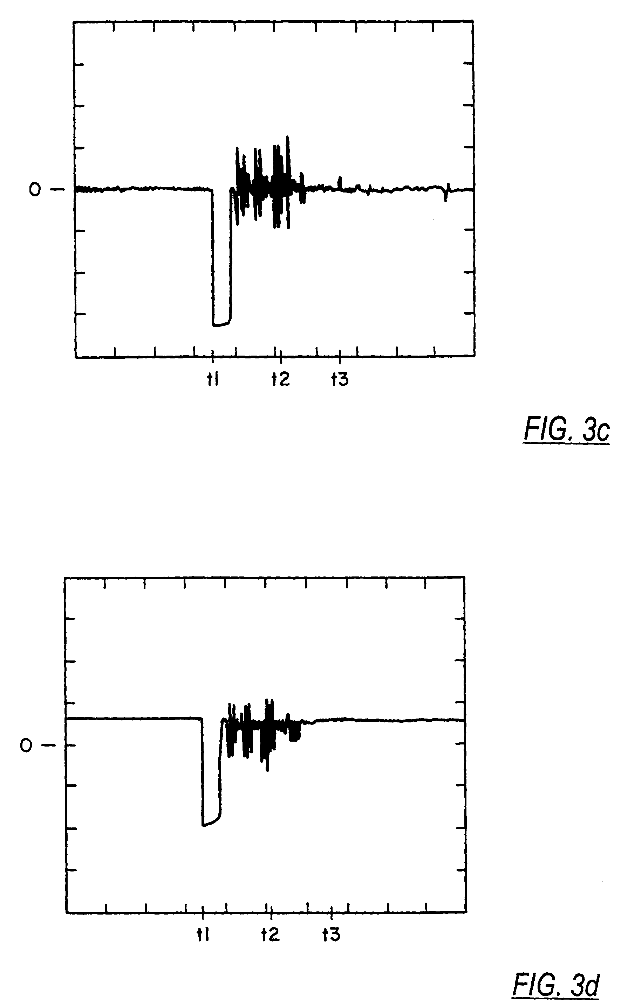

The operation of the circuit of FIG. 2 can be more clearly understood by reference to the series of waveforms in FIGs. 3a through 3g. FIG. 3a is an actual waveform from an oscilloscope connected to a line conductor 16 carrying a-c. power at 60 Hz and experiencing a high-frequency disturbance beginning at time t1. Because the high-frequency disturbance is within the frequency range to which the sensor 21 is sensitive (e.g., from about 10 KHz to about 100 KHz), the disturbance results in a burst of high-frequency noise in the di/dt output signal (FIG. 3b) from the sensor 21 (at point A in the circuit of FIG. 2), beginning at time t1. The noise burst has a relatively high amplitude from time t1 until approximately time t2, and then continues at a low amplitude from time t2 to about time t3.

The magnitude of the rate-of-change signal from the sensor 21 is compared with the magnitude of a fixed reference signal in a comparator 30, which produces an output voltage only when the magnitude of the rate-of-change signal crosses that of the reference signal. This causes the detector to ignore low-level signals generated by the sensor 21. All signals having a magnitude above the threshold level set by the magnitude of the reference signal are amplified to a preset maximum value to reduce the effect of a large signal. In the comparator 30, a transistor Q1 is normally turned on with its base pulled high by a resistor R3. A diode D3 changes the threshold and allows only the negative pulses from the sensor 21 to be delivered to the base of transistor Q1. When the signal to the comparator drops below the threshold level (minus 0.2 volt for the circuit values listed below), this causes the transistor Q1 to turn off. This causes the collector of the transistor Q1 to rise to a predetermined voltage, determined by the supply voltage V_{cc}, a resistor R4 and the input impedance of a single-shot pulse generator circuit 40. This collector voltage is the output of the comparator circuit 30. The collector voltage remains high as long as the transistor Q1 is turned off, which continues until the signal from the sensor 21 rises above the threshold level again. The transistor Q1 then turns on again, causing the collector voltage to drop. The end result is a pulse output from the comparator, with the width of the pulse corresponding to the time interval during which the transistor Q1 is turned off, which in turn corresponds to the time interval during which the negative-going signal from the sensor 21 remains below the threshold level of the comparator.

The noise burst in the sensor output is filtered to produce the waveform shown in FIG. 3c at point B in the circuit of FIG. 2. The waveform at point C in the circuit of FIG. 2 is shown in FIG. 3d, and it can be seen that the amplitude has been reduced and a d-c. offset has been introduced by summing the filtered di/dt signal with a d-c. bias from the supply voltage V_{cc} at point C. This is the input signal to the base of the transistor Q1.

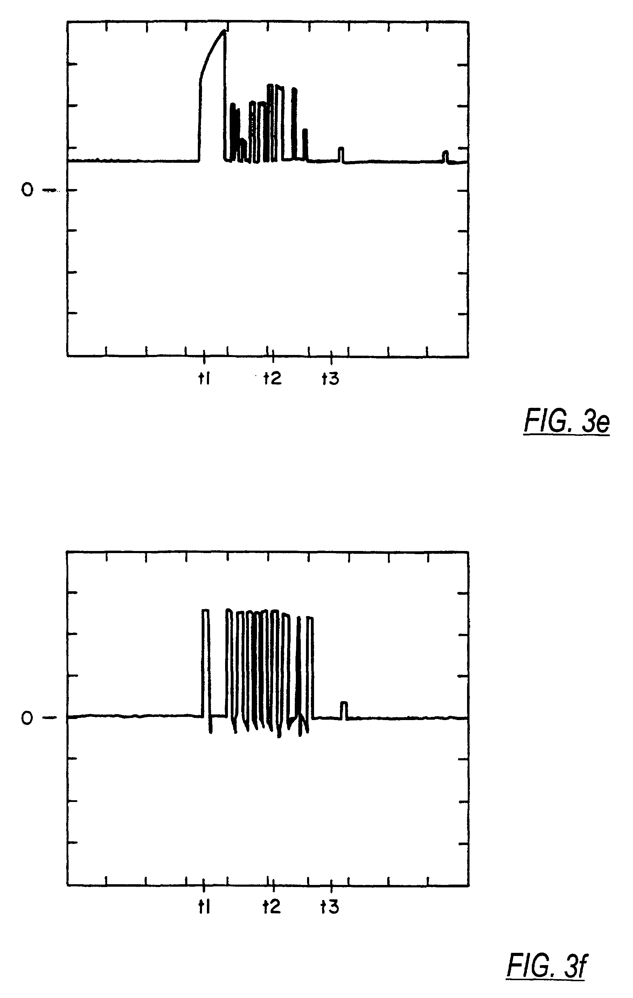

The output of the transistor Q1 is a series of positive-going pulses corresponding to the negative-going peaks in the input signal. The transistor output, at point D in the circuit of FIG. 2, is shown in FIG. 3e. It can be seen that the transistor circuit functions as a comparator by producing output pulses corresponding only to negative-going peaks that exceed a certain threshold in the filtered di/dt signal shown in FIG. 3c. At this point in the circuit, the pulses vary in both width and amplitude, as can be seen in FIG. 3e.

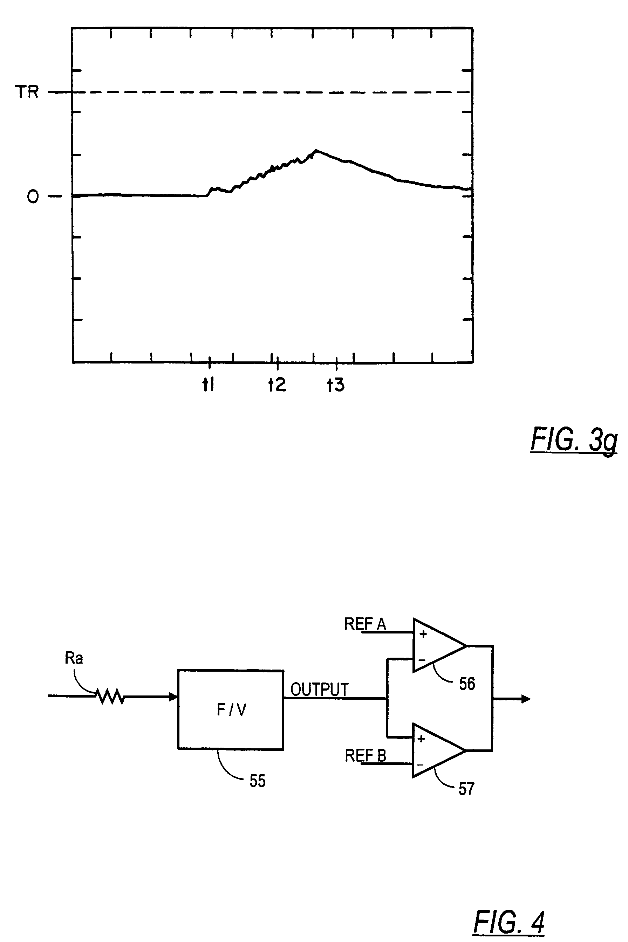

To convert the output pulses of the comparator 30, which vary in both width and amplitude, into a series of pulses of substantially constant width and amplitude, the comparator output is fed to a single-shot pulse generator circuit 40. This high-pass filter circuit includes a pair of capacitors C3 and C4 connected in series to the collector of the transistor Q1, and two resistor-diode pairs connected in parallel from opposite sides of the capacitor C4 to ground. The pulses produced by this circuit will be described in more detail below in connection with the waveforms shown in FIG. 3. The output pulses are predominantly pulses of equal width and amplitude, although occasional larger or smaller pulses can result from especially large or small input pulses.

The variable-width and variable-amplitude pulses of FIG. 3e are converted to a series of pulses of substantially constant width and amplitude by the single-shot pulse generator circuit 40. The output of this circuit 40, at point E in the circuit of FIG. 2, is shown in FIG. 3f. Although all the pulses shown in FIG. 3f are of substantially the same size, larger or smaller pulses may be produced by di/dt spikes that are excessively large or excessively small. The vast majority of the pulses at point E, however, are substantially independent of the amplitude and duration of the corresponding spikes in the di/dt signal, provided the spikes are large enough to produce an output pulse from the comparator 30.

The substantially uniform pulses produced by the circuit 40 are supplied to the base of a transistor Q2 through a current-limiting resistor R7. A capacitor C5 connected from the transistor base to ground improves the sharpness of the roll-off of the bandpass filtering. The transistor Q2 is the beginning of an integrator circuit 50 that integrates the pulses produced by the circuit 40. The pulses turn the transistor on and off to charge and discharge a capacitor C6 connected between the transistor emitter and ground. A resistor R9 is connected in parallel with the capacitor C6, and a resistor R8 connected between the supply voltage and the collector of the transistor Q2 determines the level of the charging current for the capacitor C6. The magnitude of the charge on the capacitor C6 at any given instant represents the integral of the pulses received over a selected time interval. Because the pulses are substantially uniform in width and amplitude, the magnitude of the integral at any given instant is primarily a function of the number of pulses received within the selected time interval immediately preceding that instant. Consequently, the value of the integral can be used to determine whether an arcing fault has occurred.

The integral signal produced by the circuit 50 is shown in FIG. 3g, taken at point F in the circuit of FIG. 2. It can be seen that the integrator circuit charges each time it receives a pulse from the circuit 40, and then immediately begins to discharge. The charge accumulates only when the pulses appear at a rate sufficiently high that the charge produced by one pulse is less than the discharge that occurs before the next pulse arrives. If the pulses arrive in sufficient number and at a sufficient rate to increase the integral signal to a trip threshold level TR (FIG. 3g), SCR1 is triggered to trip the circuit breaker. The circuit is designed so that this occurs only response to a di/dt signal representing an arcing fault.

When SCR1 is turned on, a trip solenoid S1 is energized to disconnect the load from the circuit in the usual manner. Specifically, turning on SCR1 causes current to flow from line to neutral through a diode bridge formed by diodes D7-D10, thereby energizing the solenoid to open the circuit breaker contacts in the line 16 and thereby disconnect the protected portion of the system from the power source. The d-c. terminals of the diode bridge are connected across SCR1, and the voltage level is set by a zener diode D6 in series with a current-limiting resistor R10. A varistor V1 is connected across the diode bridge as a transient suppressor. A filtering capacitor C7 is connected across the zener diode D6. The trip circuit loses power when the circuit breaker contacts are opened, but of course the contacts remain open until reset.

One example of a circuit that produces the desired result described above is the circuit of FIG. 2 having the following values:

| | |
|---|---|
| D1 | 1N4148 |
| D2 | 1N4148 |
| D3 | 1N4148 |
| D4 | 1N4148 |
| D5 | 1N4148 |
| D6 | 27v zener |
| R1 | 3.01K |
| R2 | 1.3K |
| R3 | 174K |
| R4 | 27.4K |
| R5 | 10K |
| R6 | 10K |
| R7 | 10K |
| R8 | 4.2K |
| R9 | 4.75K |
| R10 | 24K |
| L1 | 3300uH |
| L2 | 500uH |
| L3 | 500uH |
| C1 | 0.012uF |
| C2 | 0.001uF |
| C3 | 0.001uF |
| C4 | 0.001uF |
| C5 | 0.001uF |
| C6 | 6.8uF |
| C7 | 1.0uF |
| C8 | 1.0uF |
| Q1 | 2N2222A |
| Q2 | 2N2222A |
| SCR1 | CR08AS-12 made by POWEREX-Equal |
| V_{cc} | 27v |

Although a circuit breaker is the most commonly used line interrupter, the output device may be a comparator, SCR, relay, solenoid, circuit monitor, computer interface, lamp, audible alarm, etc.,

It will be understood that a number of modifications may be made in the circuit of FIG. 2. For example, the discrete bandpass filter between the sensor and the comparator can be replaced with an active filter using an operational amplifier. As another example, a single-shot timer can be used in place of the single-shot pulse generator in the circuit of FIG. 2. This circuit can receive the output signal from an active filter as the trigger input to an integrated-circuit timer, with the output of the timer supplied through a resistor to the same integrator circuit formed by the resistor R9 and capacitor C6 in the circuit of FIG. 2.

FIG. 4 illustrates a frequency-to-voltage converter circuit that can be used in place of all the circuitry between point A and the integrator circuit in FIG. 2. In this circuit, the signal from point A in FIG. 2 is supplied through a resistor Ra to a frequency/voltage converter integrated circuit 55 such as an AD537 made by Analog Devices Inc. The output of the integrated circuit 55 is fed to a pair of comparators 56 and 57 that form a conventional window comparator. Specifically, the output of the circuit 55 is applied to the inverting input of a comparator 56 and to the non-inverting input of a comparator 57. The other inputs of the comparators 56 and 57 receive two different reference signals A and B which set the limits of the window, i.e., the only signals that pass through the window comparator are those that are less than reference A and greater than reference B.

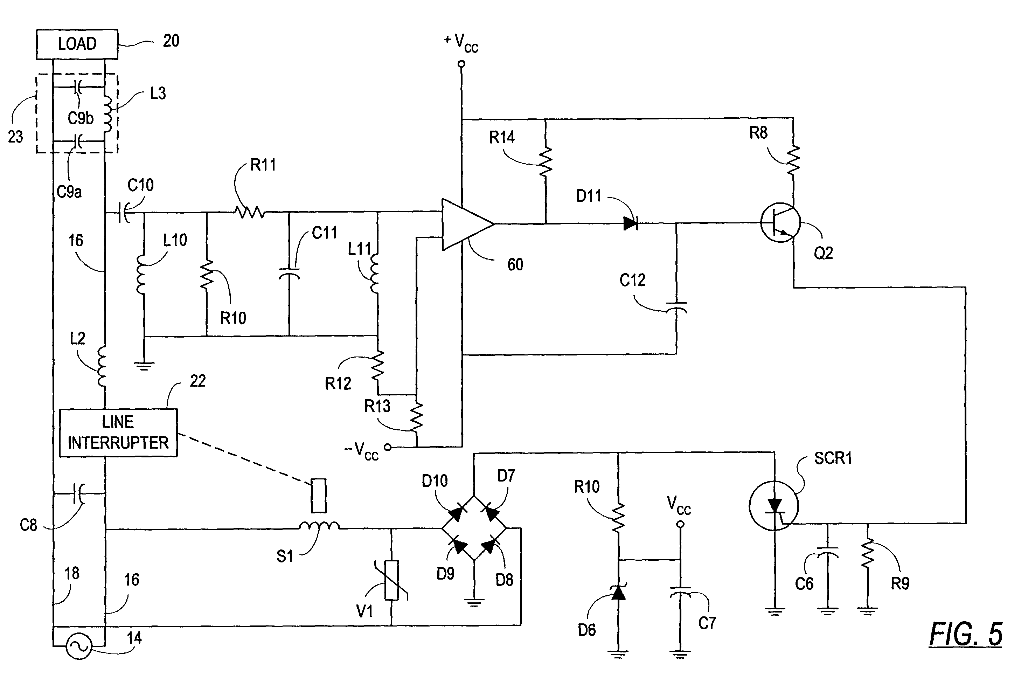

FIG. 5 illustrates an arc detector 10 for sensing the rate of change of the line voltage, i.e., dv/dt, rather than current. The sensor in this circuit is a capacitor C10 connected between a line conductor 16 and an inductor L10 leading to ground. The inductor L10 forms part of a bandpass filter that passes only those signals falling within the desired frequency band, e.g., between 10 KHz and 100 KHz. The filter network also includes a resistor R10, a capacitor C11 and a second inductor L11 in parallel with the first inductor L10, and a resistor R11 connected between the resistor R10 and the capacitor C11. The resistor R10 dampens the ringing between the capacitor C10 and the inductor L10, and the resistor R11 adjusts the threshold or sensitivity of the circuit. The inductors L10 and L11 provide low-frequency roll-off at the upper end of the pass band, and a capacitor C11 provides the high-frequency roll-off at the lower end of the pass band.

The capacitor C10 may be constructed by attaching a dielectric to the line bus so that the bus forms one plate of the capacitor. The second plate of the capacitor is attached on the opposite side of the dielectric from the bus. The sensor circuit is connected to the second plate.

The output of the bandpass filter described above is supplied to a comparator 60 to eliminate signals below a selected threshold, and to limit large signals to a preselected maximum amplitude. The filter output is applied to the inverting input of the comparator 60, through the resistor R11, while the non-inverting input receives a reference signal set by a voltage divider formed by a pair of resistors R12 and R13 connected between V_{cc} and ground. The comparator 60 eliminates very low levels of signal received from the sensor. The comparator 60 is normally off when there is no arcing on the line conductor 16, and thus the comparator output is low. When the voltage signal from the sensor is more negative than the reference input (e.g., -0.2 volts), the output from the comparator goes high, and a forward bias is applied to the transistor Q2 that drives the integrator circuit. A capacitor C12 connected from the base of transistor Q2 to -V_{cc} filters out high frequency noise. A diode D11 is connected between the comparator output and the base of the transistor Q2 to block negative signals that would discharge the capacitor C12 prematurely. The rest of the circuit of FIG. 5 is identical to that of FIG. 2.

When a fault occurs, it is desirable to isolate the branch of the distribution system in which the arcing fault occurred from the rest of the distribution system. In the system of FIG. 1, such isolation is provided by isolator #1 (24a, 24b...24n) and/or isolator #2 (25a, 25b...25n). Isolator #1 is designed for use in a system using a current-type sensor, as shown in FIG. 2, while isolator #2 is designed for use in a system using a voltage-type sensor, as shown in FIG. 5. Both isolator #1 and #2 may be used in a system having both a current- and a voltage-type sensor.

As shown in FIG. 2, isolator #1 comprises a capacitor C8 connected between the load line 16 and the neutral line 18 in each branch of the distribution system. The capacitor C8 is located between the line interrupter 22 and the power source 14 to provide a low impedance path for an arcing fault from the line conductor 16 to the neutral conductor 18, independent of the impedance of the load 20. More specifically, the capacitor C8 is designed to effectively short high-frequency arcing fault signals from line conductors 16 to neutral conductors 18, thus preventing a series path from being created between branch circuits and preventing the erroneous detection of arcing faults in other branch circuits. For example, with reference to FIG. 1, the isolator #1 will prevent high frequency arcing fault signals on line conductor 16a from crossing over to line conductor 16b. Accordingly, an arcing fault signal on line conductor 16a will properly trigger line interrupter 22a but will not trigger line interrupter 22b.

As shown in FIG. 5, isolator #2 comprises an inductor L2 in the load line 16 for each branch circuit. Each inductor L2 is located between the line interrupter 22 and the sensor 21 to provide an impedance for the current produced by an arcing fault.

The arcing fault detection system also includes a blocking filter 23 in each branch circuit for blocking false arcing fault signals or other nuisance output signals generated by normal operation of the load 20. Each blocking filter 23 is connected between the sensor 21 and the load 20 in each branch circuit to prevent false arcing fault signals from being delivered to the sensor 21. As seen in FIGs. 2 and 5, the preferred blocking filter includes a pair of capacitors C9a and C9b connected between the load line 16 and the neutral line 18 of each branch circuit. An inductor L3 is connected in the load line 16 between the two capacitors C9a and C9b. Preferably, the capacitors C9a and C9b have a rating across the line of about 0.47 uF. The inductor L3 has a rating for 15 amps at 500 uH and dimensions of about 1.5" diameter and 1.313" in length (e.g., Dale IHV 15-500). These values, of course, can be adjusted for the power rating of the electrical system and the loads 20.

The capacitor C9a creates a low impedance path for any series arcing that occurs upstream of that capacitor, such as arcing within the wall upstream of a noisy load. This permits series arcing to be detected in the branch containing the blocking filter. The inductor L3 creates an impedance that does most of the attenuation of the signal created by a noisy load. This inductor is sized to carry the load current of the device, which is typically 15 or 20 amperes. The second capacitor C9b reduces the amount of inductance required in the inductor L3, by creating a low impedance path across the load 20.

One of the advantages of the blocking filter 23 is that it can be used locally on a particular branch circuit that is known to connect to a load 20 which is noisy. The expense of using the blocking filter 23 is reduced since it can be used only where needed. The blocking filter 23 also allows easy retrofitting to existing electrical distribution systems in residences and commercial space.

Although the above system has been described in connection with an ordinary 120 volt system, it is applicable to the voltages of any standard, including 12, 120, 240, 480, 600 and 18500 volts. The system is suitable for use in residential, commercial and industrial applications, single-shot or multiphase systems and at all frequencies for a-c. as well as d-c. This system is applicable to automotive, aviation, and marine needs, separately derived sources such as generators or UPS, and capacitor banks needing incipient fault protection.

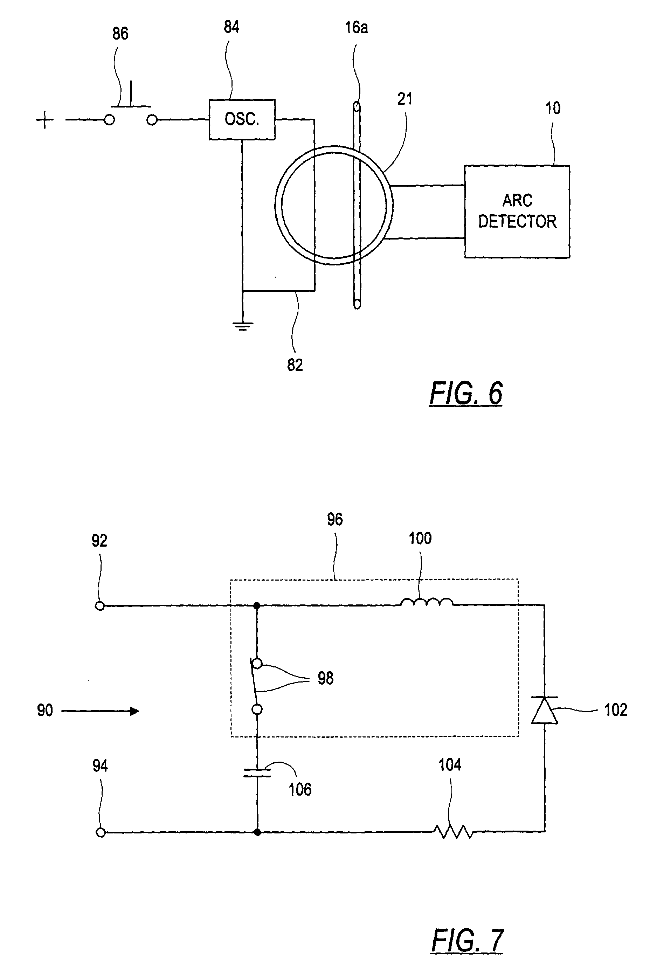

FIG. 6 illustrates a test circuit that may be used in an arcing fault detection system according to principles of the present invention. A test wire 82 passes through the sensing coil 21 together with the line conductor 16a. The test wire 82 is connected to a free running oscillator 84, which is adapted to produce a current in the test wire 82 simulating an arcing fault, preferably an alternating current with a frequency of about 10 kHz to 100 kHz. The simulated arcing fault passing through the test wire 82 is detected by sensor 21, which in turn sends a signal to the arcing fault detector circuit 10 in the same manner shown generally in FIG. 1. The arcing fault detector circuit 10 is preferably the same circuit shown in FIG. 2, but it will be appreciated any circuit which detects arcing faults may be used. The arcing fault detector circuit thereafter processes the signal produced by the sensor 21 in response to the test signal, produces a trip signal and triggers the line interrupter 22 (FIG. 2) in the same manner as it would for an actual arcing fault.

The oscillator 84 may be manually controlled through operation of a push-to-test switch 86. An operator may start the oscillator and introduce a current in the test wire 82 by depressing the push-to-test switch 86, and subsequently stop the oscillator by releasing the push-to-test switch 86. Moreover, a self-test or automatic test can be used instead of the manual test described above. For example, the switch can include a timer for automatically starting and stopping the oscillator 84 at preselected intervals.

An alternative test circuit 90 which may be used in arcing fault detection systems according to principles of the present invention is illustrated in FIG. 7. A first terminal 92 is connected to the line conductor and a second terminal 94 is connected to the neutral conductor of a selected branch circuit of an electrical distribution system having an arcing fault detector, as in FIG. 1. A relay 96 is connected between the first and second terminals 92 and 94. The relay 96 contains a pair of electrical contacts 98 and a relay coil 100. A diode 102 and a resistor 104 are connected between the second terminal 94 and the relay coil 100. A capacitor 106 is connected between the second terminal 94 and the electrical contacts 98. When the first and second terminals 92, 94 are attached to the line and neutral conductors of the selected branch circuit, alternating current from the branch circuit is introduced into the test circuit 90 and energizes the relay 96. The diode 102 thereafter causes the relay coil 100 to drop every half cycle, causing the electrical contacts 98 to rapidly open and close, once every cycle. This chattering effect of the electrical contacts 98 produces a signal on the line conductor which simulates an arcing fault condition. The simulated arcing fault condition is thereafter detected by the sensor 21 (FIG. 1) and processed by the arcing fault detector circuit 10 in the same manner as an actual arcing fault.

The relay 96 preferably comprises a Class 8501 Type KL-12 24VAC available from Square D Company, but it may comprise any comparable relay known in the art. The capacitor 106 preferably has a value of about 0.47 µF and is provided to increase the strength of the simulated arcing fault signal. The resistor 104 is provided to drop the 120 VAC of the branch circuit down to 24 VAC for the relay 96.

In one embodiment, the test circuit 90 is removably attachable to the line and neutral conductors of a selected branch circuit. This enables a user to externally remove and attach the test circuit to a selected branch circuit as often as needed or desired to test the arcing fault detection system. Alternatively, the test circuit 90 may be housed together with the arcing fault detector circuit in a common module.

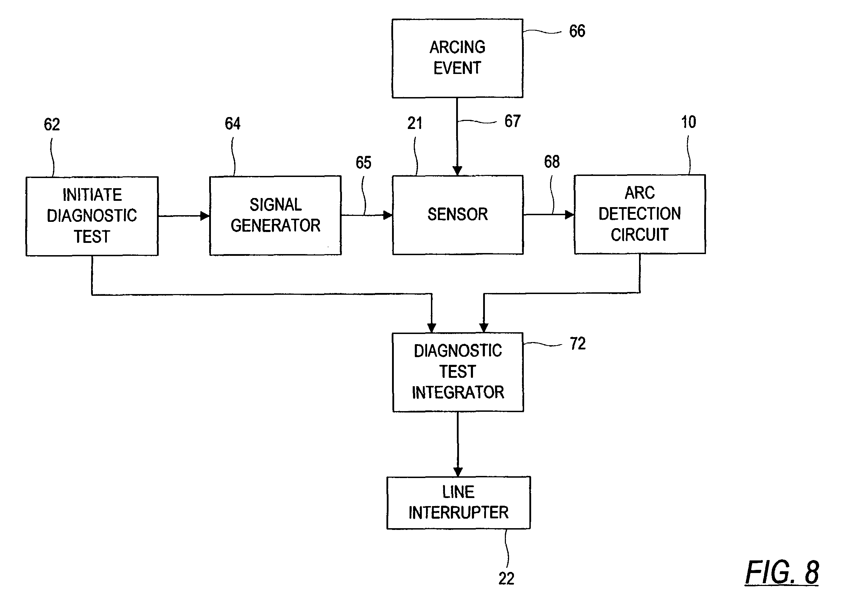

A flow chart for testing an arcing fault detection system according to principles of the present invention is illustrated in FIG. 8. Block 62 designates the initiation of a diagnostic test within the arcing fault detection system. The initiation step 62 may be accomplished automatically or under operator control. When the diagnostic test is initiated, a signal generator 64 provides a test signal 65 to a sensor 21. The test signal is designed to simulate the occurrence of an arcing fault. The signal generator 64 may comprise the oscillator 84 described in relation to FIG. 6, the test circuit 90 described in relation to FIG. 7 or any other means for producing a test signal 65 simulating an arcing fault. The sensor 21 preferably comprises a toroidal current sensing coil substantially the same as depicted in FIG. 6. The sensor 21 receives the test signal 65 and produces a rate-of-change signal 68. The rate-of-change signal 68 is processed by the arcing fault detection circuit 10 in the manner heretofore described to determine whether or not the test signal 65 represents an arcing fault. In addition, the sensor 21 also monitors the line conductor of a selected branch circuit for the occurrence of "true" arcing faults.

The arc detection circuit 10 thereafter provides an output to a diagnostic test integrator 72 indicating that an arcing fault either was detected or was not detected. The diagnostic test integrator also receives a signal from block 62 indicating whether or not the system is in test. Thus, either of four possible conditions will be received by the diagnostic test integrator 72: (1) the system is in test and an arcing fault was detected; (2) the system is in test and no arcing fault was detected; (3) the system is not in test and an arcing fault was detected; or (4) the system is not in test and no arcing fault was detected. The diagnostic test integrator 72 will produce a trip signal to trip open the contacts of a line interrupter 22 if either condition (2) or (3) occurs. Thus, a trip signal will be produced not only when a true arcing fault is present, but also when an arcing fault should have been indicated during the test protocol as a sign of operability and yet was not so indicated. Conversely, the diagnostic test integrator 72 will not produce a trip signal if either condition (1) or (4) occurs.

Where the sensor 21 comprises a toroidal winding, the arcing fault detection system may also be tested by testing the resistance of the winding. This may be accomplished by inputting a test signal having a known voltage through the winding and comparing the resistance of the winding to a known value to determine whether the winding is operating properly. Both of these steps may be accomplished while the sensor 21 is in operation. If the winding is found to be operating outside of an acceptable range above or below the known value, a trip signal is generated to interrupt the current flowing in the branch circuit associated with the sensor 21. If the winding is found to be operating properly, no trip signal is generated. In a preferred embodiment, the presence or absence of a trip signal resulting from testing the resistance of the winding is independent of the presence or absence of a trip signal from the diagnostic test integrator 72 of FIG. 8. For example, if no trip signal is produced because the coil is found to be operating properly as a result of the resistance test, a trip signal may nevertheless still be produced by the diagnostic test integrator 72 of FIG. 8 if either condition (2) or (3) occurs. Conversely, if a trip signal is produced by the resistance test because the coil resistance is not within proper limits, the line interrupter 22 will be triggered to interrupt the current in the branch circuit regardless of whether the diagnostic test integrator 72 of FIG. 8 has produced a trip signal.

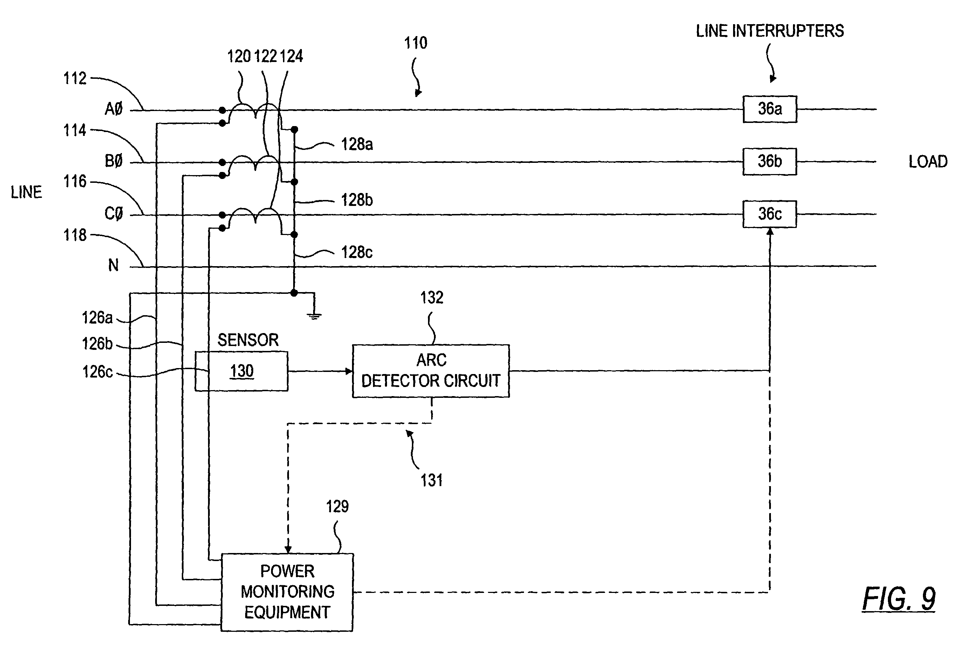

FIG. 9 shows a three phase, four wire electrical distribution system 110 adapted to distribute electrical power from a utility company power source (not shown) to various loads (not shown). Reference numerals 112, 114 and 116 designate three respective phase lines and reference numeral 118 designates a neutral line of the electrical distribution system 110. In industrial applications, each of the phase lines generally comprises a large bus bar which may be about eight inches in width and carry a current from 50 amps up to approximately 6,000 amps. Current transformers (CTs) 120, 122 and 124 having their primary windings connected to the respective phase lines 112, 114 and 116 are provided to step down the current to 5 amps on secondary lines 126a, 126b and 126c. Secondary lines 126a, 126b and 126c typically comprise #16 AWG electrical wires.

Power monitoring equipment 129 may be provided to monitor the electrical distribution system 110 via one or more of the secondary lines 126a, 126b and 126c. A sensor 130 is coupled to the secondary line 126c and is adapted to monitor the rate-of-change of electrical current flowing through the secondary line 126c and produce a signal representing the rate of change. The sensor 130 may be coupled to any one of the secondary lines 126a, 126b or 126c. Alternatively, second and third sensors may be provided to monitor any two or all three of the secondary lines 126a, 126b or 126c. In using sensor(s) connected to the relatively small secondary lines of a current transformer rather than to the large bus bars used in industrial applications, the sensor 130 is much smaller than prior art systems and may be installed more easily and much less expensively than prior art systems.

The sizes and current ratings heretofore described are intended to reflect those found in a typical industrial system, but it will be appreciated that the values heretofore described are exemplary only. Moreover, the present invention is not limited to three-phase, four-wire systems, but may be used with single-phase, three-wire systems or any other electrical power distribution system known in the art. Although the present invention is particularly adapted for industrial systems, it will be appreciated that the present invention may also be used in residential or commercial systems having a current transformer connected to the phase or line buses.

The rate-of-change signal from the sensor 130 is supplied to an arcing fault detector circuit 132, which produces a pulse each time the rate-of-change signal increases above a selected threshold. The rate-of-change signal and/or the pulses produced therefrom are filtered to eliminate signals or pulses outside a selected frequency range. The final pulses are then monitored to detect when the number of pulses that occur within a selected time interval exceeds a predetermined threshold. In the event that the threshold is exceeded, the arc detector circuit 132 energizes a trip solenoid (not shown) which triggers the appropriate line interrupter 136a, 136b or 136c to interrupt the current flowing in the respective line conductor 112, 114 or 116.

In an alternative embodiment, the power monitoring equipment 129 is capable of independently energizing a trip solenoid which triggers the line interrupters 136a, 136b or 136c. In this case, if the arcing fault detector circuitry 132 determines that an arcing fault has occurred, it may indirectly trigger the line interrupter 136 by sending a signal 131 to the power monitoring equipment rather than directly to the line interrupters.

Each of the line interrupters 136 is preferably a circuit breaker which includes an overload trip mechanism having a thermal/magnetic characteristic which trips the breaker contacts to an open circuit condition in response to a given overload condition, to disconnect the corresponding load from the power source, as is known in the art. The line interrupters may also be equipped with ground fault interrupter circuitry responding to a line or neutral-to-ground fault to energize a trip solenoid which trips the circuit breaker and interrupt the current in line conductor 112, 114 or 116.

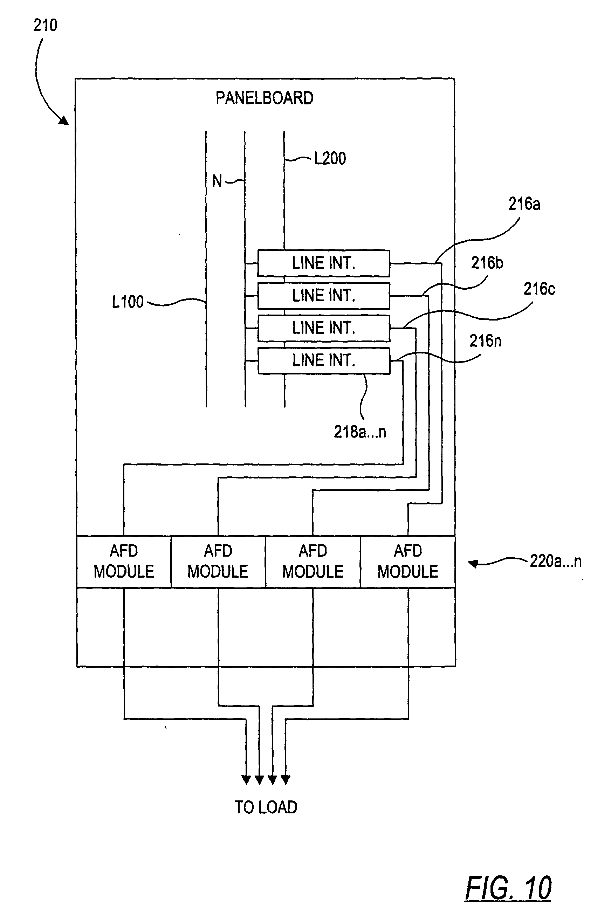

FIG. 10 depicts a panelboard 210 including an integrated protection system according to one embodiment of the present invention. As used herein, the term "panelboard" is intended to encompass electrical distribution devices having current capacities suitable for either residential, commercial or industrial uses. The panelboard 210 receives electrical power from a utility source through line buses L100 and L200 and a neutral bus N and distributes the power to loads in a plurality of branch circuits defined by line conductors 216a, 216b, 216c...216n and neutral conductors (not shown). The line conductors 216a, 216b, 216c...216n are electrically connected to one of the line buses L100, L200 and the neutral conductors are electrically connected to the neutral bus N. The panelboard 210 comprises a framework for attaching various circuit protection devices to the line and neutral conductors in either of the branch circuits.

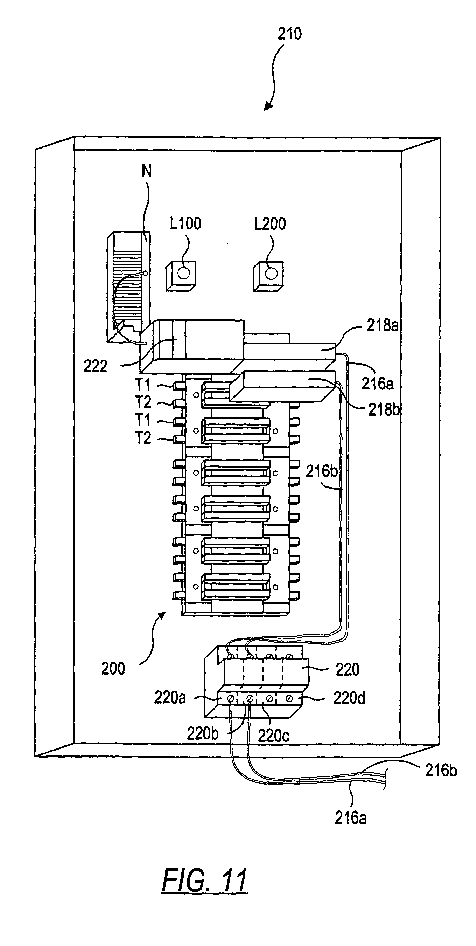

In the embodiment shown in FIG. 10, the integrated protection system includes a plurality of line interrupters 218a, 218b, 218c...218n and arcing fault detector modules 220a, 220b, 220c...220n (hereinafter "AFD modules"). Each of the line interrupters 218a, 218b, 218c...218n is designed to protect the branch circuit to which they are connected from overcurrents by disconnecting the load from the power source in response to the occurrence of an overload or short circuit in the branch circuit. The line interrupters may be plugged onto or bolted to one of the line buses L100 or L200 as shown in FIGs. 10 or 11, or they may be mounted separately within the panelboard 210 and connected to one of the line buses L100 or L200 by wire. The line interrupters may comprise a circuit breaker, fuse, relay, automatic switch or any suitable means known in the art.

Turning now to FIG. 11, the integrated protection system of FIG. 10 is shown in another embodiment using an isolation module 222 at the distribution panel. The isolation module 222 is designed to ensure that arcing fault signals are "isolated" to the branch circuit in which they occur. For example, the isolation device 222 shown in FIG. 11 ensures that arcing fault signals present on line conductor 216a do not cross over to line conductor 216b, and vice versa. A series of bus bar tabs T1 and T2 extend in alternating fashion along the length of distribution center 200. Each of the tabs T1 are electrically connected to line bus L100 and each of the tabs T2 are electrically connected to line bus L200. (The electrical connection between tabs T1, T2 and line buses L100, L200 is not visible in FIG. 11.) The isolation module 222 is electrically connected to the neutral bus N through pig-tail wire 219. The isolation module 222 comprises a "two-pole" module, connected to one of the tab pairs T1, T2 (not visible in FIG. 11), thus electrically connected to both line buses L100 and L200. It will be appreciated, however, that isolation may be provided by one or two "single-pole" isolation modules (not shown), each connected to one of the line buses L100 or L200 and the neutral bus N. In either case, it will further be appreciated that the isolation module(s) 222 may be connected to the line buses L100 and/or L200 by wire or other suitable means known in the art rather than as described above.

The electrical distribution system may also include individual isolation modules (not shown) for one or more of the individual branch circuits instead of the dual-pole isolation module 222 shown in FIG. 11. However, if individual isolation modules are desired, they must be positioned on the power source side of an arcing fault detector in any given branch circuit. For example, if branch isolation modules are used in FIG. 11, they must be positioned on the power source side of arcing fault detector modules 220a, 220b, 220c or 220d.

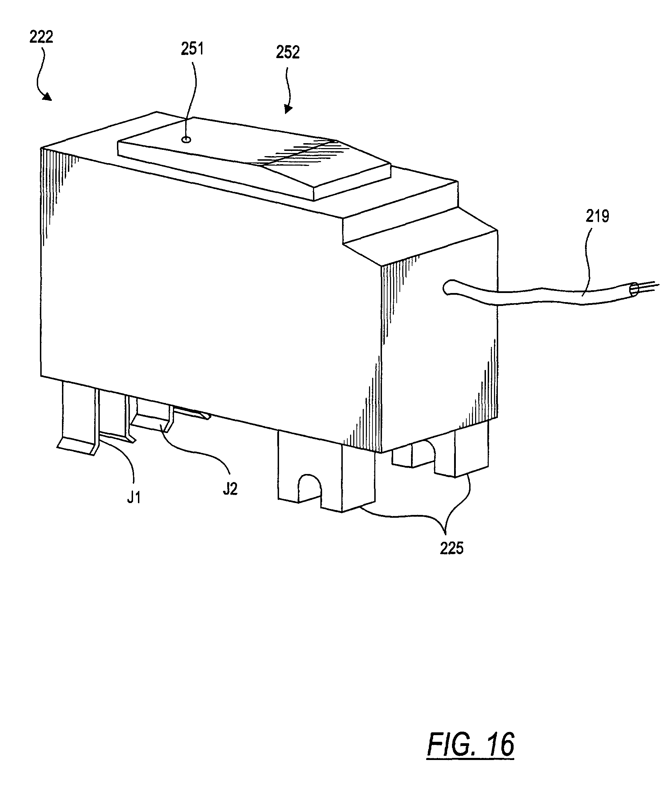

The exterior housing of the two-pole isolation module 222 is illustrated in more detail in FIG. 16. Jaws J1 and J2 on one side of the isolation module 222 are each adapted to plug onto one of the bus bar tabs T1, T2 of the distribution panel and thus provide an electrical connection to respective line buses L100 and L200. For instance, jaw J1 may be electrically connected to line bus L100 through connection to bus bar tab T1 and jaw J2 may be electrically connected to line bus L200 through connection to bus bar tab T2. Rail clips 225 on another side of the isolation module 222 are adapted to plug onto a mounting rail in the panelboard to help retain the isolation module 222 firmly in position in the panelboard. Pig-tail wire 219 connects the device to the neutral bus N. As will be described below, a window 251 in a top wall 252 of the housing allows a user to see an LED inside the device.

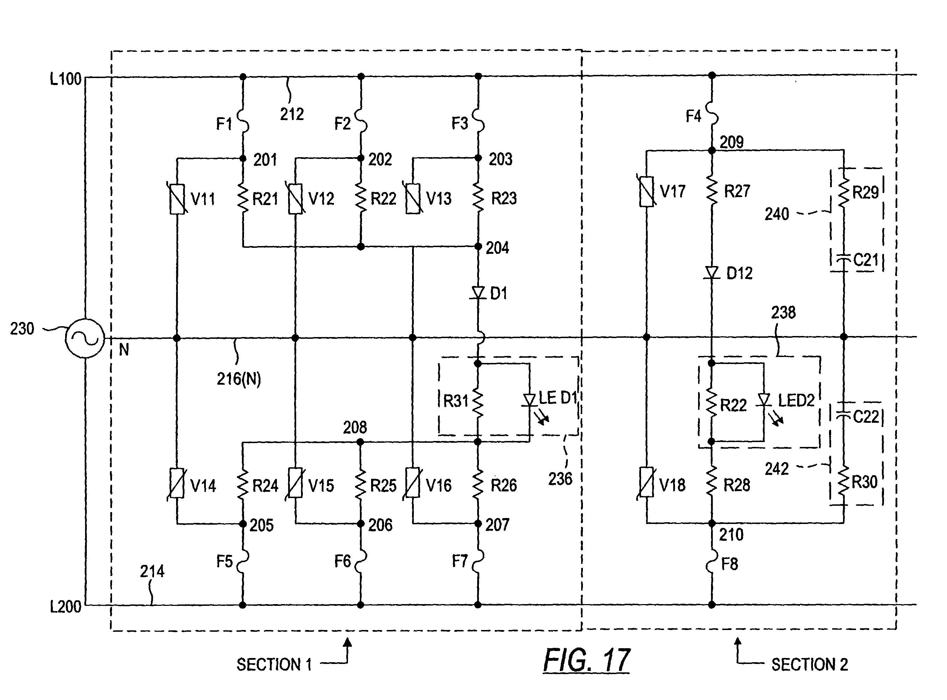

FIG. 17 depicts an electrical circuit for implementing the two-pole isolation module 222 described in relation to FIGs. 11 and 16. As shown in FIG. 17, the two-pole isolation module 222 is connected to supply source 230 via line buses L100 and L200 and neutral bus N. The isolation module 222 includes both surge protection circuitry (section 1) and isolation circuitry (section 2). However, it will be appreciated that module 222 may contain only isolation circuitry.

Referring initially to the surge protection circuitry (section 1) and, more specifically, to the portion of section 1 located between the line bus L100 and neutral bus N, there is provided a plurality of fuses F1, F2, F3 connected between the line bus L100 and nodes 201, 202, and 203 respectively. Varistors V11, V12, and V13 are connected between nodes 201, 202, and 203, respectively, and the neutral bus N. Preferably, the varistors are metal oxide varistors using zinc oxide. Resistors R21, R22, R23 are connected between nodes 201, 202, and 203, respectively, and node 204.

Fuses F1, F2, and F3 open if the respective varistors V11, V12, and V13 fail, that is if a destructive surge occurs. Resistors R21, R22, and R23 form a resistance ladder which develops a voltage across display resistor R31. Diode D11 provides a forward bias between node 204 and the first display 236.

Now referring to the remainder of the surge protection circuitry (section 1) located between the line bus L200 and the neutral bus N, there is provided a plurality of fuses F4, F5 and F6 connected between the line bus L200 and nodes 205, 206 and 207 respectively. Varistors V14, V15 and V16 are connected between nodes 205, 206 and 207, respectively, and the neutral bus N. Resistors R4, R5 and R6 are connected between node 205, 206 and 207 respectively and node 208. The fuses F4, F5 and F6 are designed to open if the respective varistors V14, V15 and V16 fail.

Display 236 comprises a resistor R31 connected in parallel with a light emitting diode LED1 visible through an opening 251 in a top wall 252 of isolation module 222 (shown in FIG. 16). LED1 provides for monitoring the status condition of varistor and fuse pairs such as V11 and F1. The intensity of LED 1 decreases when a fuse is blown. When only a predetermined number of varistor and fuse pairs remain operational, LED 1 will extinguish entirely to signal for replacement of the surge protection circuitry.

Specifically, the light output of LED1 varies with the operating condition of each varistor and fuse pair. Display 236 uses the first plurality of resistors R21, R22 and R23, the second plurality of resistors R4, R5 and R6, diode D11, resistor R31 and LED1 to indicate when the circuit is operating correctly. The resistance ladder of the first set of resistors R21-R23 monitors the fuses F1, F2 and F3 on line bus L100 and the second set of resistors R24-R26 monitors the fuses F4, F5 and F6 and the line bus L200. Line buses L100 and L200 each develop a voltage across resistor R31 that is proportional to the number of conducting fuses F1, F2, F3, F4, F5, F6. Only when a preselected number of these fuses are intact will sufficient voltage be available to forward bias LED1 to emit a signal to indicate that the surge protection circuitry is operational.

The above-described surge arrestor circuit is designed to limit the voltage between line bus L100 and neutral bus N upon the occurrence of a voltage surge. The operation of the surge arrestor circuit is described in detail in U.S. Patent No. 5,412,526, hereby incorporated by reference.

Referring next to the isolation circuitry (section 2) of FIG. 17 and, more specifically, to the portion of section 2 located between the line bus L100 and neutral bus N, there is provided a fuse F7 connected between the line bus L100 and a node 209. A filter 240 consisting of a capacitor C21 in series with a resistor R9, is connected between the node 209 and the neutral bus N. Filter 240 is designed to effectively short high-frequency arcing fault signals from line bus L100 to neutral bus N, thus preventing arcing fault signals on line bus L100 from crossing over to line bus L200. In completing the arcing fault signal path from line bus L100 to neutral bus N, the filter 240 accomplishes two functions. First, it prevents an arcing fault detector (not shown) on line bus L200 from detecting a "false" arcing fault signal on line bus L200. Second, it increases the signal strength at an arcing fault detector (not shown) positioned on line bus L100 on a load side of filter 240. Varistor V17 is connected between the node 209 and the neutral bus N. Varistor V17 provides a degree of surge protection for the isolation circuitry connected between the line bus L100 and the neutral bus N. A resistor R7 and a diode D12 are connected in series between the node 209 and a display 238.

Referring now to the remainder of the isolation circuitry (section 2) located between line bus L200 and neutral bus N, there is provided a fuse F8 connected between the line bus L200 and a node 211. A filter 242 consisting of a capacitor C22 in series with a resistor R30 is connected between node 211 and the neutral bus N. Filter 242 is designed to complete the arcing fault signal path from line bus L200 to neutral bus N by effectively shorting high frequency arcing fault signals from the line bus L200 to neutral bus N. Thus, similar to the filter 240 described above, the filter 242 prevents an arcing fault detector (not shown) on line bus L100 from detecting a "false" arcing fault signal on line bus L100, and increases the signal strength at an arcing fault detector (not shown) positioned on line bus L200 on a load side of filter 242. A varistor V18 provides a degree of surge protection for the isolator circuitry connected between line bus L200 and neutral bus N. Resistor R8 is connected between node 211 and display 238.

Display 238 consists of a resistor R32 connected in parallel with an LED2. Display 238 provides a means for monitoring the operating status of the isolation circuitry. Should fuse F4 or F8 blow for any reason, causing a loss of isolator functionality, the LED2 will turn off. LED2 is visible through an opening 251 in the top wall 252 of the isolation module 22 (shown in FIG. 16).

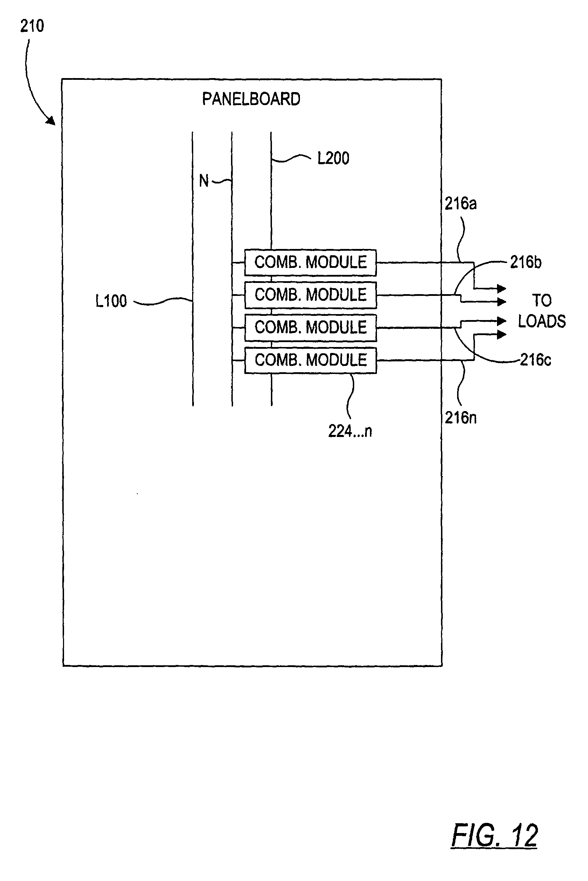

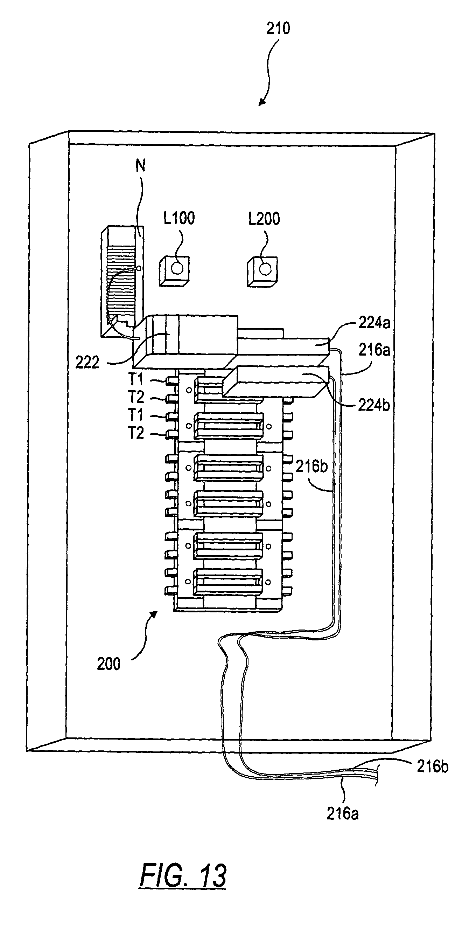

Referring now to FIG. 12, there is depicted a panelboard 210 including an integrated protection system according to another embodiment of the present invention. In this embodiment, the arcing fault detection and line interrupting functions described above are accomplished by combination arcing fault detector and line interrupter modules 224a, 224b, 224c...224n (hereinafter "combination modules"). Each of the combination modules is associated with one of the branch circuits of the electrical distribution system and includes both arcing fault detection circuitry and a line interrupter. The combination modules 224a, 224b, 224c...224n may be plugged onto or bolted to one of the line buses L100 or L200 as shown in FIGs. 12 and 13, or they may be mounted separately within the panelboard 210 and connected to the line buses L100 or L200 by wire. As shown in FIG. 13, the integrated protection system may also include an isolation module 222 for electrically isolating arcing fault signals to the branch circuit on which they occurred, as described in relation to FIG. 11. Branch isolation may also be achieved by isolation circuitry within the combination modules 224a, 224b, 224c...224n. In either case, the isolation module 222 or combination modules 224a...n may also include surge protection circuitry to protect the line buses or either of the branch circuits from voltage surges.

Similarly to the line interrupters described in relation to FIGs. 10 and 11, the combination module 224 shown in FIG. 12 or 13 may comprise a relay, fuse, automatic switch or circuit breaker combined with an arcing fault detector. In a preferred embodiment, the combination module 224 comprises a circuit breaker with arcing fault detection capability.

In the embodiment shown in FIG. 10, arcing fault detection capability is provided by the sensing coil 221 and associated electronic components 292. It is preferred that the electronic components 292 detect arcing faults in the manner of the AFD module 220 described in relation to FIGs. 4-8. However, it will be appreciated that the electronic components 292 may vary in configuration or operate differently than those of the AFD module 220. Moreover, in embodiments in which the circuit breaker 218 has GFI capability, the electronic components 292 may reflect any configuration known in the art for sensing ground faults. At any rate, the electronic components 292 are designed to produce an "AFD" signal (or "GFI" signal, if applicable) in response to detection of an arcing fault or ground fault. The AFD or GFI signal causes a magnetic field to be created around a trip solenoid 295, causing a plunger 297 to be drawn to the right. The plunger 297 is connected to a trip link 299, which in turn is connected to the armature 274, such that movement of the plunger 297 causes the armature 274 to be drawn to the right. Movement of the armature 274 to the right causes the trip lever 276 to be released and the current path through the circuit breaker 218 to be interrupted.

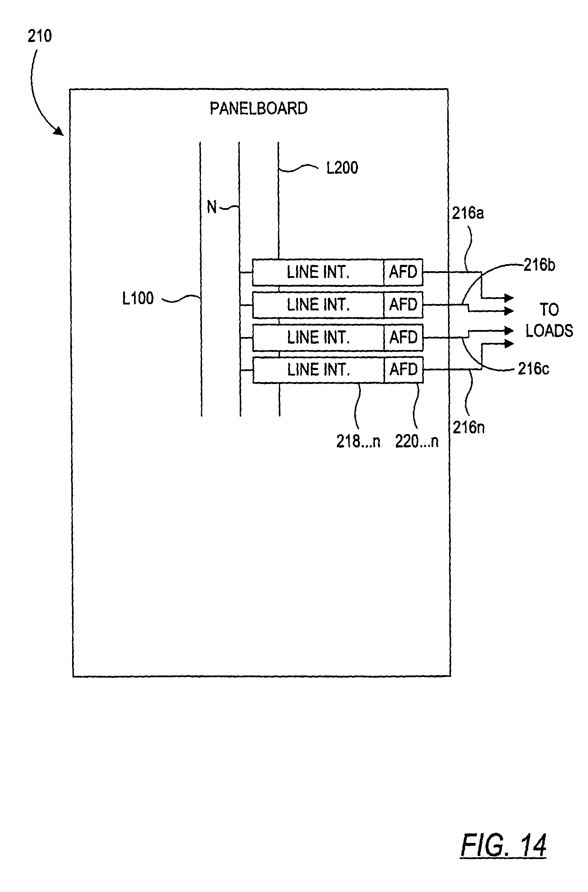

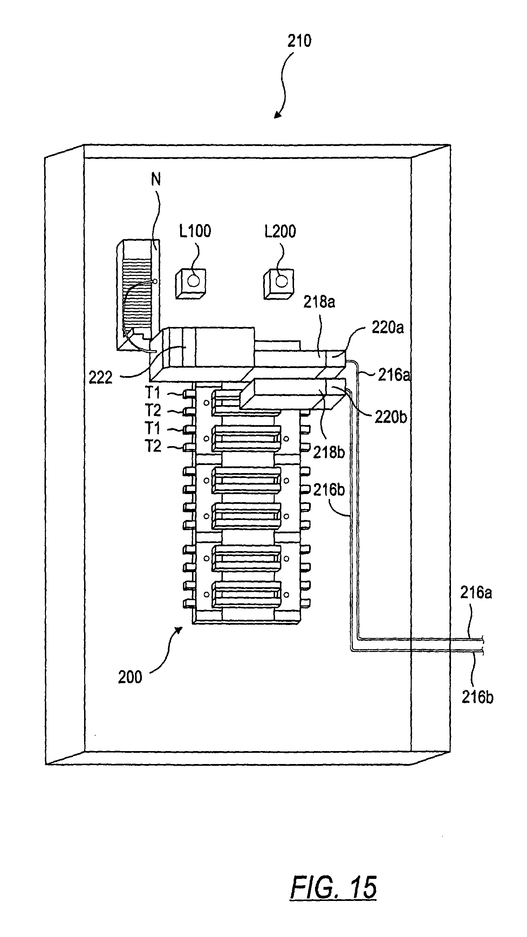

Now referring to FIGs. 14 and 15, there is depicted a panelboard 210 including an integrated protection system according to still another embodiment of the present invention. In this embodiment, the arcing fault detection and line interrupting functions described above are accomplished by separate arcing fault detector modules 220a, 220b, 220c...220n and line interrupter modules 218a, 218b, 218c...218n substantially as described in relation to FIGs. 10 and 11. However, in this embodiment, the arcing fault detector modules 220a, 220b, 220c...220n are attached externally to the line interrupter modules 218a, 218b, 218c...218n rather than being mounted to one of the positions in the panelboard 210. The line interrupter modules 218a, 218b, 218c...218n may be plugged onto or bolted to one of the line buses L100 or L200 as shown in FIGs.10 and 11, or they may be mounted separately within the panelboard 210 and connected to one of the line buses L100 or L200 by wire. The integrated protection system may also include isolation module(s) 222 and/or branch isolation means substantially as described in relation to FIG. 11. In either case, the isolation module(s) 222 or branch isolation means may include surge protection circuitry to protect the line buses or either of the branch circuits from voltage surges.

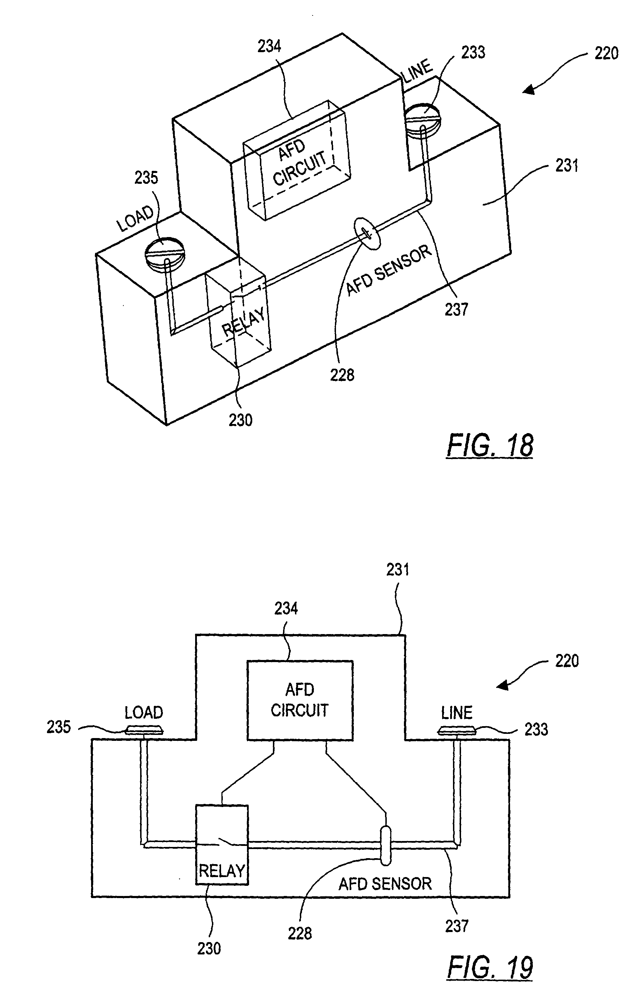

Now turning to FIGs. 18 and 19, there is depicted an AFD module 220 which may be utilized as one of the AFD modules 220a...220n in FIG. 10 or 11. The AFD module 220 comprises a housing 231 which is adapted to be connected to one of the positions in the panelboard. A line terminal 233 is provided for connecting the AFD module 220 to one of the line conductors 216a...216n by wire. Line current enters the AFD module 220 through the line terminal 233, flows through the AFD module 220 via internal line conductor 237 and exits the AFD module 220 via load terminal 235 before being supplied to the load. An AFD sensor 228 surrounds the internal line conductor 237 and senses the rate of change of electrical current flowing through the internal line conductor 237. The rate-of-change signal from the sensor 228 is supplied to the AFD circuit 234, which produces a pulse each time the rate-of-change signal increases above a selected threshold. The rate-of-change signal and/or the pulses produced therefrom are filtered to eliminate signals or pulses outside a selected frequency range. The final pulses are then monitored to detect when the number of pulses that occur within a selected time interval exceeds a predetermined threshold. In the event that the threshold is exceeded, the detector 234 generates an arcing-fault-detection signal that can be used to trip the line interrupter 230. The line interrupter 230 in the AFD module 220 is designed to interrupt power in the branch circuit resulting from an arcing fault, not an overcurrent (overload or short circuit) condition. Accordingly, as shown in FIGs. 18 and 19, it is preferred that the line interrupter 230 in the AFD module 220 comprise a relay rather than a circuit breaker such as that described in relation to FIGs. 13 and 14.

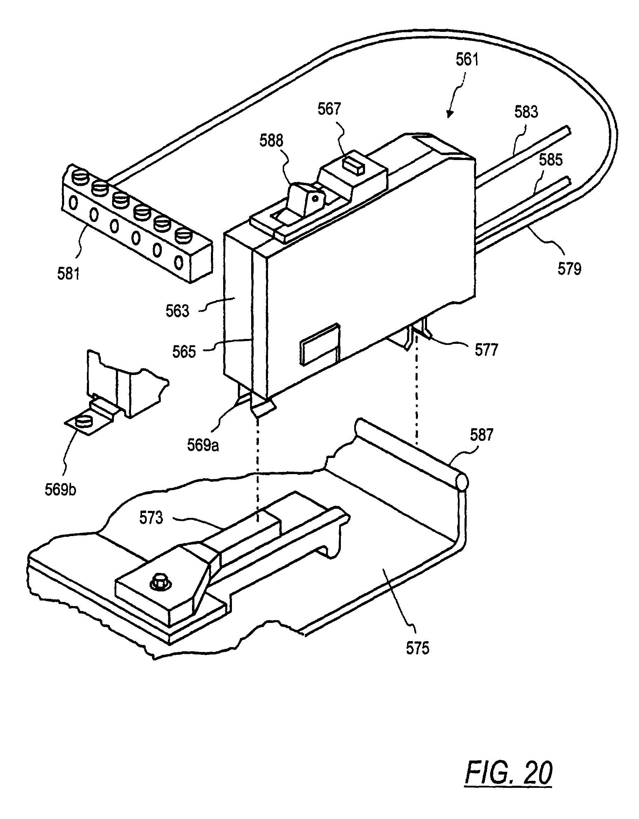

In one embodiment the line interrupters comprise circuit breakers which are connected to the panelboard by means of a housing 561 as depicted in FIG. 20. The miniature circuit breaker housing 561 is comprised of an electrically-insulating base 563 closed at one face by a detachable cover 565 which together enclose the components of a miniature circuit breaker, which may comprise a standard circuit breaker, a ground fault interrupter module, an arcing fault detection system or any combination thereof. In embodiments including an arcing fault detection system, the arcing fault detection system will preferably be that described in relation to FIG. 1, but it will be appreciated that alternative types of arcing fault detection systems may be enclosed within the miniature circuit breaker housing 561. A clip 577 is provided for mounting the housing 561 to a mounting bracket 587 of a panelboard 575 of an electrical distribution system. An electrically-conductive jaw-like terminal 569a or bolt terminal 569b extends through the base 563 to be externally connected to a line bus bar 573 within the panelboard 575. Similarly, a panel neutral conductor 579 extends through the housing 561 for connection to a neutral bar 581 in the panelboard 575. External connections to the line and neutral conductors leading to a load center of a branch circuit of the electrical distribution system are provided through a load line conductor 583 and load neutral conductor 585, respectively. An operating handle 588 and test button 567 are mounted through separate openings in the base 563 for external manual operation of the miniature circuit breaker.

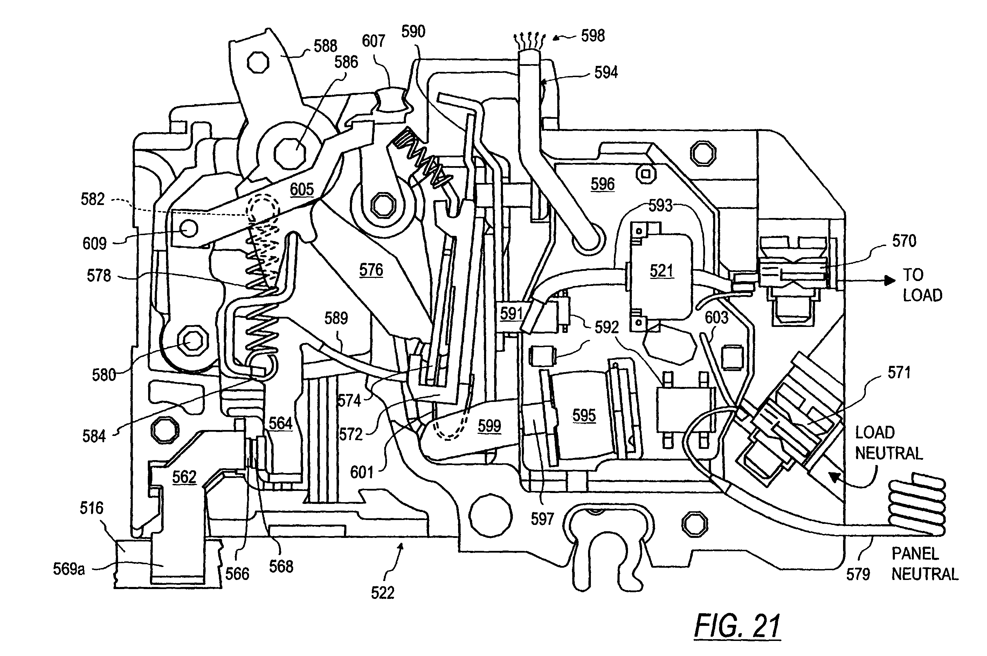

Turning now to FIG. 21, there is provided a diagram of a miniature circuit breaker 522 adapted to be housed within the miniature circuit breaker housing of FIG. 20 including standard circuit breaker components and an arcing fault detection system according to one embodiment of the present invention. As depicted in FIG. 21, the miniature circuit breaker 522 is in a closed position, enabling line current to flow completely through the circuit breaker and toward a load center of a designated branch circuit. Line current enters the circuit breaker 522 through the jaw-like terminal 569a and flows through a stationary contact carrier 562 integral with the terminal 569a. The stationary contact carrier 562 has a stationary contact 566 mounted thereon. When in the closed position, the stationary contact 566 abuts against a movable contact 568 which is mounted to a movable contact carrier 564. Line current thereby flows from the stationary contact carrier 562 to the movable contact carrier 564 through the stationary and movable contacts 566 and 568, respectively.

A pigtail conductor 589 is electrically connected at one end to the movable contact carrier 564 and at another end to a yoke 572, enabling line current to flow from the movable contact carrier 564 to the yoke 572 when the circuit breaker 522 is in a closed position. A bimetal conductor assembly 590 composed of two dissimilar thermostat materials is electrically connected to the yoke 572. The bimetal conductor assembly 590 includes a conductive plate 591 at one end which is electrically connected to an internal conductor 593. When the circuit breaker 522 is in the closed position, electrical current flows from the yoke 572 through the bimetal conductor assembly 590 to the conductive plate 591 and through the internal conductor 593. Thereafter, current flowing through the internal conductor 593 passes through a sensing coil 521 substantially as described in relation to FIG. 1 which monitors the rate of change of electrical current flowing through the circuit breaker 522. After exiting the sensing coil 521, the line current flows to load terminal block 570 to which the load line conductor 583 (FIG. 20) may be attached to provide the line current to a load. The load terminal block 570 is defined by two conductive plates adapted to be clamped together by a screw. The load line conductor 583 may be attached by inserting it between two conductive plates and tightening the screw of the load terminal block 570.

The miniature circuit breaker 522 also includes a neutral terminal block 571 to which the load neutral conductor 585 (FIG. 20) may be attached in a similar fashion as the load line conductor 583 is attached to the load terminal block 570. The miniature circuit breaker further includes an internal neutral conductor 603 electrically connected at one end to the circuit board 596 and at another end to the panel neutral conductor 579 described in relation to FIG. 20. In embodiments with ground fault interruption (GFI) circuitry, the panel neutral conductor 579 is routed through the sensor 521 along with the internal line conductor 593 to permit sensing of an imbalance of current flow between the internal line and neutral conductors 593 and 603 as is known in the art. A more complete description of GFI circuitry is disclosed in U.S. Patent No. 5,446,431, assigned to the instant assignee and incorporated herein by reference.

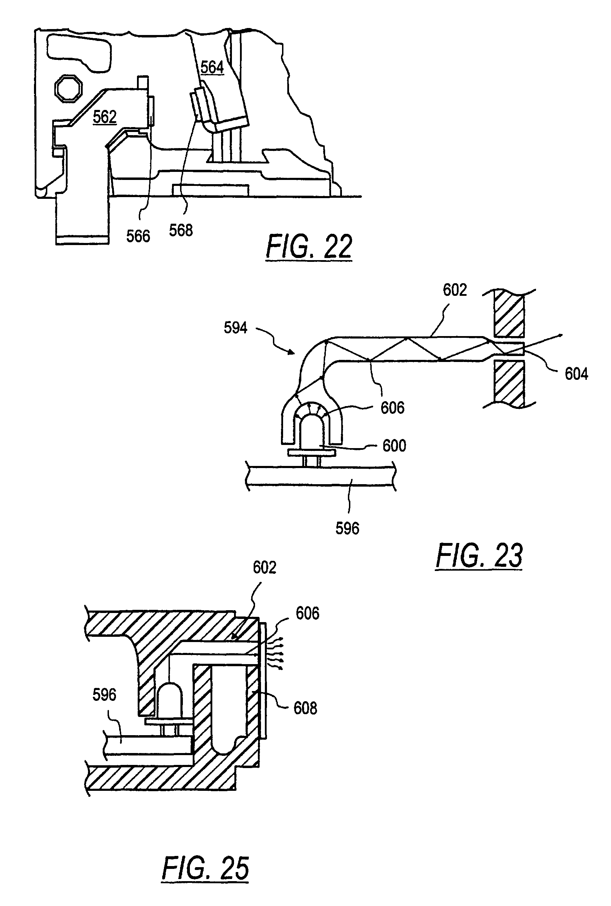

Now turning to FIG. 22, the miniature circuit breaker 522 is shown in an open position. In the open position, the movable contact carrier 564 is rotated away from the stationary contact carrier 562, causing the movable contact 568 to become separated from the stationary contact 566 and interrupt the electric current flowing through the circuit breaker 522. The circuit breaker 522 may be tripped open in any of several ways, including manual control and in response to thermally and electromagnetically-sensed overload conditions and ground fault conditions. As the mechanism for tripping open the circuit breaker 522 is described in detail in Patent No. 5,446,431, it will be described only briefly herein.

The miniature circuit breaker 522 may be moved between the open and closed positions by a user manually moving the operating handle 588 to the right or left, respectfully, causing corresponding movement of the top of the movable contact carrier 564 to the left or right of an equilibrium position. A toggle spring 578 is connected at one end to the operating handle 588 and at another end to the bottom of the movable contact carrier 564. When the top of the movable contact carrier 564 is left of the equilibrium position, the toggle spring 578 serves to bias the bottom of the movable contact carrier 564 to the closed position. Conversely, when the top of the movable contact carrier 564 is right of the equilibrium position, the toggle spring 578 biases the bottom of the movable contact carrier to the open position.

The miniature circuit breaker 522 may also be tripped open in response to sensing various types of fault conditions. Upon the occurrence of a moderately sustained overload condition when the contacts 566 and 568 are in a closed position, the bimetal conductor assembly 590 becomes heated and bends to the right. Bending of the bimetal conductor assembly 590 causes an armature 574 and yoke 572 to swing counterclockwise and release a trip lever 576. The trip lever 576 rotates clockwise about pin 580, causing the toggle spring 578 to pull the bottom of the movable contact carrier 564 away from the stationary contact 566 and interrupt the current path.

Similarly, upon the occurrence of an extensive current overload condition, a high magnetic flux field is created around the yoke 572. The armature 574 is drawn toward the yoke 572 by the magnetic field, causing the trip lever 576 to become released from the armature 574. As described in relation to thermal trips, release of the trip lever 576 from the armature 574 causes the toggle spring to pull the bottom of the movable contact carrier 564 away from the stationary contact 566 and interrupt the current path.

Finally, electronic components 592 mounted on a circuit board 596 are provided for processing the signal output of the sensor 521 and determining whether an arcing fault condition or ground fault condition is present. The electronic components 592 for sensing arcing faults are preferably the same as that described in relation to FIG. 2 or 5, but it will be appreciated that any configuration of electronic components 592 known in the art for detecting arcing faults may be provided. Similarly, the electronic components 592 may reflect any configuration known in the art for sensing ground faults. At any rate, the electronic components 592 are designed to produce either an "AFD" and/or "GFI" trip signal corresponding to whether the circuit breaker 522 is designed to sense arcing faults and/or ground faults. In response to generation of either an AFD or a GFI trip signal, a magnetic field is created around a trip solenoid 595, causing a plunger 597 to be drawn to the right. The plunger 597 is connected to a trip link 599, which in turn is connected to the armature 574, such that movement of the plunger 597 causes the armature 574 to be drawn to the right. As previously described, movement of the armature 574 to the right causes the trip lever 576 to be released and the current path through the circuit breaker 522 to be interrupted.

A flag armature 605 is connected to the trip lever 576 by a reset pin 609. When the trip lever 576 becomes released from the armature 574 in response to either of the several types of trip conditions described above, the flag armature 605 is moved to the right and becomes visible through a lens 607, thus providing an external trip indication external to the housing of the circuit breaker 522.

As depicted in FIG. 21, the circuit breaker 522 further includes a trip indicator 594 independent from the flag armature 605 for specifically indicating when the circuit breaker 522 has been tripped open by an arcing fault or ground fault. The trip indicator 594 is connected at one end to the circuit board 596 upon which are mounted the electronic components 592 described above for detecting arcing faults and/or ground faults. Upon generation of either an AFD or GFI trip signal, the circuit breaker 522 is tripped open and the trip indicator 594 provides a visible signal 598 external to the housing of the circuit breaker 522.

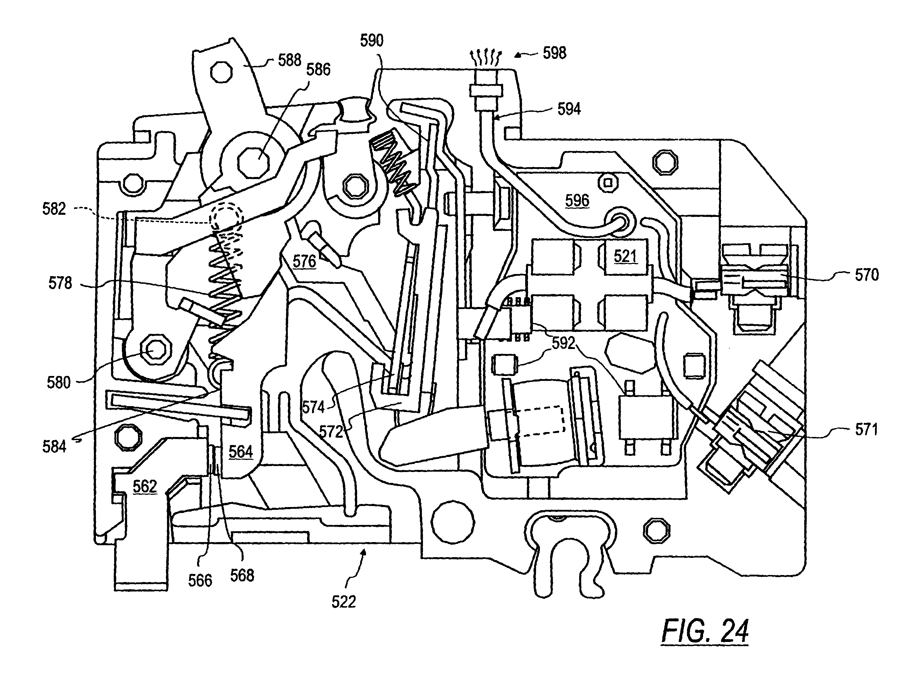

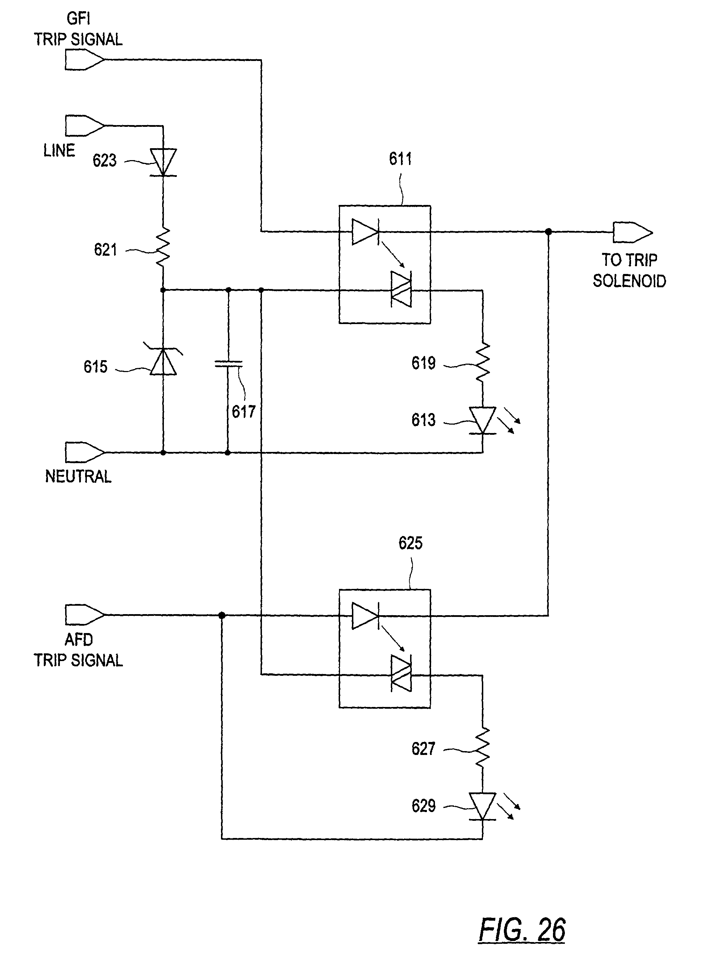

Referring now to FIG. 23, the trip indicator 594 will be described in greater detail. The trip indicator 594 comprises a light source 600, a light conduit 602 and an aperture 604. The light source may comprise a light emitting diode (LED), neon bulb or any other suitable light source known in the art. The light source is attached to the circuit board 596 within the circuit breaker housing and is illuminated in response to the generation of either an AFD or GFI trip signal. Illumination of the light source 600 causes light waves to emanate outwardly from the light source in a direction approximated by the arrows 606. A light conduit 602 having one end aligned with the light source subsequently intercepts the light waves emanating from the light source. The light conduit may comprise a light tube (FIGs. 21 and 23), a fiber optic cable (FIG. 24), an open portion of the circuit breaker housing (FIG. 25) or any other suitable means known in the art, but preferably is composed of a non-conductive material so that it does not interfere with the current carrying parts within the circuit breaker. Upon reaching the conduit, the light waves are redirected back and forth between the inner walls of the conduit as approximated by the arrows 606 in FIG. 23, ultimately reaching the aperture 604 at the other end of the conduit and emanating beyond the outer surface 606 of the circuit breaker housing. Accordingly, a user may determine the circuit breaker trip condition by observing the exterior of the circuit breaker housing. Generally, the presence of light emanating outside of the housing indicates that a trip condition has occurred, while the absence of light indicates that a trip condition has not occurred or that the circuit breaker has tripped due to electromechanical or thermal conditions.

Preferably, where the circuit breaker 522 contains both AFD and GFI sensing circuitry, the trip indicator 594 will indicate which type of fault condition caused the circuit to be interrupted. This may be accomplished by utilizing multiple light sources, each responding to a different respective AFD or GFI trip signal. Additionally, it is preferred that the light sources or single light source may be multi-colored so that illumination of a particular color will identify whether the circuit breaker 522 was tripped open by an arcing fault or ground fault. A representative circuit for accomplishing this purpose is shown at FIG. 26, which utilizes a red LED 613 for indicating a GFI fault condition and a yellow LED 629 for indicating an AFD fault condition. Of course, it will be appreciated that the color configuration of LEDs may be reversed or that alternative colors other than red and yellow may be utilized.

In the embodiment shown in FIG. 26, each of the LEDs 613 and 629 is electrically connected between the line and neutral conductors on a line side of the circuit breaker, isolated from the load side of the circuit breaker by respective optotriacs 611 and 625 to prevent any potential leak paths from line to load after the breaker has tripped. Activation of a GFI (or AFD) trip signal by the electronic components 592 (FIG. 21) causes an electrical current to flow through the optotriac 611 (or 625) which in turn provides a current path from line to neutral through the LED 613 (or 629). To keep the LED 613 or 629 illuminated after the breaker has tripped, the optotriacs 611 or 625 are latched to a conductive state by powering them directly from the line side of the breaker, thus providing a minimum current through the line side of the optotriac 611 or 625 independent of any signaling from the GFI or AFD circuitry.

Under normal operating conditions, the capacitor 617 has no discharge path, and therefore it retains a voltage level specified by the zener diode 615. Once the optotriac driver 611 (or 625) is triggered by GFI (or AFD) circuitry, the capacitor 617 is able to discharge through the LED 613 (or 629) only if the optotriac driver 611 (or 625) is activated on a negative half cycle. The RC time constant provided by resistor 619 (or 627) and capacitor 617 serves to hold the current above the maximum holding current of the optotriac 611 (or 625). This provides a forward-biased current path to LED 613 or 629 for the duration of the negative half cycle. On the next positive half cycle, the capacitor 617 will charge to the level specified by the zener diode 615. The positive half cycle will also provide current to keep the optotriac 611 or 625 conducting. If the optotriac driver 611 or 625 were initially triggered by the GFI or AFD circuitry on a positive half cycle, current from the positive half cycle would provide the current necessary to keep the optotriac driver 611 or 625 conducting. Once the voltage level of the positive half cycle starts falling below the voltage level that the capacitor 617 was charged to, the capacitor 617 will start discharging through the LED 613 or 629. The RC time constant provided by a resistor 619 (or 627) and the capacitor 617 serves to hold the current above the maximum holding current of the optotriac 611 (or 625).

A zener diode 615 is used as a voltage regulator for keeping the operation of the circuit insensitive to fluctuations in line voltage. A rectifier 623 is used to protect the LED 613 from large reverse voltages. A resistor 621 is used as a current limiter for the current flowing through the LED 613 or 629.

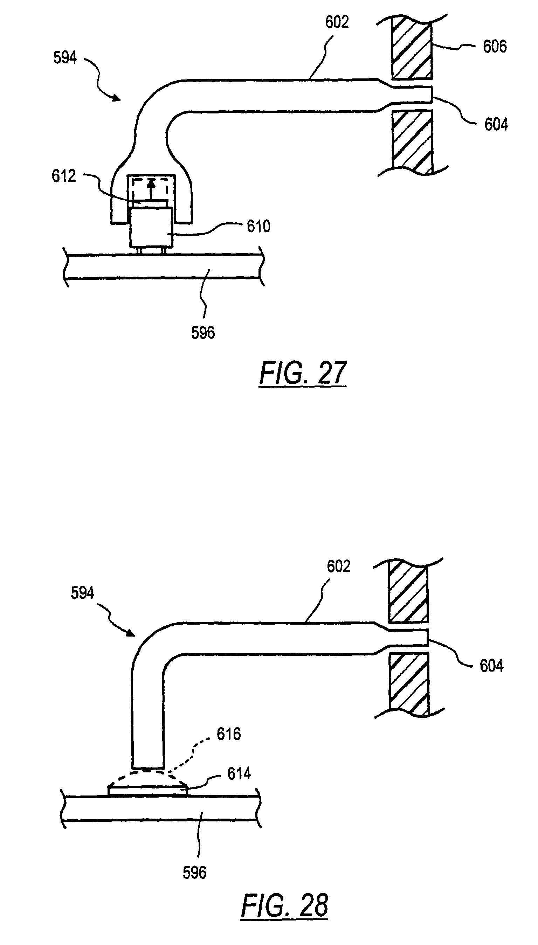

Turning now to FIG. 27, there is depicted an alternative embodiment of the trip indicator 594 in which a plunger 610 is attached to the circuit board 596 within the circuit breaker housing. The plunger 610 is movable between a retracted position and an extended position in response to the activation of the trip signal. When in the extended position, a colored tip 612 extends outwardly from the plunger 610 in response to the generation of a trip signal. A light tube 602 is aligned such that one end of the light tube 602 is adjacent to the colored tip 612 when the plunger is in the extended position. The other end of the light tube extends beyond the outer surface 606 of the circuit breaker housing. Ambient light external to the circuit breaker housing enters the light tube 602 through the aperture 604 and is reflected back and forth along the length of the light tube 602 until reaching the plunger 610. Upon reaching the plunger 610, the light is reflected back toward the aperture 604. When a trip signal has been generated causing the colored tip 612 to extend outwardly from the plunger 610, a reflection of colored light is propagated from the colored tip 612 along the surface of the light tube 602 and emanates out of the aperture 604.

Turning now to FIG. 28, there is depicted another alternative embodiment of the trip indicator 594 in which a bimetal disk 614 is attached to the circuit board 596 within the circuit breaker housing. The bimetal disk 614 is thermally movable between a generally flat position and a convex position in response to the activation of the trip signal. When in the convex position, a colored top 616 of the bimetal disk 614 extends outwardly from the circuit board 596 in response to the generation of a trip signal. A light tube 602 is aligned such that one end of the light tube is adjacent to the colored top 616 when it is in the convex position. The other end of the light tube extends beyond the outer surface 606 of the circuit breaker housing. Ambient light external to the circuit breaker housing enters the light tube 602 through the aperture 604 and is reflected back and forth along the length of the light tube 602 until reaching the bimetal disk 614. Upon reaching the bimetal disk 614, the light is reflected back toward the aperture 604. When a trip signal has been generated, causing the colored top 616 of the bimetal disk 614 to extend outwardly from the circuit board 596, a reflection of colored light is propagated from the colored top 616 along the surface of the light tube 602 and emanates out of the aperture 604.

As described in relation to FIG. 26, it is preferred that the trip indicator is capable of distinguishing whether the trip signal has been generated by AFD or GFI circuitry. This may be accomplished by utilizing multiple trip indicators of the type shown in FIGs. 27 or 28, each responding to the generation of either an AFD or GFI trip signal. Each of the respective trip indicators may include a different color of colored tip (FIG. 27) or colored top (FIG. 28) such that reflection of light from a particular color identifies the particular type of fault condition which caused the circuit breaker to trip open.

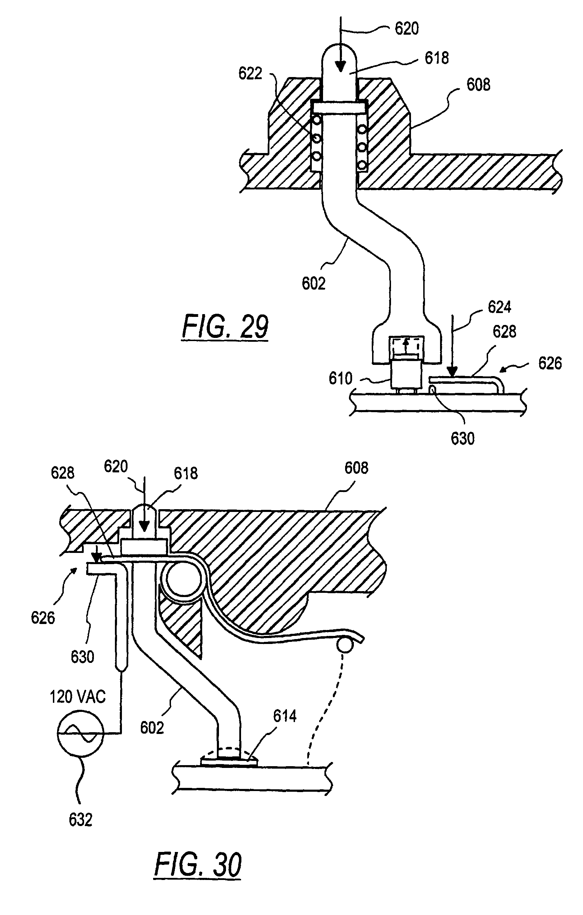

Now referring to FIGs. 29 and 30, there are depicted further embodiments of the trip indicator 594 including a reset button 618 and a test switch 626. As shown in FIG. 29, the reset button 618 is integral with the end of the light tube 602 extending beyond the circuit breaker housing 608, but it will be appreciated that the reset button may be located in a different position and physically independent from the light tube 602. The reset button 618 is designed to be depressed inwardly by a user in the direction of arrow 620, thereby causing the light tube to be moved inwardly within the circuit breaker housing 608. The trip indicator 594 may also include a coil spring 622 which is compressed when the reset button 618 is depressed and springs back when the reset button 618 is released. The light tube 602 will preferably be composed of a relatively stiff material, such as polycarbonate or acrylic plastic, so that the bottom portion of the light tube 602 is moved inwardly in the direction of arrow 620 when the reset button 618 is depressed. The bottom portion of the light tube 602 thereafter physically pushes down on the plunger 610 (FIG. 29) or bimetal disk 614 (FIG. 30), restoring the plunger or bimetal disk back to its respective untripped position (e.g. retracted or generally flat position).

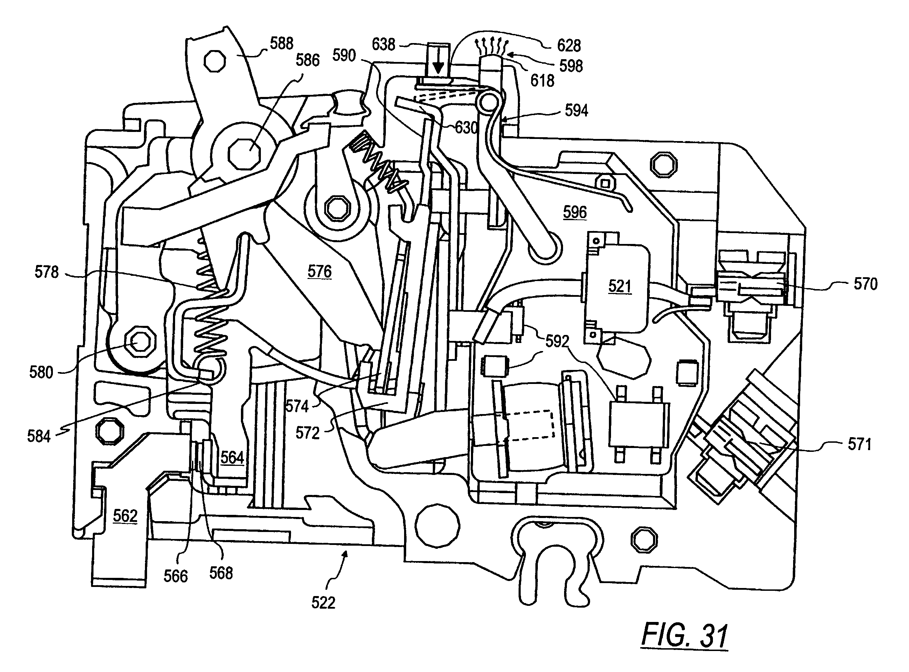

The trip indicator 594 may also be provided with a test switch 626 including a first contact 628, a second contact 630 and a push-to-test button for activating the test switch 626. The push-to-test button may comprise the reset button 618 as shown in FIGs. 29 and 30 or may comprise an independent push-to-test button 638 as shown in FIG. 31. In either case, upon depression of the push-to-test button, the first contact 628 is pressed down upon the second contact 630, forming an electrical connection between the two contacts 628, 630. The second contact 630 is connected to a current source 632, while the first contact 628 is connected to the electronic components 592 within the circuit breaker. Thus, depression of the push-to-test button 618 causes the current source 632 to become electrically connected to the electronic components 592 within the circuit breaker. The electronic components 592 thereafter interpret the influx of current from the current source as a fault condition and activate a trip signal in response thereto. Activation of the trip signal causes the trip indicator 594 to produce a light signal or reflected light signal external to the circuit breaker housing as described above. Upon release of the push-to-test button 618, the first contact 628 returns to its initial position apart from the second contact 630, causing an interruption of the electrical path between the current source 632 and the electronic components 592 within the circuit breaker.

In embodiments such as those depicted in FIGs. 29 and 30 in which a single button 618 is used as both a reset button and a push-to-test button, a time-delay circuit must be included within the electronic components 592 within the circuit breaker. Inasmuch as time delay circuits are well known in the art, they will not be described in detail herein. Suffice it to say that upon depression of the reset button/push-to-test button 618, the electronic components 592 within the circuit breaker will not activate a trip signal until the reset button/push-to-test button is depressed for a predetermined period of time. Accordingly, a user intending to reset the trip indicator 594 may press down briefly upon the reset button 618 without inadvertently activating a trip signal.

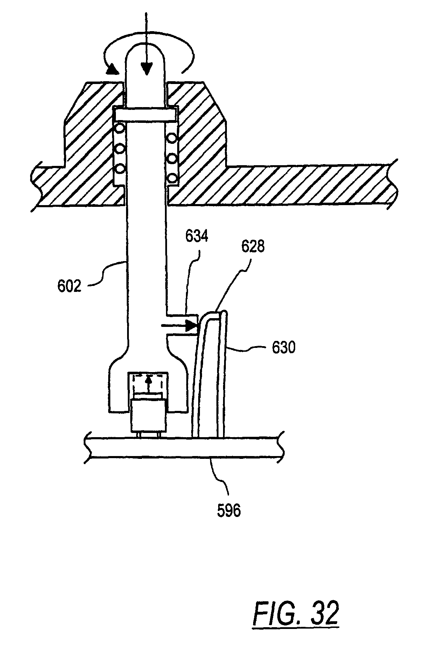

A still further embodiment of the trip indicator 594 is depicted in FIG. 32, in which the test switch may be activated by twisting rather than pushing down upon the light tube 602. In this embodiment, a cam 634 is attached to the light tube 602. Rotation of the light tube 602 causes the cam 634 to push the first contact 628 toward the second contact 630 and ultimately form an electrical connection between a current source and the electronic components 592 within the circuit breaker. Then, as described above in relation to FIGs. 29 and 30, the electronic components 592 activate a trip signal which in turn causes the trip indicator 594 to produce a light signal or reflected light signal external to the circuit breaker housing. As shown in FIG. 32, the above-described twist-to-test feature may be combined with the push-to-reset feature discussed in relation to FIGs. 29 and 30. Moreover, the trip indicator 594 may include a twist-to-reset feature combined with a push-to-test feature, a push-to-reset feature and a push-to-test feature, or a twist-to-reset feature and a twist-to-test feature.

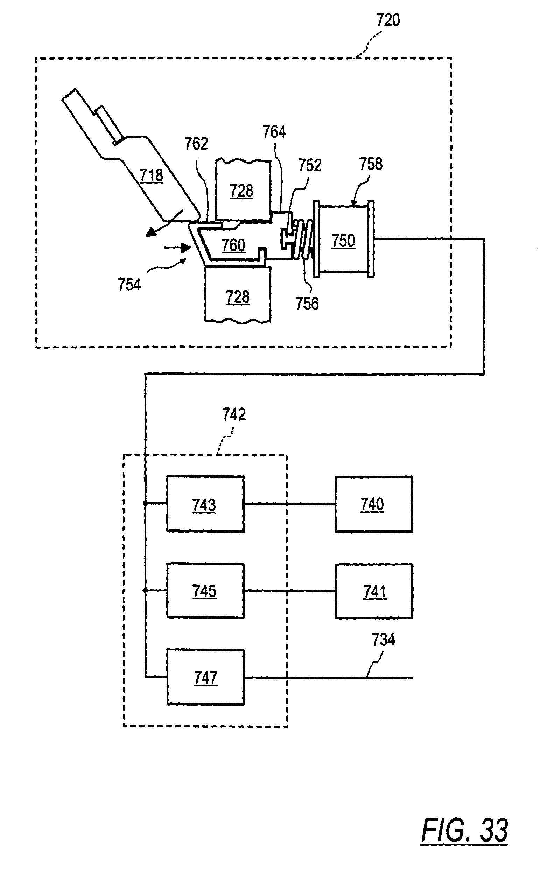

FIG. 33 illustrates the relationship among components for tripping a circuit breaker in response to sensing arcing faults, ground faults and overloads. To detect the occurrence of an arcing fault when the circuit breaker contacts are in a closed position, an arcing fault sensor 740 monitors a rate-of-change of electrical current in the line conductor 734 and provides a signal representing the rate-of-change to a trip circuit 742 comprising electronic circuitry mounted on circuit board 742. The arcing fault detection circuitry 743 in the trip circuit 742 analyzes the signal for characteristics of an arcing fault. When the arcing fault detection circuitry 743 detects the presence of an arcing fault, it sends a trip signal to the latching mechanism 720 to trip the circuit breaker 710.

To detect the occurrence of a ground fault when the circuit breaker contacts are in a closed position, a ground fault sensor 741 detects the difference in current in the line conductor 734 and a neutral conductor 733 and provides a signal representing the difference to the trip circuit 742. Ground fault detection circuitry 745 in the trip circuit 742 analyzes the signal for characteristics of a ground fault. If the ground fault detection circuitry 745 detects a ground fault, the trip circuit 742 sends a trip signal to the latching mechanism 720 to trip the circuit breaker 710 in the same fashion as described above.

To detect the occurrence of an overload when the circuit breaker contacts are in a closed position, the overload circuitry 747 of the trip circuit 742 samples the current flowing through the line conductor 734. The overload circuitry 747 analyzes current samples for characteristics of an overload. If the trip circuit 742 detects an overload, the trip circuit sends a trip signal to the latching mechanism 720 to trip the circuit breaker in the same fashion as described above.

The flexibility of electronic components of the trip circuit provide the circuit breaker with a variety of detection features. The circuit breaker may be provided with circuitry to open the breaker in response to an arcing fault, ground fault or overload. The electronic components of the trip circuit may be modified to detect only one of the above conditions, or all of the listed conditions. In every possible case, the trip circuit will provide the latching mechanism 720 with a trip signal in response to the occurrence of a detected condition.

FIG. 33 includes an enlarged side elevation of one embodiment of the latching mechanism 720. The latching mechanism 720 contains a coil 750, plunger 752, latch plate 754 and bias spring 756. The coil 750 is a typical solenoid, and the plunger 752 is positioned for movement into the coil 750. The latch plate 754 of FIG. 33 has a plastic rectangular block portion 760 partially surrounded by a thin metal jacket 762. The plastic portion 760 has an orifice end interlocking with a steel cylindrical plunger 752 to form the plunger/latch plate assembly. When the latching mechanism 720 is in the engaged position, the seat end of the latch plate 754 engages the trip lever 718. The metal jacket 762 of the latch plate 754 supplies a smooth, non-corrosive surface for easy motion within the breaker case 728 and away from the trip lever 718. The smooth motion from the engaged position to the released position gives the breaker 710 consistent tripping action.

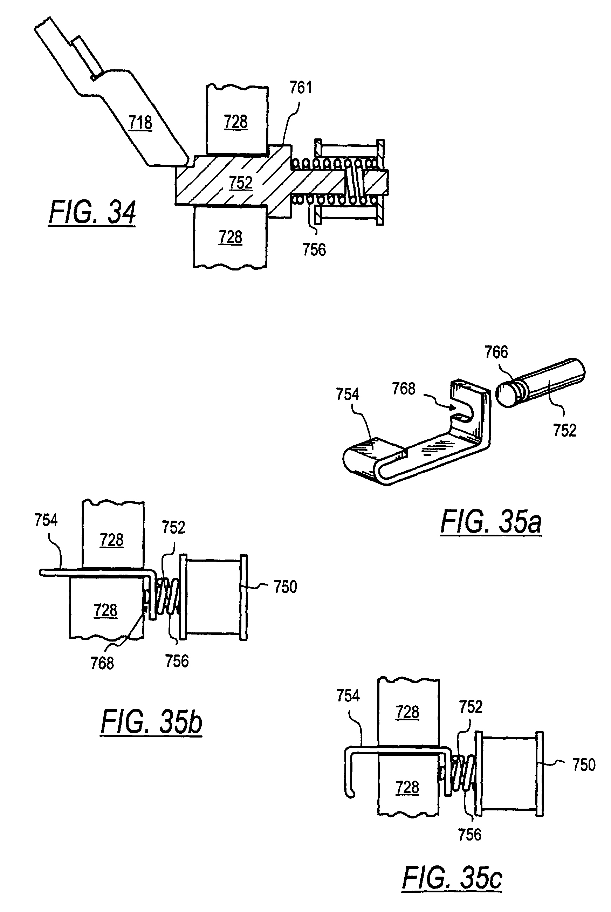

The latching mechanism of FIG. 33 further includes a bias spring 756 surrounding the plunger 752. One end of the bias spring 756 abuts the latch plate 754 and the other end abuts the coil 750. The bias spring 756 may abut the exterior portion of the coil housing 758, or the bias spring may be positioned within the coil 750 (see FIG. 34). The bias spring 756 pushes the plunger/latch plate assembly 752 and 754 away from the coil 750 to bias them toward the engaged position for seating the trip lever 718 on the latch plate 754.

When a overload, ground fault or arcing fault is detected by the trip circuit, the trip circuit sends a trip signal to the coil 750. The trip signal energizes the coil 750 and creates a magnetic field within the coil 750. The magnetic field draws the plunger 752 further into the coil 750. The plunger's motion into the coil 750 moves the plunger/latch plate assembly 752 and 754 to the right and compresses the bias spring 756. This motion pulls the latch plate 754 away from the trip lever 718 and disengages the trip lever 718 from its seat on the latch plate 754. The trip lever 718 slides off of the latch plate 754 into the tripped position, thereby causing the separation of the movable contact 726 from the stationary contact 724 and opening the circuit breaker 710.

FIG. 33 also illustrates an additional feature for the tripping mechanism 720. An upwardly extending stop 764 is formed on the latch plate 754. The stop 764 limits the movement of the plunger/latch plate assembly within the case 728. The stop 764 halts the motion of the plunger/latch plate assembly 752 and 754 to the left after the assembly has reached the position necessary to engage the trip lever 718. The stop 764 also halts the motion of the assembly 752 and 754 to the right after it has reached the position necessary to disengage the trip lever 718 from its seat on the latch plate 754.

Once the circuit breaker is in the released position, causing the trip lever 718 to be in the tripped position, current stops flowing from the line terminal to the load terminal. Current no longer flows through the line conductor. The current sensors 740 and 741 stop providing signals to the trip circuit because no current is available to measure. The trip circuit ceases transmitting a trip signal to the tripping mechanism 720, so the coil 750 is no longer energized. The magnetic field in the coil 750 vanishes, and the bias spring 756 returns the plunger 752 and latch plate 754 to their engaged positions.

To reset the circuit breaker, a user manually moves a handle to the typical reset position, moving the trip lever 718 upward to its latched position. The upper edge of the trip lever 718 moves the plunger/latch plate 752 and 754 toward the coil 750 by compressing the bias spring 756. When the trip lever 718 reaches its upper position, the plunger/latch plate 754 return to their engaged position, seating the trip lever 718 in its latched position.

There are several alternative embodiments for the integrated latch mechanism formed by the plunger/latch plate assembly 752 and 754 and the trip lever 718. FIG. 34 shows another embodiment for the plunger/latch plate assembly 752 and 754. In this case, the plunger 752 performs the function of the latch plate in the engaged position by providing a seat to mechanically engage the trip lever 718. The plunger 752 is a steel cylinder with a flattened seat end for mechanically engagement with the trip lever 718. The smooth surfaces of the plunger 752 eliminate friction with the trip lever 718 and the breaker case 728 when the plunger moves from the engaged to released position. To implement this arrangement, the plunger 752 has slight shoulder stops 761 to captivate the bias spring 756.

FIG. 35a-35c illustrate further embodiments of the plunger/latch plate assembly 752 and 754. In FIG. 35a, a flat metal latch plate 754 has a notched end 768 interlocking with the groove end 766 of the plunger 752. As depicted in FIG. 35b, the notched end 768 of the latch plate 754 abuts the bias spring 756 and acts as a stop by limiting the movement of the plunger/latch plate assembly 752 and 754 in the breaker case 728. The latch plate 754 in FIG. 35a has a folded seat end to engage the trip lever 718. Alternative embodiments for the seat end of the latch plate 754 are a rounded end of FIG. 35b and an L-shaped end turned away from the trip lever 718 as illustrated by FIG. 35c. For consistent tripping action, the surfaces of the above latch plates 754 are buffed smooth and rounded to allow the latch plate 754 to slide smoothly in the case 728 and away from the trip lever 718.

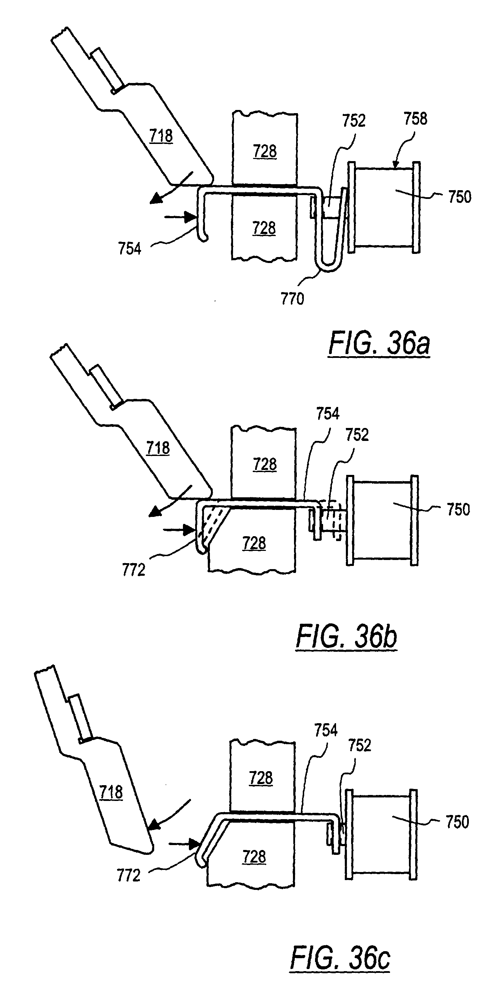

FIG. 36a-36c depict a plunger/latch plate assembly 752 and 754 with a latch plate 754 functioning as a self contained bias spring. In this arrangement, the latch plate 754 itself performs the biasing function of the bias spring 756 in the previous embodiments. The latch plate 754 is composed of a flexible metal which compresses under force and returns to its original form when the force is removed. The latch plate 754 with the self contained bias spring in its relaxed state is in the engaged position. When the plunger 752 is drawn into the coil so, the latch plate 754 is compressed or flexed such that the seat end engaging the trip lever 718 moves toward the coil 750 allowing the trip 718 to slide from its latched to tripped position interrupting the circuit

FIG. 36a shows one embodiment of the latch plate 754 functioning as a self contained spring. The latch plate 754 has a U-shaped portion 770 positioned between the grooved end of the plunger 752 and the coil housing 758. When the latching mechanism is in the engaged position, the U-shaped portion 770 in a relaxed state maintaining the engagement between the latch plate 754 and trip lever 718. When the plunger 752 is drawn into the coil 750, the U-shaped portion 770 of the latch plate 754 compresses. The motion of the plunger pulls the seat end of latch plate 754 to the right, causing the trip lever 718 to slide off the latch plate 754 and open the circuit.

FIG. 36b and 36c illustrate an alternative embodiment of the latch plate 754 with the self contained spring. In this embodiment, the self contained spring is an L-shaped portion of the latch plate with its leg 772 turned away from the trip lever 718. When the latching mechanism is in the engaged position, the leg 772 is in a relaxed state maintaining the engagement between the latch plate 754 and the trip lever 718 as shown in FIG. 36b. In FIG. 36c, the coil 750 pulls the plunger/latch plate assembly 752 and 754 to the right flexing the leg 772 and moving the seat end of the latch plate 754 to the right. Because of the motion of the seat end of the latch plate 754 toward the coil, the trip lever 718 slides off its seat on the latch plate 754 opening the circuit.

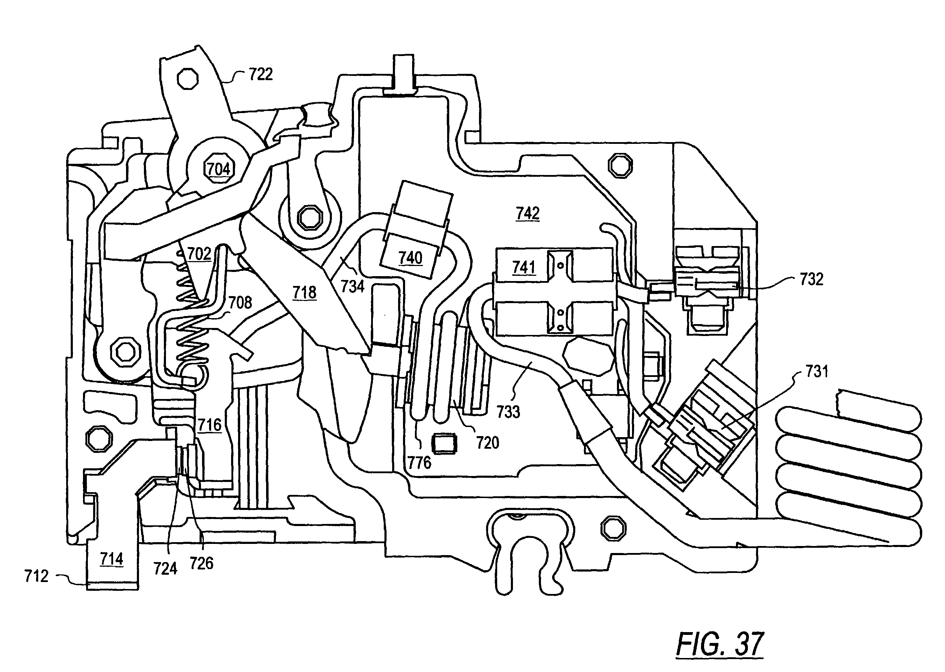

FIG. 37 illustrates a modified embodiment of the circuit breaker having the line conductor 734 wrapped around the latching mechanism 720 as a loop 776 for high magnetic tripping. When the current through the circuit breaker rises to a high level, i.e., above a preselected level, the current in the loop 776 produces a magnetic field that pulls the plunger 752 into the coil 750. The movement of the plunger 752 into the coil 750 opens the circuit as described in detail above. The high magnetic tripping of the circuit breaker occurs as soon as the current through the line conductor 732 passes the threshold level.

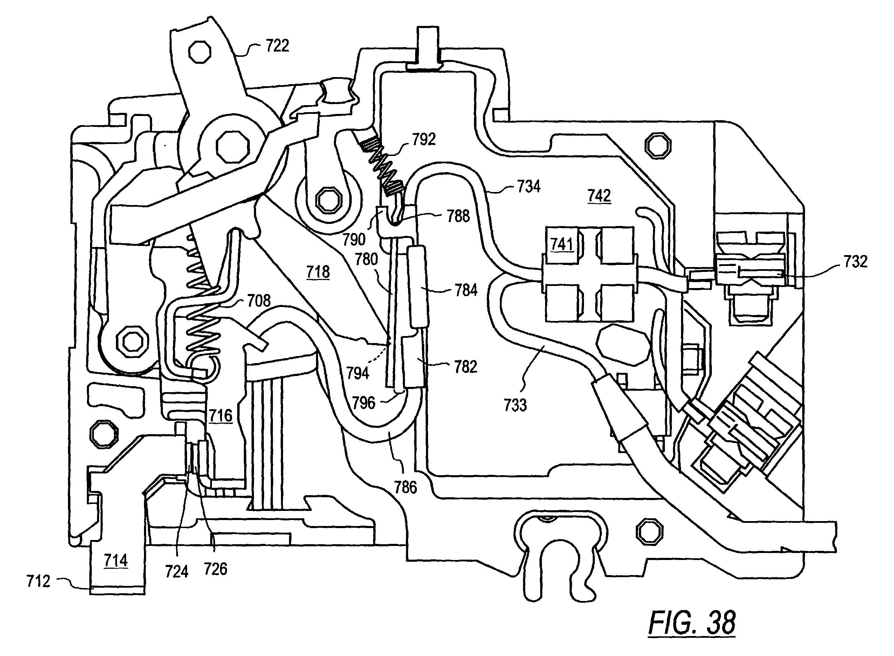

FIG. 38 shows a similar embodiment of the electronically controlled circuit breaker with integrated latch tripping. In FIG. 38, the latching mechanism 720 consists of an armature 780, yoke 782 and a trip coil 784 wrapped around the yoke 782. The current path in this embodiment passes from the moveable contact carrier 716 through a flexible conductor 786 (or pigtail) which connects the current path to a yoke 782, which, in turn, is electrically connected to the line conductor 734. FIG. 38 illustrates an embodiment of the circuit breaker 710 with a ground fault detection sensor 741. Other embodiments are contemplated including arcing fault and overcurrent detection circuitry.

As disclosed above, the ground fault sensor 741 in FIG. 38 senses the imbalance of current flow between the line and neutral conductors 734 and 733. When the trip circuit determines the presence of a ground fault, a trip signal is sent to the trip coil 784. The trip coil 784 is energized by the trip signal in the same manner as the coil was energized as disclosed above. The energized trip coil 784 generates a magnetic field about the yoke 782. In the preferred embodiment, the trip coil 784 has wrappings to produce a magnetic field of approximately 1500 A turns.

The armature 780 is pivotally cradled at its upper end 788 in the arms 790 of the yoke 782. An air gap 796 separates the armature 780 from the yoke 782. An armature spring 792 resiliently restrains the armature 780 from swinging relative to the yoke 782. When the latching mechanism is in the engaged position, the trip lever 718 engages the armature by resting on a seat 794 notched into the armature 780. When the trip coil 784 produces a magnetic field, the armature 780 is drawn toward the yoke 782 causing the armature 780 to swing counterclockwise closing the air gap 796 moving the latching mechanism to its released position. When the armature 780 swings to the right, the trip lever 718 is released from its seat 794 on the armature 780. As disclosed above, the trip lever 718 swings clockwise to open the circuit.

The circuit breaker may be reset in its traditional fashion. With the circuit open, a trip signal is no longer sent to the trip coil 784, so the magnetic field dissipates and the armature 780 returns to its engaged position. A user manually moves the handle 722 to the typical reset position, rotating the trip lever 718 counterclockwise. The trip lever 718 engages the armature 780 moving it toward the yoke 782. When the trip lever 718 reaches its upper position, the trip lever 718 returns to its seat 794 on the armature 780 resetting the trip lever in its latched position and resetting the circuit breaker.

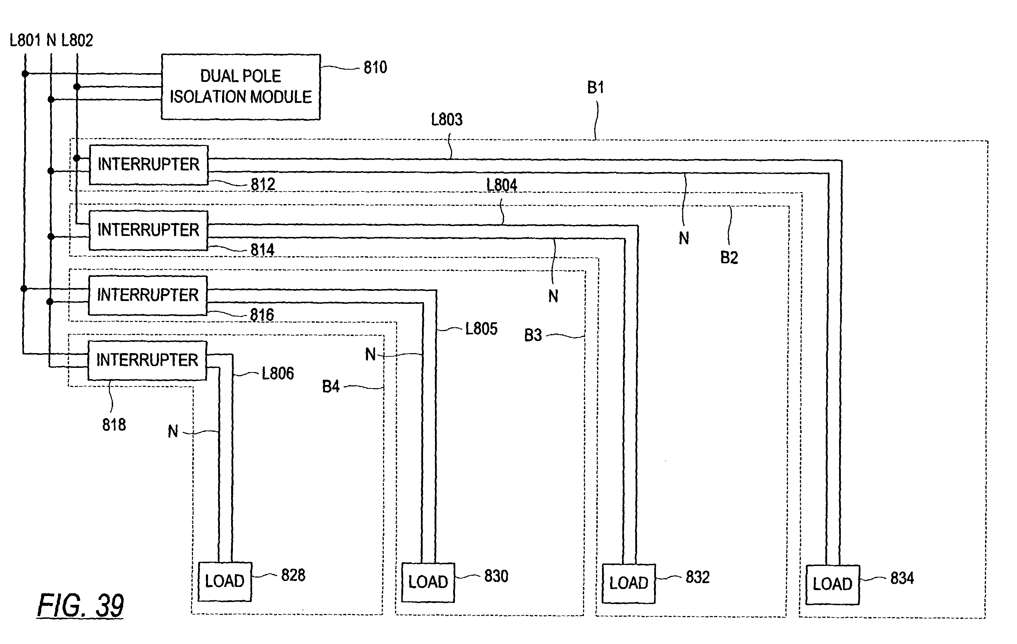

As shown in FIG. 39, a dual-pole isolation device 810 is connected to a first line bus L801, a second line bus L802, and a neutral bus N of an electrical distribution network. The electrical distribution network delivers electrical power from a power source (not shown) to branch circuits B1, B2, B3 and B4 each including respective line conductors L803, L804, L805 and L806 and a neutral conductor N for delivering electrical power to respective loads 834, 832, 830 and 828. Line interrupters 812, 814, 816 and 818 are attached to the respective line conductors L803, L804, L805 and L806 of each branch circuit between the power source and the load. The line bus L802 is connected to line interrupters 812 and 814 while line bus L801 is connected to interrupters 816 and 818. The line interrupters 812, 814, 816, and 818 are designed to break the current flow in a particular branch circuit B1, B2, B3, and B4 when an arcing fault is detected in the branch circuit. However, it will be appreciated that the electrical distribution network heretofore described is exemplary only.

The dual-pole isolation device 810 is designed to ensure that high frequency arcing fault signals present on either of the branch circuits B1, B2, B3 or B4 are isolated to the branch circuit on which the arcing fault occurred, thus ensuring that only the line interrupter associated with the branch circuit in which the arcing fault occurred is tripped. More specifically, the isolation device 810 ensures that an arcing fault signal present in branch circuit B1 will not trip line interrupters 814, 816 or 818, but rather will trip only line interrupter 812. Similarly, the isolation device 810 ensures that an arcing fault signal present in either of branch circuits B2, B3 and B4 will trip only respective line interrupters 814, 816 and 818. This is achieved by providing a low impedance path from line bus L801 to neutral bus N and from line bus L802 to neutral bus N, so that arcing fault signals in either of the branch circuits B1, B2, B3 and B4 are effectively shorted at line bus L801 or L802, thus preventing "false" arcing fault signals in the other branch circuits. By completing the arcing fault signal path, the isolation device 810 also serves to increase the signal strength at the arc fault detector in the branch circuit in which the arcing fault occurred. Preferably, the isolation device 810 also includes surge protection circuitry which protects the electrical distribution network from voltage surges.

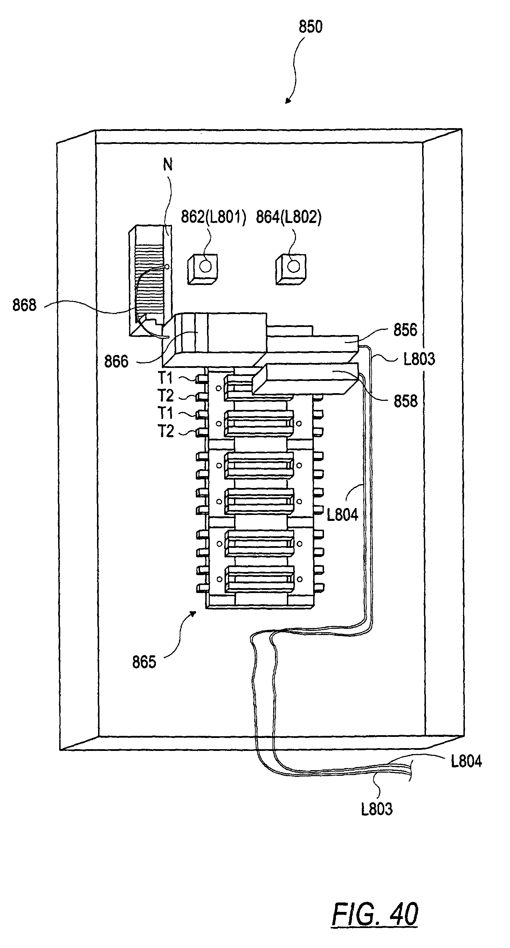

Turning now to FIG. 40, there is depicted a panelboard 850 which may be used to house the isolation device. As used herein, the term "panelboard" is intended to encompass electrical distribution devices having current capabilities suitable for residential, commercial, or industrial uses. The panelboard 850 transmits electrical power from a utility source to a plurality of branch circuits through line buses L801 and L802 and a neutral bus N. Each branch circuit comprises a line and neutral conductor for delivering electrical power from the panelboard to a load. As shown in FIG. 40, the branch circuits comprise line conductors L803 and L804 and respective neutral conductors (not shown) for delivering electrical power to respective loads (not shown). Each of the line conductors L803 and L804 is electrically connected to one of the line buses L801 or L802 and the neutral conductors are electrically connected to the neutral bus N at the distribution panel. Each of the line conductors L803 and L804 are routed through respective line interrupters 856 and 858.

The line buses L801 and L802 and the neutral bus N are typically at 240 volts or 120 volts, and a frequency of 60 Hz and enter the panelboard at main lugs 862 and 864. A series of bus bar tabs T1 and T2 extend in alternating fashion along the length of distribution center 865. Each of the tabs T1 are electrically connected to line bus L801 and each of the tabs T2 are electrically connected to line bus L802. (The electrical connection between tabs T1, T2 and line buses L801, L802 is not visible in FIG. 40.) A dual pole isolation device 866 is connected to one of the tab pairs T1, T2, thus is electrically connected to both line buses L801 and L802. The dual pole isolation device 866 is electrically connected to the neutral bus N through pig-tail wire 868. As discussed above, the isolation device 866 is designed to ensure that arcing fault signals are "isolated" to the branch circuit in which they occur. For example, the isolation device 866 shown in FIG. 40 ensures that arcing fault signals present on line conductor L803 do not cross over to line conductor L804, and vice versa.

Referring again to FIG. 40, each branch circuit of the panelboard includes a line interrupter 856 or 858 designed to disconnect the load from the power source in any of the branch circuits in which an arcing fault occurs. In a preferred embodiment, each of the line interrupters 856 or 858 comprises a circuit breaker having a trip mechanism which trips the breaker contacts to an open circuit condition in response to characteristics of arcing faults, as is known in the art. One preferred method of detecting arcing faults is disclosed in pending U.S. Patent Application Serial No. 08/600,512 filed February 13, 1996, for "Arcing Fault Detection System", assigned to the assignee of the present invention and incorporated herein by reference. The circuit breaker may also respond to overload conditions having thermal/magnetic characteristics, as is known in the art. It is also known to provide the circuit breaker with ground fault interrupter circuitry responding to a line or neutral-to-ground fault to energize a trip solenoid which trips the circuit breaker and opens the contacts.

The line interrupters may comprise a circuit breaker, fuse, relay automatic switch or any suitable means known in the art. The line interrupters need not be the same type in each of the branch circuits. The line interrupters may be plugged onto or bolted to one of the distribution buses L801 or L802 or they may be mounted separately within the panelboard and connected to one of the distribution buses L801 or L802 by wire.

As mentioned above, the panelboard 850 includes a dual-pole isolation device 866 for electrically isolating arcing faults in the appropriate branch circuit and for increasing the signal strength of the arcing fault signal in the appropriate branch circuit. The isolation device 866 is preferably mounted near the electrical supply source connection within the panelboard. It may be plugged in or bolted onto the neutral bus and the distribution buses L801 and L802, or it may be connected to the bus lines by wire. Preferably, the dual-pole isolation device 866 will include surge protection circuitry to protect either of the distribution buses L801 or L802 from voltage surges. Alternatively, two single-pole isolation devices may be provided, each being connected to the neutral bus N and one of the distribution buses L801 or L802.

Alternatively, the electrical distribution system may include branch isolation modules (not shown) in one or more of the individual branch circuits to accomplish the same function as the dual-pole isolation module 866 shown in FIG. 40. However, if branch isolation modules are used, the line interrupters 856 and 858 shown in FIG. 40 must not comprise arcing fault detectors because isolation modules must be positioned on the power source side of an arcing fault detector in any given branch circuit. Accordingly, if branch isolation modules are used, arcing fault detection must be provided either by separate arcing fault detector modules (not shown) positioned on a load side of the branch isolation modules, or by combined arcing fault detector and isolation modules (not shown) in which the arcing fault detector portion is positioned on the load side of the isolation portion.

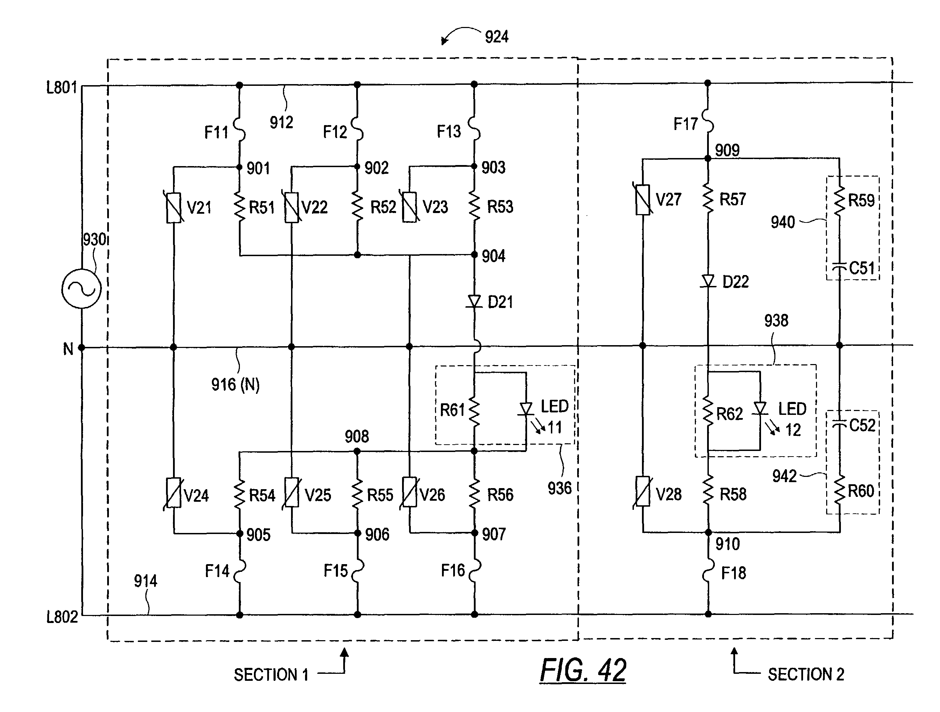

As shown in FIG. 42, a dual-pole isolation device 924 is connected to supply source 930 via line buses L801 and L802 and neutral bus N. The isolation device 924 includes both surge protection circuitry (section 1) and isolation circuitry (section 2). However, it will be appreciated that device 924 may contain only isolation circuitry.

Referring initially to the surge protection circuitry (section 1) and, more specifically, to the portion of section 1 located between the line bus L801 and neutral bus N, there is provided a plurality of fuses F11, F12, F13 connected between the line bus L801 and nodes 901, 902, and 903 respectively. Varistors V21, V22, and V23 are connected between nodes 901, 902, and 903, respectively, and the neutral bus N. Preferably, the varistors are metal oxide varistors using zinc oxide. Resistors R51, R52, R53 are connected between nodes 901, 902, and 903, respectively, and node 904.

Fuses F11, F12, and F13 open if the respective varistors V21, V22, and V23 fail, that is if a destructive surge occurs. Resistors R51, R52, and R53 form a resistance ladder which develops a voltage across display resistor R61. Diode D21 provides a forward bias between node 904 and the first display 936.

Now referring to the remainder of the surge protection circuitry (section 1) located between the line bus L802 and the neutral bus N, there is provided a plurality of fuses F14, F15 and F16 connected between the line bus L802 and nodes 905, 906 and 907 respectively. Varistors V24, V25 and V26 are connected between nodes 905, 906 and 907, respectively, and the neutral bus N. Resistors R54, R55 and R56 are connected between node 905, 906 and 907 respectively and node 908. The fuses F14, F15 and F16 are designed to open if the respective varistors V24, V25 and V26 fail.

Display 936 comprises a resistor R61 connected in parallel with a light emitting diode LED11 visible through an opening in a top wall of isolation module 866. LED11 provides for monitoring the status condition of varistor and fuse pairs such as V21 and F11. The intensity of LED11 decreases when a fuse is blown. When only a predetermined number of varistor and fuse pairs remain operational, LED11 will extinguish entirely to signal for replacement of the surge protection circuitry.

Specifically, the light output of LED11 varies with the operating condition of each varistor and fuse pair. Display 936 uses the first plurality of resistors R51, R52 and R53, the second plurality of resistors R54, R55 and R56, diode D21, resistor R61 and LED11 to indicate when the circuit is operating correctly. The resistance ladder of the first set of resistors R51-R53 monitors the fuses F11, F12 and F13 on line bus L801 and the second set of resistors R54-R56 monitors the fuses F14, F15 and F16 and the line bus L802. Line buses L801 and L802 each develop a voltage across resistor R61 that is proportional to the number of conducting fuses F11, F12, F13, F14, F15, F16. Only when a preselected number of these fuses are intact will sufficient voltage be available to forward bias LED11 to emit a signal to indicate that the surge protection circuitry is operational.

The above-described surge arrestor circuit is designed to limit the voltage between line bus L801 and neutral bus N upon the occurrence of a voltage surge. The operation of the surge arrestor circuit is described in detail in U.S. Patent No. 5,412,526, hereby incorporated by reference.

Referring next to the isolation circuitry (section 2) of FIG. 42 and, more specifically, to the portion of section 2 located between the line bus L801 and neutral bus N, there is provided a fuse F17 connected between the line bus L801 and a node 909. A filter 940 consisting of a capacitor C51 in series with a resistor R59, is connected between the node 909 and the neutral bus N. Filter 940 is designed to effectively short high-frequency arcing fault signals from line bus L801 to neutral bus N, thus preventing arcing fault signals on line bus L801 from crossing over to line bus L802. In completing the arcing fault signal path from line bus L801 to neutral bus N, the filter 940 accomplishes two functions. First, it prevents an arcing fault detector (not shown) on line bus L802 from detecting a "false" arcing fault signal on line bus L802. Second, it increases the signal strength at an arcing fault detector (not shown) positioned on line bus L801 on a load side of filter 940. Varistor V27 is connected between the node 909 and the neutral bus N. Varistor V27 provides a degree of surge protection for the isolation circuitry connected between the line bus L801 and the neutral bus N. A resistor R57 and a diode D22 are connected in series between the node 909 and a display 938.

Referring now to the remainder of the isolation circuitry (section 2) located between line bus L802 and neutral bus N, there is provided a fuse F18 connected between the line bus L802 and a node 910. A filter 942 consisting of a capacitor C52 in series with a resistor R60 is connected between node 910 and the neutral bus N. Filter 942 is designed to complete the arcing fault signal path from line bus L802 to neutral bus N by effectively shorting high frequency arcing fault signals from the line bus L802 to neutral bus N. Thus, similar to the filter 940 described above, the filter 942 prevents an arcing fault detector (not shown) on line bus L801 from detecting a "false" arcing fault signal on line bus L801, and increases the signal strength at an arcing fault detector (not shown) positioned on line bus L802 on a load side of filter 942. A varistor V28 provides a degree of surge protection for the isolator circuitry connected between line bus L802 and neutral bus N. Resistor R58 is connected between node 910 and display 938.

Display 938 consists of a resistor R62 connected in parallel with an LED12. Display 938 provides a means for monitoring the operating status of the isolation circuitry. Should fuse F14 or F18 blow for any reason, causing a loss of isolator functionality, the LED12 will turn off. LED12 is visible through an opening in the top wall of the isolation device 866.

It will be appreciated that the design and operation of the two-pole isolation device heretofore described may be similarly applied to single-pole isolation devices or multi-pole isolation devices. The circuit for a single-pole isolation device will be substantially similar to the above-described two-pole isolation device, the difference being that it will contain only the circuitry of sections 1 and 2 located between the line bus L801 and neutral bus N.

Thus, an electrical isolation device is provided where faults are isolated to the electrical branch of the electrical distribution network where they occur. The isolation device can be a single-pole, dual-pole or multiple-pole device and is adaptable for use on the power source side of an arcing fault detector. The device can be constructed such that it is adaptable for use in a variety of areas of an electrical panelboard. The isolation device also contains circuitry which suppresses voltage surges occurring in the electrical distribution network.

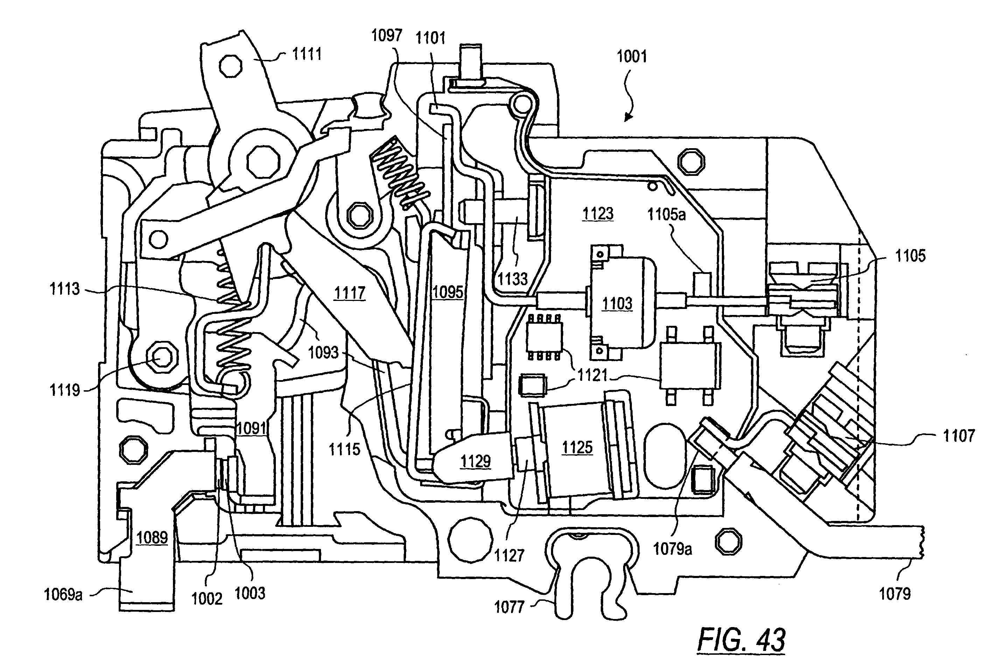

FIG. 43 illustrates a plan view of a circuit breaker 1001 including standard circuit breaker components and arcing fault detection components disposed within the miniature circuit breaker housing shown in FIG. 42. As depicted in FIG. 43, the miniature circuit breaker 1001 is in a closed position, enabling line current to flow completely through the circuit breaker and toward the load of a designated branch circuit. Line current enters the circuit breaker 1001 through the jaw-like terminal 1069a and flows through a stationary contact carrier 1089 integral with the jaw like terminal 1069a. The stationary contact carrier 1089 has a stationary contact 1002 mounted thereon. A movable contact 1003 mounted to a movable contact carrier 1091 abuts against the stationary contact 1002 when the circuit breaker 1001 is in the closed position. Line current thereby flows from the stationary contact carrier 1089 to the movable contact carrier 1091 through the stationary and movable contacts 1002 and 1003, respectively.

A pigtail conductor 1093 is electrically connected at one end to the movable contact carrier 1091 and at another end to a yoke 1095, enabling line current to flow from the movable contact carrier 1091 to the yoke 1095 when contacts 1002 and 1003 are in a closed position. A bimetal conductor 1097 composed of two dissimilar thermostat materials is electrically connected to the yoke 1095. The bimetal conductor 1097 is electrically connected to an internal line conductor 1101 which is connected to a load terminal 1105. When contacts 1002 and 1003 are in the closed position, line current flows from the yoke 1095 through the bimetal conductor 1097 and through the internal line conductor 1101. Thereafter, current flowing through the internal line conductor 1101 passes through a sensing coil 1103 which monitors the rate of change of line current flowing through the circuit breaker 1001. The present invention in one aspect is related to methods for assembling certain components associated with sensing coil 1103.

After exiting the sensing coil 1103, the line current flows to a load terminal 1105 to which the load line conductor may be attached to provide the line current to a load. The line current is electrically connected to circuit board 1123 at connection 1105a. The present invention in one aspect is related to methods and apparatus for connecting the load line conductor to the load line terminal 1105. The miniature circuit breaker 1001 also includes a load neutral terminal 1107 to which the load neutral conductor may be attached. The miniature circuit breaker further includes an internal neutral conductor electrically connected to the neutral terminal 1107 and the panel neutral conductor described in relation to FIG. 20. The internal neutral conductor is electrically connected to the circuit board 1123 at connection 1079a. The present invention in one aspect is related to methods and apparatus for connecting the internal neutral conductor, panel neutral conductor and load neutral conductor to the load neutral terminal 1107. In embodiments with ground fault interruption (GFI) circuitry (not shown), the load neutral conductor would be routed through the sensor 1103 along with the internal line conductor 1101 to permit sensing of an imbalance of current flow between the internal line and neutral conductors 1101 and 1079 as is known in the art. A more complete description of GFI circuitry is disclosed in U.S. Patent No. 5,446,431, assigned to the instant assignee and incorporated herein by reference.

The circuit breaker 1001 may be tripped open in any of several ways, including manual control and in response to thermally and electromagnetically-sensed overload conditions and ground fault conditions. The mechanism for tripping open the circuit breaker 1001 is described in detail in U.S. Patent No. 5,446,431, assigned to the assignee of the present invention and incorporated herein by reference. Accordingly, it will be described only briefly herein.

The miniature circuit breaker 1001 may be moved between the open and closed positions by a user manually moving the operating handle 1111 to the right or left, respectively, causing corresponding movement of the top of the movable contact carrier 1091 to the left or right of a pivot point. A toggle spring 1113 is connected at one end to the operating handle 1111 and at another end to the movable contact carrier 1091. When the top of the movable contact carrier 1091 is left of the handle pivot point, the toggle spring 1113 serves to bias the bottom of the movable contact carrier 1091 to the open position. Conversely, when the top of the movable contact carrier 1091 is right of the pivot point, the toggle spring 1113 biases the bottom of the movable contact carrier 1091 to the closed position.

The miniature circuit breaker 1001 is also designed to be tripped open in response to sensing various types of fault conditions. Upon the occurrence of a moderately sustained overload condition when the contacts 1002 and 1003 are in a closed position, the bimetal conductor 1097 becomes heated and the lower end bends to the right. The bimetal conductor 1097 may be adjusted by calibration screw 1133. Bending of the bimetal conductor 1097 by differential expansion causes an armature 1115 and yoke 1095 to swing counterclockwise and release a trip lever 1117. The trip lever 1117 rotates clockwise about pin 1119, causing the toggle spring 1113 to pull the bottom of the movable contact carrier 1091 away from the stationary contact 1002 and interrupt the current path.

Similarly, upon the occurrence of an extensive current overload condition, a high magnetic flux field is created around the yoke 1095. The armature 1115 is drawn toward the yoke 1095 by the magnetic field, causing the trip lever 1117 to become released from the armature 1115. As described in relation to thermal trips, release of the trip lever 1117 from the armature 1115 causes the toggle spring 1113 to pull the bottom of the movable contact carrier 1091 away from the stationary contact 1002 and interrupt the current path.

Finally, electronic components 1121 mounted on a circuit board 1123 are provided for processing the signal output of the sensor 1103 and determining whether an arcing fault condition or ground fault condition are present. The electronic components 1121 are preferably the same as those described in pending United States patent application Serial No. 08/600,512, but it will be appreciated that any configuration of electronic components known in the art for detecting arcing faults may be provided. Similarly, the electronic components 1121 may reflect any configuration known in the art for sensing ground faults. At any rate, the electronic components 1121 are designed to produce an "AFD" and/or "GFI" trip signal corresponding to whether the circuit breaker is designed to sense arcing faults and/or ground faults. In response to generation of either an AFD or a GFI trip signal, a magnetic field is created around a trip solenoid 1125, causing a plunger 1127 to be drawn to the right. The plunger 1127 is connected to a trip link 1129, which in turn is connected to the armature 1115, such that movement of the plunger 1127 causes the armature 1115 to be drawn to the right. As previously described, movement of the armature 1115 to the right causes the trip lever 1117 to be released and the current path through the circuit breaker 1001 to be interrupted.

In an alternative embodiment of the present invention, the electronic components 1121 may also be designed to generate a thermal/magnetic trip signal in response to overloads or short circuits, thus obviating the need for the bimetal, yoke and armature associated with the prior art. This capability is described in detail in U.S. Patent No. 5,136,457, assigned to the assignee of the present invention and incorporated herein by reference. In this embodiment, the thermal/magnetic trip signal will cause the contacts of the circuit breaker 1001 to be opened in substantially the same manner as they would in response to an AFD or a GFI trip signal.

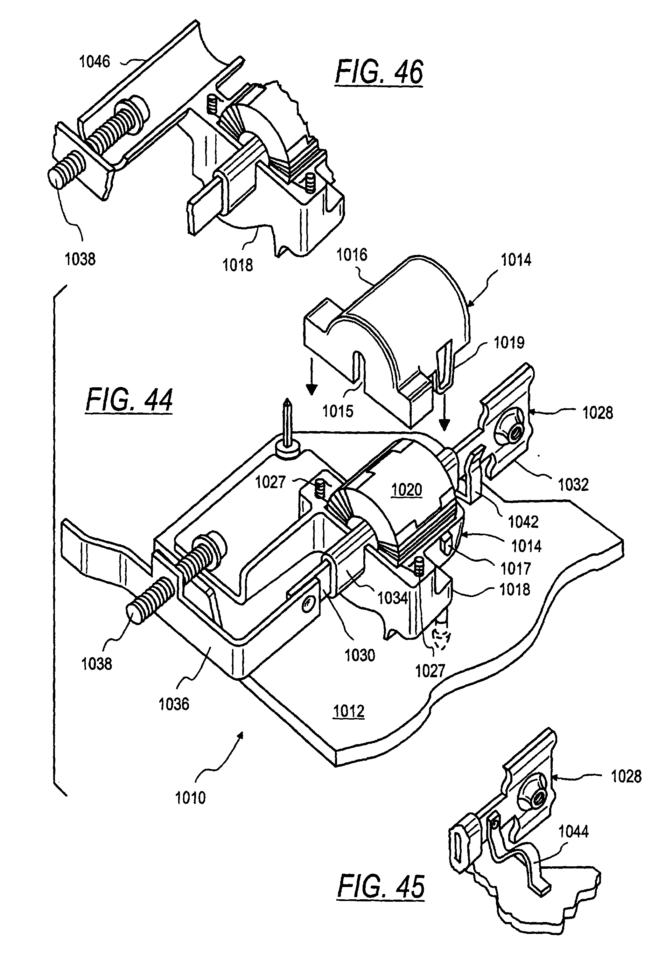

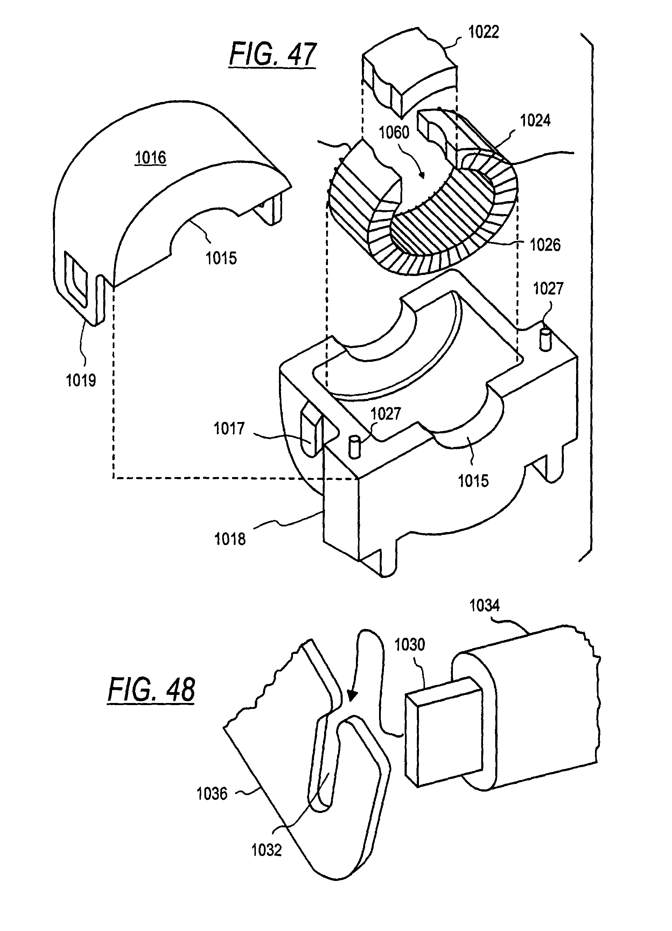

FIGS. 44 and 47 show an assembly 1010 which includes a printed circuit board 1012 (FIG. 44 only) and a housing 1014. The housing 1014 has a removable upper section 1016 and a lower section 1018 which is connected to the circuit board 1012. The sensing coil 1020 comprises an upper core section 1022 and a lower core section 1024 (see FIG. 47). A winding 1026 surrounds the lower core section 1022, as best illustrated in FIG. 47. Each end of winding 1026 is connected to a respective one of the electrically conductive pins 1027 which continue through the housing 1014 and thus are electrically attached to the circuit board 1012. The upper core section 1022 interlocks with the lower core section 1024 to form a horizontally oriented hollow center 1060 through which the line conductor (or both line and neutral conductors) of the circuit breaker are designed to pass. The upper section 1016 of the housing 1014 has a pair of catches 1019 for snapping onto a respective pair of ramps 1017 on the lower section 1018. Thus, the upper and lower sections substantially enclose the sensing coil 1020. It is feasible to omit upper section 1016 if desired, in which case the outer cover serves as the upper housing. The housing 1014 has a pair of openings 1015 through which load line terminal 1028 extends. These openings may have different configurations (*e.g.* compare Figs. 44 and 47 depending on the shape of the load line terminal).

Returning to FIG. 44, load line terminal 1028 has a long end 1030 and a short end 1032. The long end 1030 is partially surrounded with insulator 1034 where it passes through the hollow center of sensing coil 1020. The long end 1030 is disposed in sensing coil 1020 so that the insulator 1034 extends beyond the sensing coil 1020 and through the opening 1015. Line current passes through load terminal 1036 which is connected to the long end 1030 of load line terminal 1028. Preferably, load terminal 1036 is connected to long end 1030 by a pinch weld as shown. Calibration screw 1038 is disposed in load terminal 1036 so that a portion of calibration screw 1038 extends past load terminal 1036.

Power is supplied to circuit board 1012 via a connection to the load line terminal 1028. In one embodiment, the connection is via clip 1042 for frictionally and electrically engaging the short end 1032 of load line terminal 1028. Alternatively, the connection 1042 can include a leaf spring 1044 that is pinch welded to the short end 1032 of load line terminal 1028, as shown in FIG. 45.

In a preferred embodiment illustrated in FIG. 46, lower section 1018 of housing 1014 can include an insulating channel 1046 for insulating the calibration screw 1038 and a screw driver inserted into the circuit breaker from the components on the circuit board 1012. The insulating channel 1046 is substantially U-shaped and configured to receive the calibration screw 1038 and to assist in the alignment of a screw driver with the head of calibration screw 1038. The insulating channel 1046 is connected to or is integral with the lower section 1018 of housing 1014.

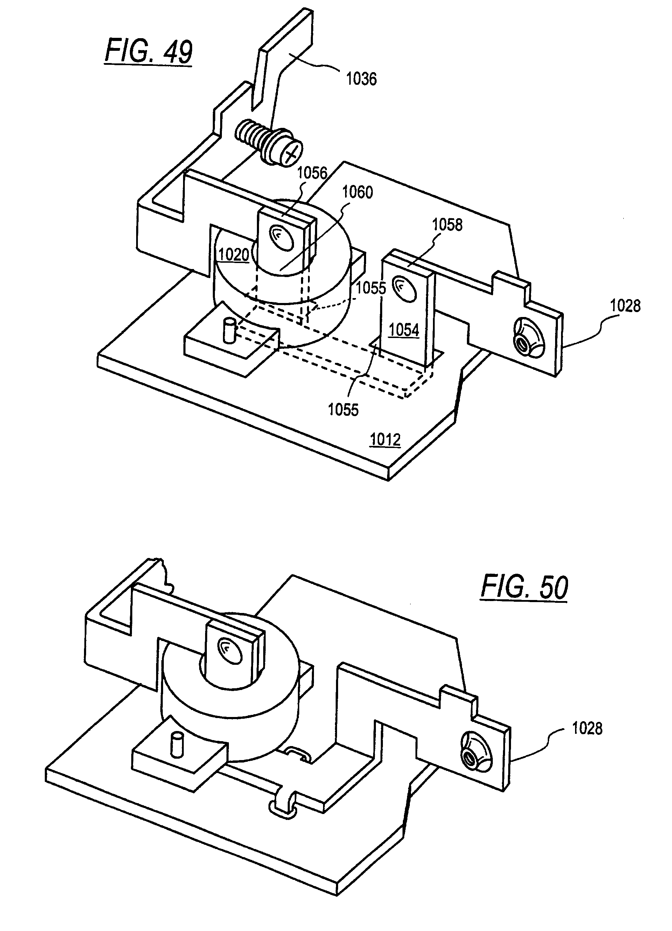

FIG. 48 illustrates an alternative connection between the load terminal 1036 and load line terminal 1028. In one embodiment, load terminal 1036 has a slot 1032 that is configured to receive the long end 1030 of the load line terminal 1028. In an alternative embodiment (not shown), the load line terminal 1028 has a similar slot that is configured to receive the end of load terminal 1036.

FIG. 49 illustrates an alternative embodiment in which the hollow center 1060 of sensor 1020 is oriented vertically rather than horizontally. Thus, the terminals pass vertically rather than horizontally through the coil as in the embodiment discussed above. Here, a sensor bus 1054, which has a first end portion 1056 and a second end portion 1058, is connected to circuit board 1012 through slots 1055. The sensing coil 1020 is disposed around the first end portion 1056. Load terminal 1036 is connected to the first end portion 1056. Load line terminal 1028 is connected to the second end portion 1058. Preferably, both connections are made by pinch welding as shown. FIG. 50 illustrates an alternative embodiment wherein the load line terminal 1028 and the sensor bus 1054 are made from a single piece of metal.

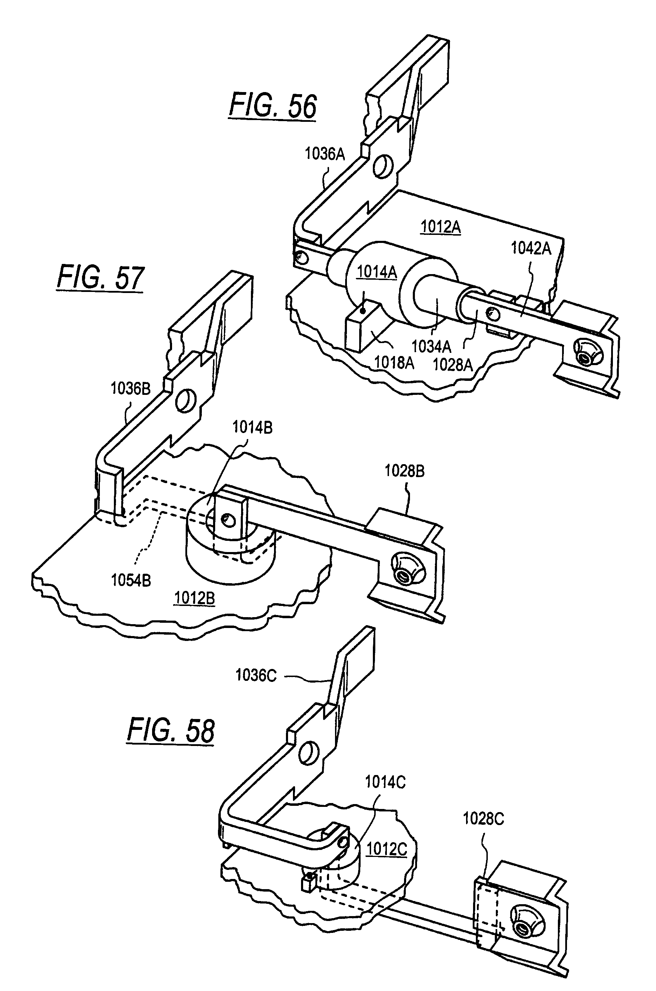

FIGs. 56-58 illustrate additional constructions to those shown in FIGs. 46 and 49-50 respectively. FIG. 56 shows a one-piece sensing coil 1014A with the hollow center oriented horizontally. The load line terminal 1028A is preassembled with the sensing coil 1014A and placed on the circuit board, 1012A and then pinch welded to the load terminal 1036A and the circuit board connector 1042A. A screw terminal may be used to connect the power supply as shown.

FIGs. 57 and 58 show a one-piece sensing coil (1014B and 1014C) with the hollow center oriented vertically. In those constructions, power is supplied through connections either under the circuit board (1012B FIG. 57) or above the circuit board (1012C FIG. 58). The connections to the load terminal (1036B and 1036C) are made by pinch welding above the sensing coil (1014B and 1014C), again facilitating top-down assembly.

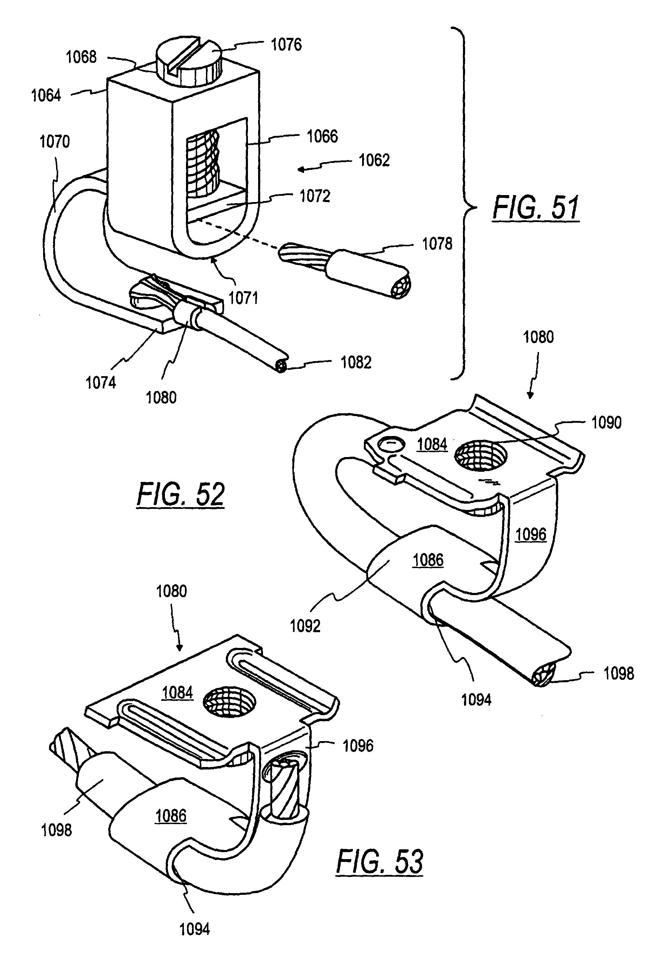

Flexible, but restrained, wire terminations are important features of the circuit breakers of the invention to facilitate their automated assembly. Alternative methods of providing such wire terminations are shown in FIGs.51-54.

A lug connection 1062 is illustrated in FIG. 51. The lug 1062 includes a top 1064 and a hollow center 1066. The top 1064 includes a hole 1068 connecting the top 1064 to the hollow center 1066. A neutral bus 1070 which is connected via wire 1082 to the panel neutral (not shown) is connected by lug 1062 to the load neutral via wire 1078. End 1072 of bus 1070 is positioned inside of the hollow center 1066 of the lug 1062 and extends underneath the hole 1068. A wire binding screw 1076 is disposed in the hole 1068 and extends through the hollow center 1066 in order to secure wire 1078 between end 1072 of the neutral bus 1070 and bottom 1071 of hollow center 1066. A strain relief member 1080 is provided at end 1074 of the neutral bus 1070.

Turning to FIG. 52, there is shown a strain relief member 1080 which includes a top section 1084 for connecting the load neutral wire (shown as 1078 in FIG. 51) and a bottom section 1086. The top section 1084 is substantially flat and includes a hole 1090 disposed therein. The load neutral wire is clamped between the flat section and a second mating plate (not shown) by means of a screw (not shown) threaded into hole 1090. Strain relief region 1092 defines a cavity 1094 for receiving the panel neutral wire. The bottom section 1086 forms a cylinder 1092 which defines a cavity 1094. The top section 1084 and the bottom section 1086 are connected together and separated by a solid member 1096. Connected to the top section 1084 of strain relief member 1080 is a wire 1098 (corresponding to wire 1082 of FIG. 51). The wire 1098 extends through the cavity 1094 formed by the bottom section 1086 and is secured therein in order to prevent strain on the connection of wire 1098 to top section 1084. In a preferred embodiment, the wire 1098 is pinch welded to top section 1084 as shown.

In an alternative embodiment illustrated in FIG. 53, wire 1098 is connected to the solid member 1096 of the strain relief member 1080. The wire 1098 extends through cavity 1094 in order to prevent strain on the connection of wire 1098 to solid member 1096. Preferably, the wire 1098 is pinch welded to solid member 1096. As described in FIG. 52 the load neutral wire 1078 (of FIG. 51) would be clamped to the upper section 1084.

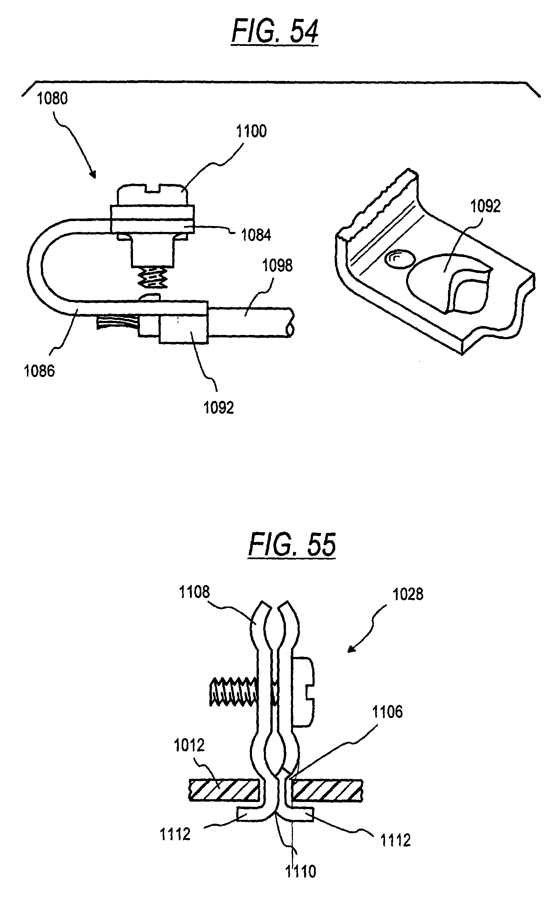

In another alternative embodiment illustrated in FIG. 54, the load neutral wire is shown connected to the top section 1084 by a screw 1100 as previously described in connection with FIGs. 52-53. The panel neutral wire 1098 is connected to the bottom section 1086 of the strain relief member 1080. Strain relief section 1092 prevents strain on the connection of wire 1098.

FIG. 55 illustrates an embodiment in which a slot 1106 is provided in the outer edge of the circuit board 1012 to receive a clip which secures load line terminal 1028 (see FIG. 45). The bottom sections of the clip 1108 and the clamp terminal 1028 are disposed in the slot 1106 of the circuit board 1012. Extending from the bottom of the clip and the clamp terminal are flanges 1110 which are configured to limit the load line terminal 1028 from moving in any direction except towards the center the circuit board 1012.

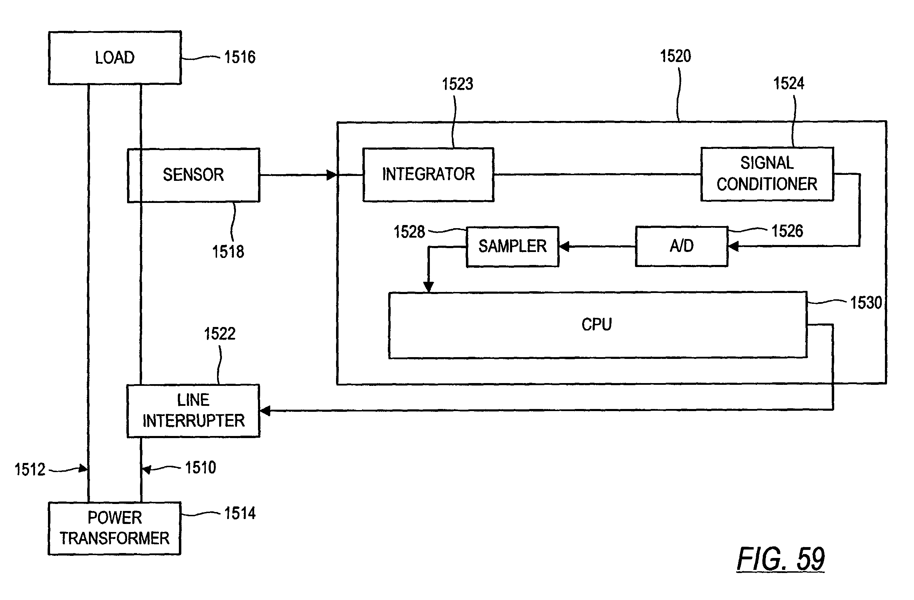

Turning now to the drawings and referring initially to FIG. 59, there is shown a schematic block diagram of an arcing fault detection system connected to a single branch circuit of an electrical distribution system. It will be appreciated, however, that the arcing fault detection system may be connected to multiple branch circuits. Each branch circuit is comprised of line conductor 1510 and neutral conductor 1512 which distribute electrical power from a utility company power transformer 1514 to a load 1516. The line conductor 1510 and neutral conductor 1512 are typically at 240 volts or 120 volts, and a frequency of 60 Hz. A sensor 1518 senses the rate of change of electrical current on the line conductor 1510 and sends a rate-of-change signal, commonly referred to as a di/dt signal, to an arc detector 1520. As will be described in detail hereinafter, the arc detector 1520 processes and evaluates the sensor signal for characteristics of arcing faults. If the arc detector 1520 senses the occurrence of an arcing fault, it produces a trip signal to line interrupter 1522, which interrupts the current in line conductor 1510.

The line interrupter 1522 is preferably a circuit breaker which includes an overload trip mechanism having a thermal/magnetic characteristic which trips the breaker contacts to an open circuit condition in response to a given overload condition, to disconnect the load 1516 from the power source, as is known in the art. It is also known to provide the circuit breaker 1522 with ground fault interrupter circuitry responding to a line or neutral-to-ground fault to energize a trip solenoid which trips the circuit breaker and opens the contacts.

The sensor 1518 preferably comprises a toroidal sensor having an annular core encompassing the current-carrying line conductor 1510, with the sensing coil wound helically on the core. The core is made of magnetic material such as a ferrite, iron, or molded permeable powder capable of responding to rapid changes in flux. A preferred sensor uses a ferrite core wound with 200 turns of 24-36 gauge copper wire to form the sensing coil. An air gap may be cut into the core to reduce the permeability to about 30. The core material preferably does not saturate during the relatively high currents produced by parallel arcs, so that arc detection is still possible at those high current levels.

Other means for sensing the rate of change of the current in a line conductor are contemplated by the present invention. By Faraday's Law, any coil produces a voltage proportional to the rate of change in magnetic flux passing through the coil. The current associated with an arcing fault generates a magnetic flux around the conductor, and the coil of the sensor 1518 intersects this flux to produce a signal. Other suitable sensors include a toroidal transformer with a core of magnetic material or an air core, an inductor or a transformer with a laminated core of magnetic material, and inductors mounted on printed circuit boards. Various configurations for the sensor core are contemplated by the present invention and include toroids which have air gaps in their bodies.

An integrator 1523 integrates the di/dt signal from the sensor 1518 to produce a signal representing the current (i) carried by the line conductor 1510. The integrated di/dt signal (or i signal) is thereafter processed by a signal conditioner 1524 and converted to a series of pulses by analog-to-digital (A/D) converter 1526. The current pulses are then sampled at a plurality of points by sampler 1528. The sampled current is then processed by CPU 1530, which determines the number of certain arcing fault characteristics occurring within a predetermined time interval. If the number of arcing fault characteristics exceed a trip threshold level within the predetermined time interval, the CPU 1530 produces a trip signal to trigger the line interrupter 1522.

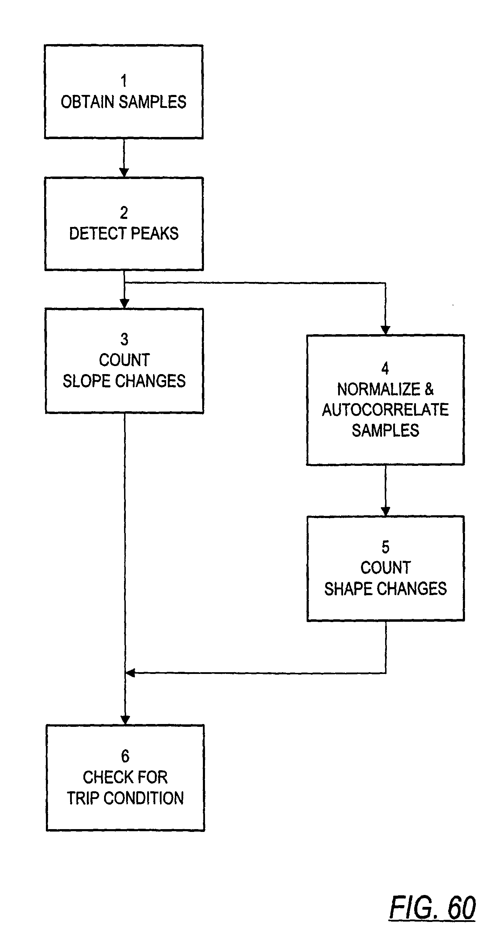

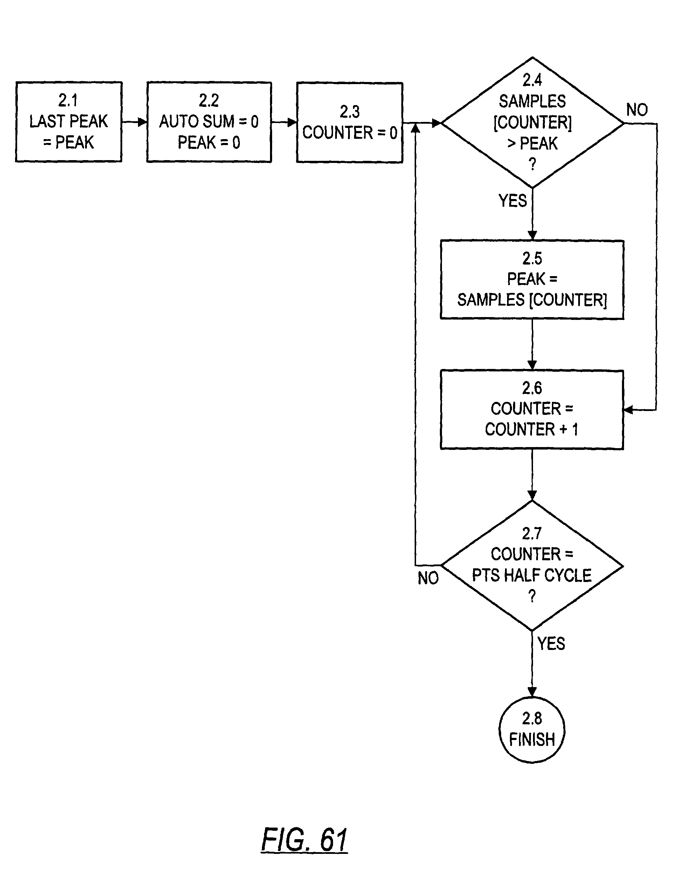

Turning now to FIG. 60, there is shown an overview flow chart of the steps accomplished by the arcing fault detection system according to one embodiment of the present invention. Each of these steps will be described in detail in relation to FIGs. 61 through 65. Generally, however, step 1 represents the obtaining of current samples from the sampler 1528. Preferably, samples will be taken from either two consecutive half-cycles (e.g. a positive half-cycle followed by a negative half-cycle, or vice versa), two consecutive positive half-cycles or two consecutive negative half cycles. Moreover, it is preferred that samples are taken at 32 points per half cycle of current, but it will be appreciated that an alternate number of sampling points may be used. Next, as represented by step 2, the CPU determines the magnitude of the current peak in each selected half cycle. Next, as represented by step 3, the "slope", or ratio of current peaks from one half cycle to the next is assigned a polarity (e.g. "positive" or "negative"), and the number of reversals of polarity between adjacent slopes is counted.

Finally, in step 6, the number of reversals in polarity is compared to a trip threshold level. If the number of reversals in polarity exceed the trip threshold level, a trip signal is sent to the line interrupter 1522 to disconnect the power source from the load. If the number of reversals in polarity do not exceed the trip threshold level and thereby do not represent an arcing fault, the above-described process repeats itself with newly obtained current samples until an arcing fault is detected. Preferably, the trip threshold level will be high enough so that reversals in polarity caused by known load transients do not trip the circuit breaker. In a preferred embodiment of the present invention, the trip threshold level is based on finding fifteen or more reversals in polarity per second.

In another embodiment, the CPU 1530 detects arcing faults by counting the number of significant waveform shape changes between half cycles in addition to counting the number of reversals in polarity. This is accomplished by performing step 3 heretofore described along with additional steps 4 and 5. In step 4, the CPU 1530 normalizes and autocorrelates the current samples. Normalizing is accomplished by dividing each of the current samples by the peak current associated with the half cycle from which they were taken. Each of the current samples will thereby have a normalized magnitude less than or equal to 1. Autocorrelation is accomplished by comparing each one of the number of normalized current samples from one half cycle to the corresponding one of the number of normalized current samples in the next selected half cycle. As will be described in more detail hereinafter, the autocorrelation step is designed to obtain a measure of significant waveform shape changes between selected half cycles. In steps 5 and 6, the CPU counts the number of significant shape changes occurring within a predetermined time interval and sends a trip signal to the line interrupter 1522 if the number of significant shape changes exceed a trip threshold level.

Similar to the trip threshold level associated with slope changes described above, the trip threshold level associated with shape changes will preferably be high enough so that significant shape changes caused by known load transients do not trip the circuit breaker. In a preferred embodiment of the present invention, the trip threshold level associated with shape changes is based on finding three significant shape changes per second. Thus, in a preferred embodiment of the present invention, the line interrupter may be triggered by fifteen or more reversals in polarity per second or three or more significant shape changes per second. It will be appreciated, however, that other trip thresholds and/or time intervals may be selected without departing from the scope of the present invention.

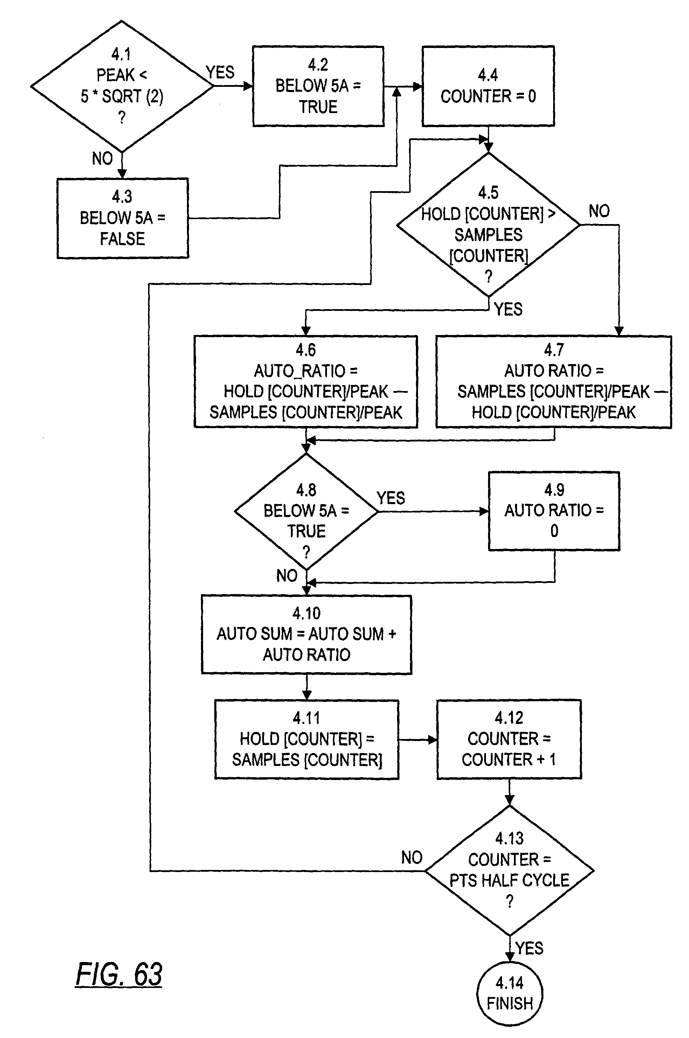

FIGs. 61 through 65 are flow charts representing the steps associated with the flowchart of FIG. 60 in greater detail. Referring initially to FIG. 61, there is shown a flow chart illustrating the peak detection subroutine associated with step 2 of the flowchart of FIG. 60. In step 2.1, the peak current of the most recent half cycle is stored in memory as variable "last peak". In step 2.2, an "auto sum" and a "peak" variable associated with the present half cycle are initialized to zero. The "auto sum" variable will be described hereinafter in relation to FIGs. 63 through 65. The "peak"variable represents the value of the current sample having the largest absolute magnitude in the present half cycle. An integer counter number is initialized to zero in step 2.3. In step 2.4, a current sample associated with the present counter number is compared to the value of the "peak" variable associated with the next most recent counter number in the present cycle. For example, in the 5th iteration of step 2.4, current sample 5 is compared to the "peak" variable obtained through current samples 1-4 of the present cycle. If the current sample associated with the counter number is greater than any of the previous current samples in the present cycle, the "peak" variable is reset to match the absolute magnitude of the current sample (step 2.5). The counter number is thereafter incremented by one (step 2.6) and, if the counter number is less than the number of points per half cycle (step 2.7), the process returns to step 2.4 with the next current sample. In step 2.4, if the current sample associated with the counter number is not greater than the previous "peak" variable, the process proceeds to step 2.6 and continues as heretofore described. In bypassing step 2.5, the "peak" variable is not reset but rather retains whatever value it had prior to the present current sample. Finally, in step 2.7, if the counter number equals the number of points in the half cycle, the process is complete. The value of the "peak" variable upon completion of the process thereby represents the absolute value of the peak current sample in its associated half cycle.

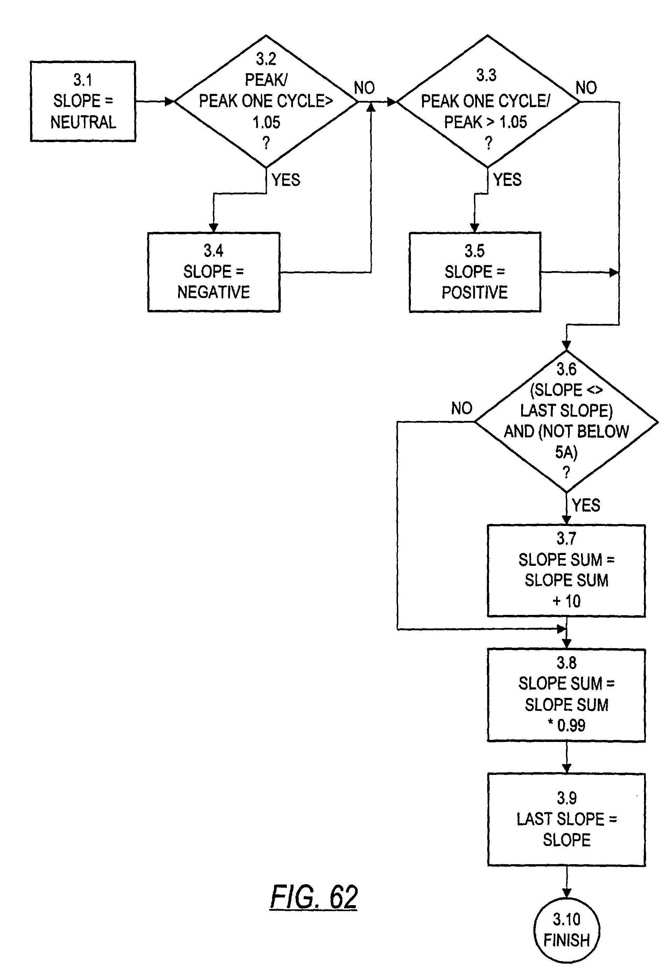

Turning now to FIG. 62, there is shown a flow chart illustrating the count slope changes subroutine associated with step 3 of the flowchart of FIG. 60. In step 3.1, a "slope" variable is initialized to neutral. The "slope" variable represents the slope of a line drawn from the current peak in a first selected half cycle (designated as variable "peak") to the current peak in a second selected half cycle (designated as variable "peak one cycle"). Preferably, the "peak" and "peak one cycle" variables represent the current peaks of consecutive positive (or negative) half cycles.

In steps 3.2 and 3.3, the current peaks in the selected half cycles are compared to each other to determine if they represent a significant slope change, defined here as being greater than 5%. More specifically, the ratio of "peak" to "peak one cycle" is evaluated in step 3.2, and the ratio of "peak one cycle" to "peak" is evaluated in step 3.3. If the ratio derived in step 3.2 is greater than 1.05, the slope variable is designated as negative (step 3.4). If the ratio derived in step 3.3 is greater than 1.05, the slope variable is designated as positive (step 3.5). If neither ratio is greater than 1.05, the slope remains designated as neutral.

In step 3.6, the slope direction associated with the selected pair of half cycles is compared to the slope direction of the next most recent pair of half cycles. A change in slope occurs when the slope directions change in polarity (e.g. from "positive" to "negative", or vice versa) and neither of the peaks is less than five amps. Current peaks of less than five amps are ignored because they do not represent a significant electrical hazard. If it is determined in step 3.6 that a change in slope has occurred, the slope change is counted in step 3.7 by incrementing a "slope sum" variable by an arbitrary number, here 10. In step 3.8, the "slope sum" variable is multiplied by 0.99 to decay the cumulative value of the "slope sum" variable by one percent at each sampling point of the waveform.

FIG. 63 is a flow chart illustrating the normalization and autocorrelation subroutines associated with step 4 in the flowchart of FIG. 60. Normalizing the current values before autocorrelating them enables the present invention to avoid a problem associated with the prior art, namely "false tripping" or erroneously indicating an arcing fault in response to load transients caused by, for example, the starting of an electrical motor. Because load transients cause changes in magnitude of the current between cycles, arc detection systems which indicate or at least conditionally indicate an arcing fault in responses to changes in magnitude in current are likely to false trip in response to the load transients. By normalizing the current values in every half cycle to a peak of "1", the arcing fault detection system according to the present invention is insensitive to increases in magnitude in current caused by load transients, and thereby is not likely to false trip in response to load transients.

In step 4.1, it is determined whether or not the "peak" variable has an rms value of less than 5 amps. If it is less than 5 amps, a boolean "Below 5A" variable is designated as True (step 4.2). If it is not less than 5 amps, the "Below 5A" variable is designated as False (step 4.3). An integer counter number is initialized to zero in step 4.4.

In step 4.5, the sampled current from a selected half cycle associated with the counter number (designated "samples[counter]") is compared to the sampled current from a previous half cycle associated with the same counter number (designated "hold[counter]"). For example, in the tenth iteration, sample "10" from the present half cycle is compared to the stored current sample "10" from the previous half cycle. Thereafter, in step 4.6 or 4.7, the current samples associated with the counter number in both the present cycle and previous cycle are normalized by dividing them by the peak current associated with the previous cycle, then subtracted from each other to obtain the difference between the normalized current from the present cycle to the previous half cycle. The smaller of the two normalized values is subtracted from the larger of the two normalized values so that the difference comprises a positive number representing the absolute value between the two normalized values. This result is designated by the variable "auto ratio".

In step 4.8, if the "Below 5A" variable is true, the "auto ratio" variable associated with the counter number is set to zero in step 4.9. In step 4.10, an "auto sum" variable, representing the cumulative sum of the ratios of corresponding current samples in selected half cycles, is incremented by the value of the "auto ratio" variable heretofore described. The "hold[counter]" variable associated with the counter number is then reset to the value of the "samples[counter]" variable associated with the counter number (step 4.11), and the counter number is incremented by one (step 4.12). If the counter number is less than the number of points per half cycle (step 4.13), the process returns to step 4.5 with the next current sample. The process is complete when the counter number equals the number of points in the half cycle. The value of the "auto sum" variable upon completion of the process thereby represents a measure of shape changes between selected half cycles.

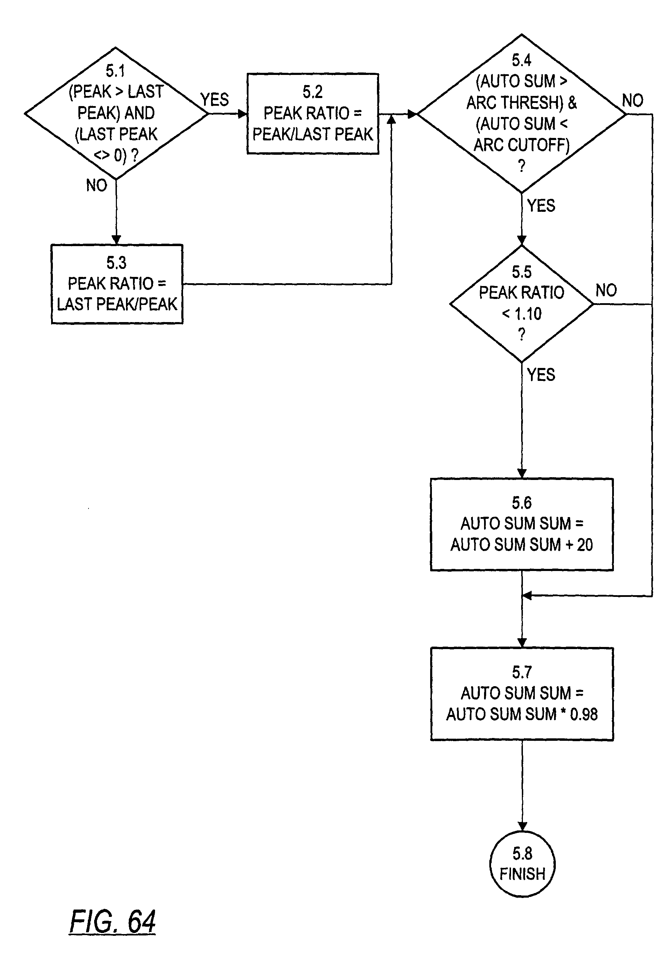

FIG. 64 is a flow chart illustrating the counting shape changes subroutine associated with step 5 in the flowchart of FIG. 60. In step 5.1, it is determined whether the "peak" variable is greater than the "last peak" variable and the "last peak" variable is not equal to zero. Thereafter, in step 5.2 or 5.3, the ratio of the present peak to the last peak (designated by variable "peak ratio") is computed. Next, in step 5.4, it is determined whether the "auto sum" variable described in relation to FIG. 63 is greater than an arc threshold value and less than an arc cutoff value. The arc threshold value, as previously described, is preferably based on detecting 16 significant waveform shape changes per second. The arc cutoff value is based on detecting an excessively large number of significant shape changes, which indicate load fluctuations rather than arcs. In step 5.5, it is determined whether the peak ratio is less than 1.10. If the answer in both steps 5.4 and 5.5 is determined to be yes, a significant shape change has occurred and an "auto sum sum" variable is incremented by an arbitrary number (here 20) in step 5.6. In step 5.7, the "auto sum sum" variable is multiplied by 0.98 to decay the cumulative value of the "auto sum sum" variable by two percent at each sampling point of the waveform.

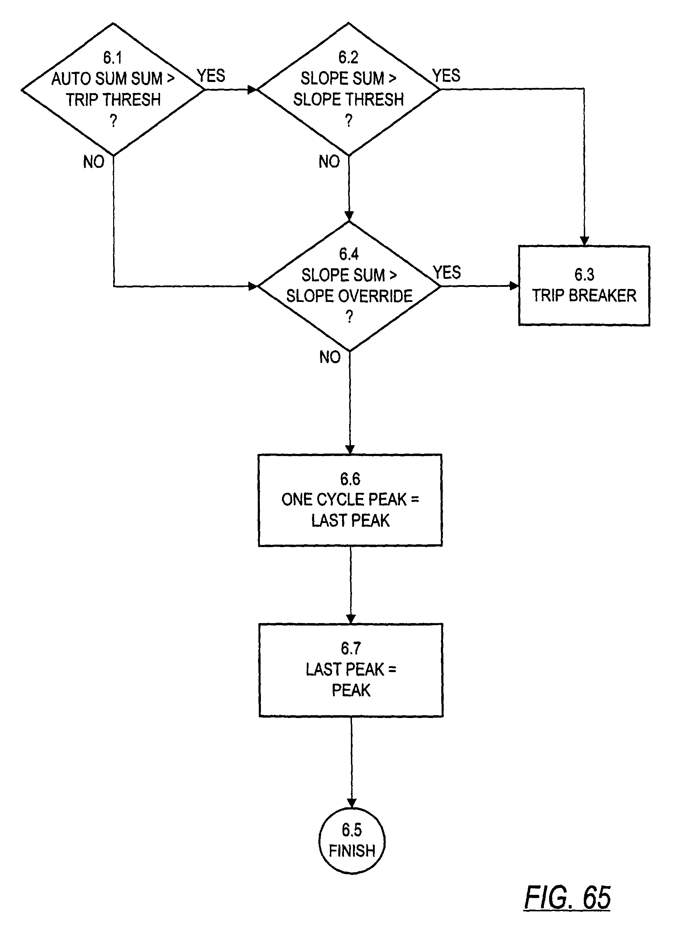

Now turning to FIG. 65, there is shown a flow chart illustrating the check for trip condition subroutine associated with step 6 in the flowchart of FIG. 60. If the number of significant shape changes represented by the "auto sum sum" variable is greater than a trip threshold level (step 6.1) and the number of slope changes represented by the "slope sum" variable is greater than a slope threshold level (step 6.2), a trip signal is generated to trip the circuit breaker (step 6.3). The circuit breaker is also tripped if the slope sum sum is greater than a slope override level (step 6.4). If neither of the trip conditions occur, the peak current of the most recent half cycles are stored in memory in steps 6.6 and 6.7, and the entire process of detecting arcing faults continues with subsequent half cycles.

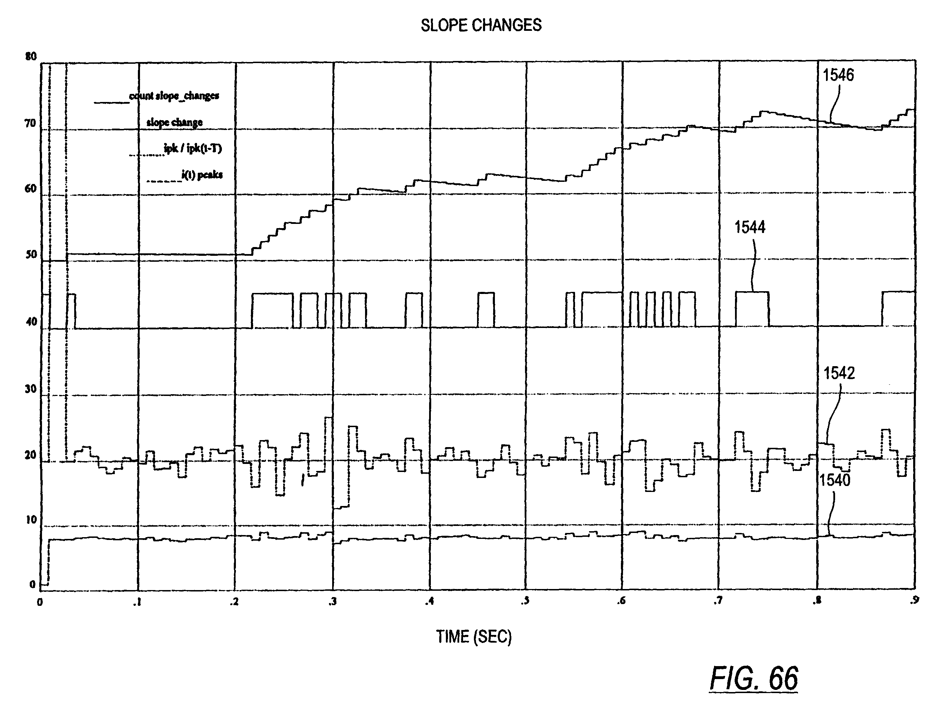

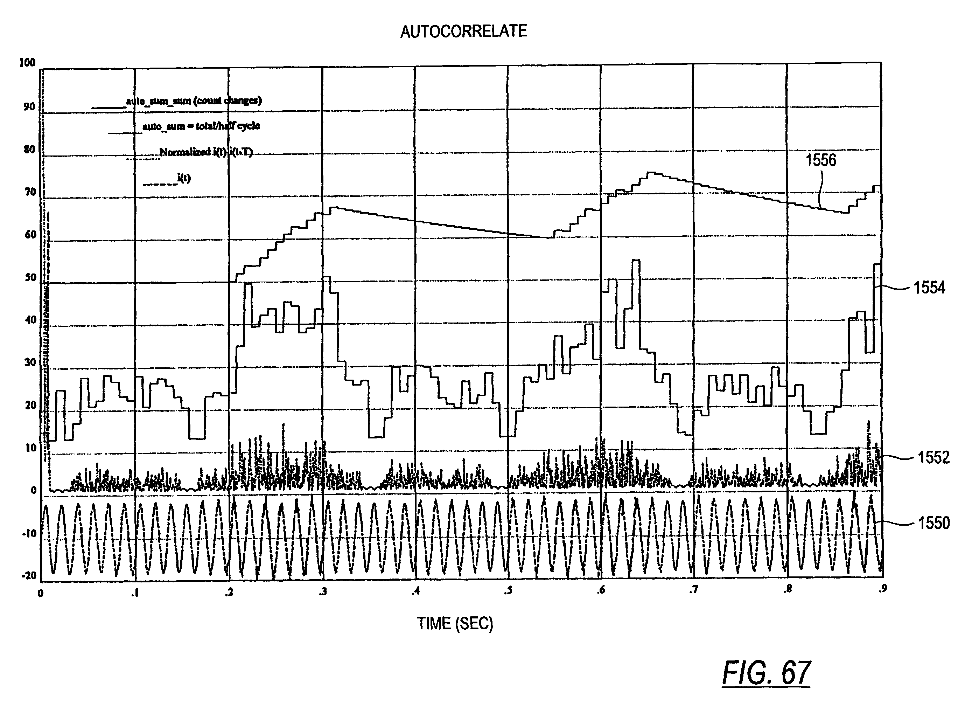

The subroutines described in relation to FIG. 61 through FIG. 65 may perhaps best be understood by reference to the series of waveforms shown in FIG. 66 and 67. FIG. 66 depicts the waveforms associated with the detection of slope changes and FIG. 67 depicts the waveforms associated with the detection of shape changes. Turning initially to FIG. 66, waveform 1540 represents the "peak" variable discussed in relation to FIG. 61. The "peak"variable represents the value of the current sample having the largest absolute magnitude in its associated half cycle. Thus, waveform 1540 is comprised of one discrete value per cycle, or 12 discrete values per every tenth of a second. As shown in FIG. 66, the "peak" waveform 1540 has a minimum value of zero amps (corresponding reference position "0" in FIG. 66) and a maximum value of about ten amps (corresponding to reference position "10" in FIG. 66).

Waveform 1542 represents the slope of the current peaks from one half cycle to the previous half cycle. As heretofore defined, the slope is computed by taking the ratio of the current peak in one half cycle to the current peak of the previous half cycle. The ratios falling above the line represent "positive" slopes and the ratios falling below the line represent "negative" slopes. The waveform 1542 is centered on zero percent (corresponding to reference position "20" in FIG. 66) and fluctuates between a minimum value of about minus two percent (corresponding to reference position "10") and a maximum value of about plus two percent (corresponding to reference position "30").

Waveform 1544 comprises a series of pulses indicating whether the slopes of waveform 1542 have changed in polarity (e.g. from "positive" to "negative" or vice versa) from cycle to cycle. As described in relation to FIG. 62, slope changes are indicated only if the peak currents between cycles differ by at least 5% and if the peak current is not less than 5 amps rms. As shown in FIG. 66, the waveform 1544 comprises a series of binary zeros (corresponding to reference position "40") indicating that a slope change has not occurred and binary "ones" (corresponding to reference position "45") indicating that a slope change has occurred.

Waveform 1546 represents the "slope sum" variable described in relation to FIG. 62, comprising a count of significant slope changes from cycle to cycle. As shown in FIG. 66, the "slope sum" waveform 1546 has a minimum value of zero (corresponding to reference position "50") and a maximum value of about thirty (corresponding to reference position "80"). A first trip criteria for the arcing fault detection system is triggered when the "slope sum" variable 1546 equals or exceeds fifteen significant slope changes per second (corresponding to y-axis reference "65").

Now turning to FIG. 67, waveform 1550 represents the current i(t) on the line conductor, comprising an ac waveform at a frequency of 60 Hz throughout a time interval of 0.9 seconds. Each cycle has a period of 1/60th of a second, or 16.67 milliseconds. Accordingly, there are 6 full cycles (or 12 half cycles) every tenth of a second. The i(t) waveform is centered on zero amps (corresponding to y-axis reference "-10") and cycles between a minimum value of about minus 10 amps (corresponding to reference position "-20") and a maximum value of about plus 10 amps (corresponding to reference position "0").

Waveform 1552 represents the value of the "auto ratio" variable discussed in relation to FIG. 63. The "auto ratio" variable represents the differences between the normalized current from the sample position in one half cycle to that of the corresponding sample position in the previous half cycle, expressed as a percentage. The "auto ratio" waveform 1552 thereby represents a plurality of individual "auto ratio" variables, 32 per half cycle, corresponding to the number of samples taken of the i(t) waveform 1550. As shown in FIG. 67, the "auto ratio" waveform 1552 has a minimum value of zero percent (corresponding to reference position "0") and a maximum value of about twenty percent (corresponding to reference position "10").

Waveform 1554 represents the "auto sum" variable discussed in relation to FIG. 3c. The "auto sum" variable is computed by summing the "auto ratio" waveform 1552 in each half cycle. Thus, the "auto sum" waveform 1554 provides a measure of the number of shape changes per half cycle, comprising one discrete value per half cycle, or 12 values for every tenth of a second. As shown in FIG. 67, the "auto sum" waveform 1554 has a minimum value of zero (corresponding to reference position "10") and a maximum value of about eight (corresponding to reference position "50").

Waveform 1556 represents the "auto sum sum" variable discussed in relation to FIG. 3d. As discussed above, the magnitude of the "auto sum sum" variable is dependent on whether the "auto sum" waveform 1554 is greater than an arc threshold value and less than an arc cutoff value, and whether the ratio of current peaks from cycle to cycle is less than 10%. If these conditions are satisfied, a significant shape change has occurred and the "auto sum sum" variable is incremented accordingly. As shown in FIG. 67, the "auto sum sum" waveform 1556 has a minimum value of zero (corresponding to reference position "50") and a maximum value of about twelve or thirteen (corresponding to reference position "75"). A second trip criteria for the arcing fault detection system is triggered when the "auto sum sum" variable 1556 equals or exceeds three significant shape changes per second (corresponding to reference position "56").

While particular embodiments and applications of the present invention have been illustrated and described, it is to be understood that the invention is not limited to the precise construction and compositions disclosed herein and that various modifications, changes, and variations will be apparent from the foregoing descriptions without departing from the spirit and scope of the invention as defined in the appended claims.

## Claims

1. Method of detecting arcing faults in an electrical distribution system that includes a line conductor (16a) connected to a utility power transformer (14), said method comprising the steps of
monitoring the rate of change of electrical current in the line conductor (16a) with a current transformer (T1), and producing a signal (A) representing the rate of change,
generating an arcing-fault-detection signal (30, 40, 50) in response to said rate-of-change signal, and
applying a test signal to said current transformer (T1) through a test line (82) coupled to said transformer in the same manner as said line conductor (16a), and said test signal simulating a line current produced by an arcing fault, said test signal being produced by a signal generator (84) connected to said test line.

2. Method of claim 1 wherein said test signal is an alternating signal having a frequency substantially above the frequency of the power signal.

3. Method of claim 2 wherein said test signal has a frequency above 60Hz and below about 1 Mhz.

4. Method of claim 1 wherein said test signal is a repetitive oscillating signal.

5. Method of claim 1 wherein said current transformer is a toroid, and said line conductor and said test line pass through said toroid.

6. Method of claim 5 wherein said arcing-fault-detection signal is produced in response to the occurrence of signals having frequencies substantially above the frequency of the power signal, on said line conductor.

7. Method of claim 1 **characterised in that** said test signal is produced periodically on said test line (82), said sensor simultaneously monitoring said test signal and said electrical signal when said test signal is present on said test line, said sensor signal representing both said test signal and said electrical signal when said test signal is present on said test line, said arcing fault detection system generating an arc-indicative signal in response to said sensor signal associated with either of said test line or said line conductor having characteristics indicative of an arcing fault.

8. Method of claim 7 further comprising the step of generating a trip signal to trigger the interruption of the electrical signal on said line conductor, said step of generating a trip signal being accomplished when said test signal is not present on said test line and said arc-indicative signal was produced in response to the sensor signal representing both said test signal and said electrical signal.

9. Method of claim 8 wherein said step of generating a trip signal is further accomplished when said test signal is present on said test line and said arc-indicative signal was not produced in response to the sensor signal representing both said test signal and said electrical signal.

10. Method of claim 9 wherein said step of generating a trip signal is inhibited when said test signal is present on said test line and said arc-indicative signal is produced in response to the sensor signal representing both said test signal and said electrical signal.

11. Method of claim 1, **characterised by** the step of:
coupling a sensor (21) to one of said secondary lines, said sensor monitoring the secondary current and producing a rate-of-change signal representing the rate of change of said secondary current.

12. Method of claim 11 further comprising the step of bandpass filtering said rate-of-change signal within a selected frequency band so that power frequency signals and noisy load signals are rejected.

13. Method of claim 12 further comprising the step of disconnecting the load from the power source in said phase line in response to the occurrence of an arcing fault in said phase line.

14. System for detecting arcing faults in an electrical distribution system that includes a line conductor (16a-n) connected to a utility power transformer (14), said system comprising:
a current transformer (21) coupled to said line conductor for monitoring the rate of change of electrical current in the line conductor (16) and producing a signal representing the rate of change,
means for generating an arcing-fault-detection signal (30, 40, 50) in response to said rate-of-change signal,
a test line (82) coupled to said current transformer (T1) in the same manner as said line conductor for subjecting said transformer to a test signal simulating a line current produced by an arcing fault, and
a signal generator (84) connected to said test line for producing said test signal.

15. System of claim 14 wherein said test signal is an alternating signal having a frequency substantially above the frequency of the power signal.

16. System of claim 15 wherein said test signal has a frequency above 60 Hz and below about 1 Mhz.

17. System of claim 11 wherein said test signal is a repetitive oscillating signal.

18. System of one of claims 14 to 17 wherein said current transformer (21) is a toroid, and said line conductor and said test line pass through said toroid.

19. System of claim 14 wherein said arcing-fault-detection signal is produced in response to the occurrence of signals having frequencies substantially above the frequency of the power signal, on said line conductor.

20. System according to claim 14, **characterised by** distribution network (Fig.1) having a line conductor (16a-n) carrying an electrical signal between a power source (14) and a load, (20a-n), said arcing fault detection system including a sensor coupled to said line conductor (16a-n) for monitoring said electrical signal and generating a sensor signal representing said electrical signal, said arcing fault detection system generating an arc indicative signal in response to said sensor signal having characteristics indicative of an arcing fault, said testing apparatus comprising:
means (96) for periodically producing a test signal on said test line (82; 92), said sensor simultaneously monitoring said test signal and said electrical signal when said test signal is present on said test line, said sensor signal representing both said test signal and said electrical signal when said test signal is present on said test line, said arcing fault detection system generating an arc-indicative signal in response to said sensor signal associated with either of said test line or said line conductor having characteristics indicative of an arcing fault.

21. System of claim 20 further comprising a diagnostic test integrator for evaluating status conditions of said test signal and said arc-indicative signal and generating a trip signal to trigger the interruption of the electrical signal in response to certain status conditions of said test signal and said arc-indicative signal.

22. System of claim 21 wherein said diagnostic test integrator generates said trip signal when said test signal is not present on said test line and said arc-indicative signal was produced in response to the sensor signal representing both said test signal and said electrical signal.

23. System of claim 21, wnerein said diagnostic test integrator generates said trip signal when said test signal is present on said test line and said arc-indicative signal was not produced in response to the sensor signal representing both said test signal and said electrical signal.

24. System of claim 21, wherein said diagnostic test integrator does not generate said trip signal when said test signal is present on said test line and said arc-indicative signal is produced in response to the sensor signal representing both said test signal and said electrical signal.

25. System of claim 20 further comprising an oscillator connected to said test line for producing said test signal on said test line.

26. System of one of claims 14 to 18, wherein said current transformer including at least one secondary line (T1) carrying a secondary current less than the electrical current carried on said line conductor, and the system further comprises a sensor (24) coupled to one of said secondary lines for monitoring the secondary current to detect the occurrence of an arcing fault signal in said line conductor (16), said sensor producing a rate-of-change signal representing the rate of change of said secondary current.

27. System of claim 26 further comprising means for bandpass filtering (T1, C1, C2, L1) said rate-of-change signal within a selected frequency band so that power frequency signals and noisy load signals are rejected.

28. System of claim 28 wherein said sensor is a toroidal sensor that includes a winding, said system including means for testing the resistance of the winding.

29. System of claim 26 wherein said test signal has a frequency between about 10 KHz and 100 KHz.

30. System of claim 26 wherein said system further comprises:
means for producing a pulse each time the rate-of-change signal exceeds a selected threshold;
means for counting the number of said pulses occurring with a selected time interval; and
means for generating a trip signal in response to the number of said pulses occurring within said selected time interval exceeding a trip threshold level.

## Patentansprüche

1. Verfahren zum Erfassen von Lichtbogenfehlern in einem elektrischen Verteilungssystem, das einen Leitungs-Leiter (16a), verbunden mit einem Nutzleistungstransformator (14), umfasst, wobei das Verfahren die Schritte aufweist:
Überwachen der Änderungsrate eines elektrischen Stroms in dem Leitungs-Leiter (16a) mit einem Stromtransformator (T1) und Erzeugen eines Signals (A), das die Rate einer Änderung darstellt,
Erzeugen eines Lichtbogenfehlererfassungssignals (30, 40, 50) in Abhängigkeit von dem Signal der Rate einer Änderung, und
Anlegen eines Testsignals an den Stromtransformator (T1) über eine Testleitung (82), verbunden mit dem Transformator, in derselben Art und Weise wie bei dem Leitungs-Leiter (16a), und wobei das Testsignal einen Leitungsstrom simuliert, erzeugt durch einen Lichtbogenfehler, wobei das Testsignal durch einen Signalgenerator (84) erzeugt wird, verbunden mit der Testleitung.

2. Verfahren nach Anspruch 1, wobei das Testsignal ein alternierendes Signal ist, das eine Frequenz im Wesentlichen oberhalb der Frequenz des Leistungssignals ist.

3. Verfahren nach Anspruch 2, wobei das Testsignal eine Frequenz oberhalb 60Hz und unterhalb ungefähr 1 MHz besitzt.

4. Verfahren nach Anspruch 1, wobei das Testsignal ein sich wiederholendes, oszillierendes Signal ist.

5. Verfahren nach Anspruch 1, wobei der Stromtransformator ein Toroid ist und wobei der Leitungs-Leiter und die Testleitung durch den Toroid hindurchführen.

6. Verfahren nach Anspruch 5, wobei das Lichtbogenfehlererfassungssignal in Abhängigkeit von dem Auftreten von Signalen erzeugt wird, die Frequenzen im Wesentlichen oberhalb der Frequenz des Leistungssignals haben, und zwar an dem Leitungs-Leiter.

7. Verfahren nach Anspruch 1, **dadurch gekennzeichnet, dass** das Testsignal periodisch auf der Testleitung (82) erzeugt wird, wobei der Sensor simultan das Testsignal und das elektrische Signal überwacht, wenn das Testsignal auf der Testleitung vorhanden ist, wobei das Sensorsignal sowohl das Testsignal als auch das elektrische Signal darstellt, wenn das Testsignal auf der Testleitung vorhanden ist, wobei das Lichtbogenfehlererfassungssystem ein für einen Lichtbogen indikatives Signal in Abhängigkeit von dem Sensorsignal erzeugt, zugeordnet zu entweder der Testleitung oder dem Leitungs-Leiter, mit Charakteristika, die für einen Lichtbogenfehler indikativ sind.

8. Verfahren nach Anspruch 7, das weiterhin den Schritt eines Erzeugens eines Auslösesignals aufweist, um die Unterbrechung des elektrischen Signals auf dem Leitungs-Leiter zu triggern, wobei der Schritt eines Erzeugens eines Auslösesignals dann durchgeführt wird, wenn das Testsignal nicht auf der Testleitung vorhanden ist und das für den Lichtbogen indikative Signal in Abhängigkeit von dem Sensorsignal erzeugt wurde, sowohl das Testsignal als auch das elektrische Signal darstellend.

9. Verfahren nach Anspruch 8, wobei der Schritt eines Erzeugens eines Auslösesignals weiterhin dann vorgenommen wird, wenn das Testsignal auf der Testleitung vorhanden ist und das für den Lichtbogen indikative Signal nicht in Abhängigkeit von dem Sensorsignal erzeugt wurde, sowohl das Testsignal als auch das elektrische Signal darstellend.

10. Verfahren nach Anspruch 9, wobei der Schritt eines Erzeugens eines Auslösesignals verhindert wird, wenn das Testsignal auf der Testleitung vorhanden ist und das für den Lichtbogen indikative Signal in Abhängigkeit von dem Sensorsignal erzeugt wird, sowohl das Testsignal als auch das elektrische Signal darstellend.

11. Verfahren nach Anspruch 1, **gekennzeichnet durch** den Schritt eines Verbindens eines Sensors (21) mit einer der sekundären Leitungen, wobei der Sensor den sekundären Strom überwacht und ein Signal für die Rate einer Änderung erzeugt, die Rate einer Änderung des sekundären Stroms darstellend.

12. Verfahren nach Anspruch 11, das weiterhin den Schritt einer Bandpassfilterung des Signals der Rate einer Änderung innerhalb eines ausgewählten Frequenzbands so aufweist, dass Leistungsfrequenzsignale und Rauschbelastungssignale ausgesondert werden.

13. Verfahren nach Anspruch 12, das weiterhin den Schritt eines Unterbrechens der Last von der Energieversorgung in der Phasenleitung in Abhängigkeit von dem Auftreten eines Lichtbogenfehlers in der Phasenleitung aufweist.

14. System zum Erfassen von Lichtbogenfehlern in einem elektrischen Verteilungssystem, das einen Leitungs-Leiter (16a-n) umfasst, verbunden mit einem Nutzleistungstransformator (14), wobei das System aufweist:
einen Stromtransformator (21), verbunden mit dem Leitungs-Leiter zum Überwachen der Rate einer Änderung eines elektrischen Stroms in dem Leitungs-Leiter (16) und zum Erzeugen eines Signals, das die Rate einer Änderung darstellt, Einrichtungen zum Erzeugen eines Lichtbogenfehlererfassungssignals (30, 40, 50) in Abhängigkeit von dem Signal der Rate einer Änderung,
eine Testleitung (82), verbunden mit dem Stromtransformator (T1), in derselben Art und Weise wie der Leitungs-Leiter, zum Unterwerfen des Transformators einem Testsignal, das einen Leitungsstrom simuliert, erzeugt durch einen Lichtbogenfehler, und
einen Signalgenerator (84), verbunden mit der Testleitung, zum Erzeugen des Testsignals.

15. System nach Anspruch 14, wobei das Testsignal ein alternierendes Signal ist, das eine Frequenz im Wesentlichen oberhalb der Frequenz des Leistungssignals ist.

16. System nach Anspruch 15, wobei das Testsignal eine Frequenz oberhalb 60Hz und unterhalb ungefähr 1 MHz besitzt.

17. System nach Anspruch 14, wobei das Testsignal ein sich wiederholendes, oszillierendes Signal ist.

18. System nach einem der Ansprüche 14 bis 17, wobei der Stromtransformator (21) ein Toroid ist und wobei der Leitungs-Leiter und die Testleitung durch den Toroid hindurchführen.

19. System nach Anspruch 14, wobei das Lichtbogenfehlererfassungssignal in Abhängigkeit von dem Auftreten von Signalen erzeugt wird, die Frequenzen im Wesentlichen oberhalb der Frequenz des Leistungssignals haben, und zwar an dem Leitungs-Leiter.

20. System nach Anspruch 14, **gekennzeichnet durch** ein Verteilungsnetzwerk (Fig. 1), das einen Leitungs-Leiter (16a-n) besitzt, der ein elektrisches Signal zwischen einer Energieversorgungsquelle (14) und einer Last (20a-n) führt, wobei das Lichtbogenfehlererfassungssystem einen Sensor umfasst, verbunden mit dem Leitungs-Leiter (16a-n), zum Überwachen des elektrischen Signals und zum Erzeugen eines Sensorsignals, das das elektrische Signal darstellt, wobei das Lichtbogenfehlererfassungssystem ein für den Lichtbogen indikatives Signal in Abhängigkeit von dem Sensorsignal erzeugt, das Charakteristika besitzt, die für einen Lichtbogenfehler indikativ sind, wobei die Testvorrichtung aufweist:
Einrichtungen (96) zum periodischen Erzeugen eines Testsignals auf der Testleitung (82; 92), wobei der Sensor simultan das Testsignal und das elektrische Signal überwacht, wenn das Testsignal auf der Testleitung vorhanden ist, wobei das Sensorsignal sowohl das Testsignal als auch das elektrische Signal darstellt, wenn das Testsignal auf der Testleitung vorhanden ist, wobei das Lichtbogenfehlererfassungssystem ein für einen Lichtbogen indikatives Signal in Abhängigkeit von dem Sensorsignal erzeugt, zugeordnet entweder der Testleitung oder dem Leitungs-Leiter, mit Charakteristika, die für einen Lichtbogenfehler indikativ sind.

21. System nach Anspruch 20, das weiterhin einen Diagnostik-Test-Integrator zum Evaluieren von Status-Zuständen des Testsignals und des für den Lichtbogen indikativen Signals und zum Erzeugen eines Auslösesignals, um die Unterbrechung des elektrischen Signals in Abhängigkeit von bestimmten Status-Zuständen des Testsignals und des für den Lichtbogen indikativen Signals zu triggern, aufweist.

22. System nach Anspruch 21, wobei der Diagnostik-Test-Integrator das Auslösesignal erzeugt, wenn das Testsignal nicht auf der Testleitung vorhanden ist und das für den Lichtbogen indikative Signal in Abhängigkeit von dem Sensorsignal erzeugt wurde, darstellend sowohl das Testsignal als auch das elektrische Signal.

23. System nach Anspruch 21, wobei der Diagnostik-Test-Integrator das Auslösesignal dann erzeugt, wenn das Testsignal auf der Testleitung vorhanden ist und das für den Lichtbogen indikative Signal nicht in Abhängigkeit von dem Sensorsignal erzeugt wurde, darstellend sowohl das Testsignal als auch das elektrische Signal.

24. System nach Anspruch 21, wobei der Diagnostik-Test-Integrator nicht das Auslösesignal erzeugt, wenn das Testsignal auf der Testleitung vorhanden ist, und das für den Lichtbogen indikative Signal in Abhängigkeit von dem Sensorsignal erzeugt wird, darstellend sowohl das Testsignal als auch das elektrische Signal.

25. System nach Anspruch 20, das weiterhin einen Oszillator aufweist, verbunden mit der Testleitung, zum Erzeugen des Testsignals auf der Testleitung.

26. System nach einem der Ansprüche 14 bis 18, wobei der Stromtransformator mindestens eine sekundäre Leitung (T1) umfasst, die einen sekundären Strom geringer als der elektrische Strom, geführt auf dem Leitungs-Leiter, führt, und wobei das System weiterhin einen Sensor (24) aufweist, verbunden mit einer der sekundären Leitungen, zum Überwachen des sekundären Stroms, um das Auftreten eines Lichtbogenfehlersignals in dem Leitungs-Leiter (16) zu erfassen, wobei der Sensor ein Signal für eine Rate einer Änderung erzeugt, die Rate einer Änderung des sekundären Stroms darstellend.

27. System nach Anspruch 26, das weiterhin Einrichtungen für eine Bandpassfilterung (T1, C1, C2, L1) des Signals einer Rate einer Änderung innerhalb eines ausgewählten Frequenzbands aufweist, so dass die Energiefrequenzsignale und die Rauschbelastungssignale zurückgewiesen werden.

28. System nach Anspruch 27, wobei der Sensor ein toroidaler Sensor ist, der eine Wicklung umfasst, wobei das System Einrichtungen zum Testen des Widerstands der Wicklung aufweist.

29. System nach Anspruch 26, wobei das Testsignal eine Frequenz zwischen ungefähr 10 KHz und 100 KHz besitzt.

30. System nach Anspruch 26, wobei das System weiterhin aufweist:
Einrichtungen zum Erzeugen eines Impulses zu jedem Zeitpunkt, zu dem das Signal für die Rate einer Änderung einen ausgewählten Schwellwert übersteigt; Einrichtungen zum Zählen der Anzahl der Impulse, die mit einem ausgewählten Zeitintervall auftreten; und
Einrichtungen zum Erzeugen eines Auslösesignals in Abhängigkeit von der Anzahl der Impulse, die innerhalb des ausgewählten Zeitintervalls auftreten, einen Auslöseschwellwertpegel übersteigend.

## Revendications

1. Procédé de détection d'arcs électriques dans un réseau de distribution électrique qui comprend un conducteur de ligne (16a) connecté à un transformateur de puissance de distribution (14), ledit procédé comprenant les étapes consistant à
surveiller le rythme de variation du courant électrique dans le conducteur de ligne (16a) avec un transformateur de courant (T1) et produire un signal (A) représentant le rythme de variation,
générer un signal de détection d'arc électrique (30, 40, 50) en réponse audit signal de rythme de variation, et
appliquer un signal de test audit transformateur de courant (T1) à travers une ligne de test (82) couplée audit transformateur de la même manière que ledit conducteur de ligne (16a) et ledit signal de test simulant un courant de ligne produit par un arc électrique, ledit signal de test étant produit par un générateur de signal (84) connecté à ladite ligne de test.

2. Procédé selon la revendication 1, dans lequel ledit signal de test est un signal alternatif ayant une fréquence sensiblement supérieure à la fréquence du signal de puissance.

3. Procédé selon la revendication 2, dans lequel ledit signal de test a une fréquence supérieure à 60 Hz et inférieure à environ 1 MHz.

4. Procédé selon la revendication 1, dans lequel ledit signal de test est un signal oscillant répétitif.

5. Procédé selon la revendication 1, dans lequel ledit transformateur de courant est une bobine toroïdale et ledit conducteur de ligne et ladite ligne de test passent à travers ladite bobine toroïdale.

6. Procédé selon la revendication 5, dans lequel ledit signal de détection d'arc électrique est produit en réponse à l'apparition de signaux ayant des fréquences sensiblement supérieures à la fréquence du signal de puissance, sur ledit conducteur de ligne.

7. Procédé selon la revendication 1, dans lequel ledit signal de test est produit périodiquement sur ladite ligne de test (82), ledit capteur surveillant simultanément ledit signal de test et ledit signal électrique quand ledit signal de test est présent sur ladite ligne de test, ledit signal de capteur représentant à la fois ledit signal de test et ledit signal électrique quand ledit signal de test est présent sur ladite ligne de test, ledit système de détection d'arcs électriques générant un signal indiquant un arc en réponse audit signal de capteur associé avec l'un de ladite ligne de test ou dudit conducteur de ligne ayant des caractéristiques indiquant un arc électrique.

8. Procédé selon la revendication 7, comprenant en outre l'étape consistant à générer un signal de déclenchement pour déclencher l'interruption du signal électrique sur ledit conducteur de ligne, ladite étape de génération d'un signal de déclenchement étant accomplie quand ledit signal de test n'est pas présent sur ladite ligne de test et ledit signal indiquant un arc a été produit en réponse au signal de capteur représentant à la fois ledit signal de test et ledit signal électrique.

9. Procédé selon la revendication 8, dans lequel ladite étape de génération d'un signal de déclenchement est accomplie en outre quand ledit signal de test est présent sur ladite ligne de test et ledit signal indiquant un arc n'a pas été produit en réponse au signal de capteur représentant à la fois ledit signal de test et ledit signal électrique.

10. Procédé selon la revendication 9, dans lequel ladite étape de génération d'un signal de déclenchement est invalidée quand ledit signal de test est présent sur ladite ligne de test et ledit signal indiquant un arc est produit en réponse au signal de capteur représentant à la fois ledit signal de test et ledit signal électrique.

11. Procédé selon la revendication 1, **caractérisé en ce qu'**il comprend les étapes consistant à coupler un capteur (21) à une desdites lignes secondaires, ledit capteur surveillant le courant secondaire et produisant un signal de rythme de variation représentant le rythme de variation dudit courant secondaire.

12. Procédé selon la revendication 11, comprenant en outre l'étape de filtrage passe-bande dudit signal de rythme de variation dans une bande de fréquences sélectionnée de manière que des signaux de fréquence de puissance et des signaux de charge bruités soient rejetés.

13. Procédé selon la revendication 12, comprenant en outre l'étape consistant à déconnecter la charge de la source de puissance dans ladite ligne de phase en réponse à l'apparition d'un arc électrique dans ladite ligne de phase.

14. Système de détection d'arcs électriques dans un système de distribution électrique qui comprend un conducteur de ligne (16a-n) connecté à un transformateur de puissance de distribution (14), ledit système comprenant :
un transformateur de courant (21) couplé à ledit conducteur de ligne pour surveiller le rythme de variation du courant éléctrique dans le conducteur de ligne (16) et produire un signal représentant le rythme de variation,
des moyens pour générer un signal de détection d'arc électrique (30, 40, 50) en réponse audit signal de rythme de variation,
une ligne de test (82) couplée audit transformateur de courant (T1) de la même manière que ledit conducteur de ligne pour soumettre ledit transformateur à un signal de test simulant un courant de ligne produit par un arc électrique, et
un générateur de signal (84) connecté à ladite ligne de test pour produire ledit signal de test.

15. Système selon la revendication 14, dans lequel ledit signal de test est un signal alternatif ayant une fréquence sensiblement supérieure à la fréquence du signal de puissance.

16. Procédé selon la revendication 15, dans lequel ledit signal de test a une fréquence supérieure à 60 Hz et inférieure à environ 1 MHz.

17. Procédé selon la revendication 14, dans lequel ledit signal de test est un signal oscillant répétitif.

18. Procédé selon une des revendications 14 à 17, dans lequel ledit transformateur de courant (21) est une bobine toroïdale et ledit conducteur de ligne et ladite ligne de test passent à travers ladite bobine toroïdale.

19. Système selon la revendication 14, dans lequel ledit signal de détection d'arc électrique est produit en réponse à l'apparition de signaux ayant des fréquences sensiblement supérieures à la fréquence du signal de puissance, sur ledit conducteur de ligne.

20. Système selon la revendication 14, **caractérisé par** un réseau de distribution (Figure 1) ayant un conducteur de ligne (16a-n) portant un signal électrique entre une source d'énergie (14) et une charge (20a-n), ledit système de détection d'arcs électriques comprenant un capteur couplé audit conducteur de ligne (16a-n) pour surveiller ledit signal électrique et générer un signal de capteur représentant ledit signal électrique, ledit système de détection d'arc électrique générant un signal indiquant un arc en réponse audit signal de capteur ayant des caractéristiques indiquant un arc électrique, ledit appareil de test comprenant :
des moyens (96) pour produire périodiquement un signal de test sur ladite ligne de test (82 ; 92), ledit capteur surveillant simultanément ledit signal de test et ledit signal électrique quand ledit signal de test est présent sur ladite ligne de test, ledit signal de capteur représentant à la fois ledit signal de test et ledit signal électrique quand ledit signal de test est présent sur ladite ligne de test, ledit système de détection d'arcs électriques générant un signal indiquant un arc en réponse audit signal de capteur associé avec l'un de ladite ligne de test ou dudit conducteur de ligne ayant des caractéristiques indiquant un arc électrique.

21. Système selon la revendication 20, comprenant en outre un intégrateur de test de diagnostic pour évaluer les conditions d'état dudit signal de test et dudit signal indiquant un arc et générer un signal de déclenchement pour déclencher l'interruption du signal électrique en réponse à certaines conditions d'état dudit signal de test et dudit signal indiquant un arc.

22. Système selon la revendication 21, dans lequel ledit intégrateur de test de diagnostic génère ledit signal de déclenchement quand ledit signal de test n'est pas présent sur ladite ligne de test et ledit signal indiquant un arc a été produit en réponse au signal de capteur représentant à la fois ledit signal de test et ledit signal électrique.

23. Système selon la revendication 21, dans lequel ledit intégrateur de test de diagnostic génère ledit signal de déclenchement quand ledit signal de test est présent sur ladite ligne de test et ledit signal indiquant un arc n'a pas été produit en réponse au signal de capteur représentant à la fois ledit signal de test et ledit signal électrique.

24. Système selon la revendication 21, dans lequel ledit intégrateur de test de diagnostic ne génère pas ledit signal de déclenchement quand ledit signal de test est présent sur ladite ligne de test et ledit signal indiquant un arc est produit en réponse au signal de capteur représentant à la fois ledit signal de test et ledit signal électrique.

25. Système selon la revendication 20, comprenant en outre un oscillateur connecté à ladite ligne de test pour produire ledit signal de test sur ladite ligne de test.

26. Système selon une des revendications 14 à 18, dans lequel ledit transformateur de courant comprenant au moins une ligne secondaire (T1) portant un courant secondaire inférieur au courant électrique porté sur ledit conducteur de ligne, et le système comprend en outre un capteur (24) couplé à une desdites lignes secondaires pour surveiller le courant secondaire pour détecter l'apparition d'un signal d'arc électrique dans ledit conducteur de ligne (16), ledit capteur produisant un signal de rythme de variation représentant le rythme de variation dudit courant secondaire.

27. Système selon la revendication 26 comprenant en outre des moyens de filtrage passe-bande (T1, C1, C2, L1) dudit signal de variation de rythme dans une bande de fréquences sélectionnée de manière que des signaux de fréquence de puissance et des signaux de charge bruités soient rejetés.

28. Système selon la revendication 28, dans lequel ledit capteur est un capteur toroïdal qui comprend un enroulement, ledit système comprenant des moyens pour tester la résistance de l'enroulement.

29. Système selon la revendication 26, dans lequel ledit signal de test a une fréquence entre environ 10 KHz et 100 KHz.

30. Système selon la revendication 26, dans lequel ledit système comprend en outre :
des moyens pour produire une impulsion chaque fois que le signal de rythme de variation dépasse un seuil prédéterminé ;
des moyens pour compter le nombre desdites impulsions apparaissant dans un intervalle de temps prédéterminé ; et
des moyens pour générer un signal de déclenchement en réponse au nombre desdites impulsions apparaissant dans ledit intervalle de temps prédéterminé dépassant un niveau de seuil de déclenchement.
